(19) **Europäisches Patentamt**
**European Patent Office**
**Office européen des brevets**

(11) **EP 1 573 931 B1**

(12) **EUROPEAN PATENT SPECIFICATION**

(45) Date of publication and mention
of the grant of the patent:
**30.07.2008 Bulletin 2008/31**

(51) Int Cl.:
**H04B 1/28** (2006.01) **H04N 7/20** (2006.01)
**H04Q 3/52** (2006.01)

(21) Application number: **03797006.8**

(22) Date of filing: **11.12.2003**

(86) International application number:
**PCT/US2003/039741**

(87) International publication number:
**WO 2004/054128 (24.06.2004 Gazette 2004/26)**

(54) **INTEGRATED CROSSPOINT SWITCH WITH BAND TRANSLATION**

INTEGRIERTE KREUZVERMITTLUNG MIT BANDUMSETZUNG

MULTISELECTEUR INTEGRE AVEC TRANSPOSITION DE BANDE

(84) Designated Contracting States:
**AT BE BG CH CY CZ DE DK EE ES FI FR GB GR
HU IE IT LI LU MC NL PT RO SE SI SK TR**

(30) Priority: **11.12.2002 US 433066 P
11.12.2002 US 433061 P
11.12.2002 US 433067 P
11.12.2002 US 433063 P**

(43) Date of publication of application:
**14.09.2005 Bulletin 2005/37**

(73) Proprietor: **R.F. Magic Inc.
San Diego, CA 92121 (US)**

(72) Inventors:
• **BARGROFF, Keith, P.
San Diego, CA 92105 (US)**
• **FRANSIS, Bert, L.
San Diego, CA 92109 (US)**
• **HANCOCK, Dale
San Diego, CA 92109 (US)**

(74) Representative: **Dilg, Haeusler, Schindelmann
Patentanwaltsgesellschaft mbH
Nußbaumstrasse 6
80336 München (DE)**

(56) References cited:
**WO-A-02/082671** **US-A- 5 184 084**
**US-A- 5 881 369**

**Description**

Background of the Invention

Field of the Invention

The invention relates to electronic signal processing. More particularly, the invention relates to Radio Frequency (RF) signal distribution and frequency conversion.

Description of the Related Art

Communication systems are designed to provide information from a source to a destination using a communication channel. Electronic communication channels can be implemented in a variety of ways. An electronic communication system can implement a communication channel as point to point channels, broadcast channels, or a combination of the two. The communication channels can be implemented using optical communication links or electronic communication links. Optical communication links include, but are not limited to, free space optical links and fiber optic links. Electronic communication links similarly include, but are not limited to, wireless links and wired links.

The amount of information that can be carried on a particular link is limited by the usable bandwidth in the link. Some communication links can be band limited due to a physical characteristic, while other communication links can be band limited due to artificial factors, which can include system design limitations and regulatory restrictions. Regulatory restrictions are particularly prevalent in wireless communication systems in order to minimize interference that can result if the radio spectrum was unregulated. A signal that occupies the same bandwidth as another uncorrelated signal, whether occurring in a wired system or a wireless system, appears as interference to the uncorrelated signal. Similarly, the uncorrelated signal appears as interference to the first signal. Wireless communication systems commonly operate in regulated bands because of the difficulty in isolating a signal from interfering signals in a wireless environment.

Common communication systems that are band limited by regulations, such as those imposed by the Federal Communications Commission (FCC) in the United States, or the International Telecommunications Union (ITU), include broadcast radio and television systems. Regulation and standardization of the frequency bands used in broadcast radio and television enable consumer electronics to standardize their frequency bands of operation.

Numerous techniques are known and available to more efficiently utilize a particular frequency band. The more common techniques employ some form of signal multiplexing. Common multiplexing techniques include Time Division Multiplexing (TDM), Frequency Division Multiplexing (FDM), Code Division Multiplexing (CDM), Orthogonal Frequency Division Multiplexing (OFDM), and the like.

In TDM systems, independent users are allocated time slots that do not overlap. Thus, at any particular time, one user is allowed to occupy the entire allocated bandwidth. Similarly, in FDM systems, users are allocated portions of the entire allocated frequency band and the portion of the frequency band allocated to one user does not overlap those portions allocated to another user. In CDM systems each user is allocated the entire frequency band for the entire time, but each user communicates in the frequency band using an orthogonal code. Because the user codes are orthogonal, each user can recover their respective signal from the other signals occupying the frequency band. However, in a CDM system, each user appears as an interfering signal to every other user in the frequency band. In order to minimize the interference contributed by any one user to all other users in the frequency band, the power transmitted by each user in a CDM system is tightly controlled to the minimum power that is required to achieve a particular signal quality. In an OFDM system, the frequency band is divided into a number of distinct frequency bands. Each user can communicate over the entire band, but the information from each user is divided up into a number of parallel streams that are broadcast as orthogonal waveforms in each of a predetermined number of sub-bands. Of course, this discussion of multiplexing techniques is not exhaustive and some communication systems can implement other multiplexing techniques or a combination of more than one multiplexing technique.

One consequence of regulated frequency bands and communication channels within the regulated frequency bands is compatibility. Communication systems operating in a first communication band can desire to provide information to second communication system operating in second communication band. One manner of interfacing two otherwise compatible signals at different frequency bands is frequency translation. A signal from a first communication system at a first frequency can be translated to a second frequency in order to make the signal available in the second communication system. Communication systems can incorporate a number of frequency translations in providing a signal from a source to its ultimate destination.

Additionally, signals from a first communication system can be frequency translated to be compatible with a second communication system. One example of the use of frequency translation is in cable television systems. Televisions are typically produced to be compatible with a particular television standard. In the United States, most televisions are compatible with the National Television System Committee (NTSC) standard and the frequency allocation for television channels regulated by the FCC. However, cable television providers are, to some extent, able to provide the same content on practically any channel. Additionally, the number of signals to which a cable operator has can be far in excess of the number of channels that a typical television receiver can tune. Thus, at a head end or cable television signal source, a cable operator can receive a desired number of signals and frequency translate each signal to a desired television channel.

The system design implemented by the cable operator determines frequency translation and the majority of the contributors to inter-channel interference such that these issues are typically of no concern to the end user. However, with the increased availability of content from different sources, receivers that are local to the end user are incorporating the ability to interface to multiple sources and combine those multiple sources into a signal that is presented to the end user.

For example, a single household can have access to over-the-air television broadcast channels, cable television channels, satellite television channels, microwave television channels, closed circuit television channels, and television channels from other sources. These multiple channels from multiple signal sources can easily provide more channels to which a typical television may be tuned. Additionally, some of the channels from one or more of the signal sources can appear on the same channel such that direct signal combination can not be feasible. For example, signals from a satellite transponder can be downconverted to a particular block of channels that can coincide with channels provided by the cable television source. The channels from the two signal sources cannot be directly combined without channels from the satellite television source interfering with the coincident channels from the cable television source. Thus, typically, a switch can be provided to allow an end user to choose one signal source and eliminate interfering signals from all other sources.

To further compound the problems associated with distributing signals from multiple sources to an end user, signals from a source such as a satellite television source, do not arrive from a single source but rather from multiple sources. A satellite television receiver is typically capable of simultaneously receiving signals from multiple satellite transponders positioned on one or more satellites. The signals received from the multiple satellite transponders can exceed the channel tuning capability of a typical television tuner. Thus, only a subset of all available satellite television signals can be simultaneously made available to a particular television receiver.

Although a source switch can be a viable solution for a single receiver, the use of a source switch quickly becomes unfeasible when multiple receivers, such as televisions, interface to the same sources via a common distribution mechanism, such as a shared coaxial cable. It is typically unfeasible to provide every signal source to each television location and provide a source switch at the television. However, it is desirable for each television receiver to independently have the ability to control the signal source. Additionally, where signals from a particular source, such as satellite television, can be provided on the same channels, it is desirable to have the ability to frequency translate some of the signals such that they are provided at different channels. The state of the art includes U.S. Patent No. 5, 184,084 to Yun disclosing a double band frequency converter for converting high frequency signals to a lower band for a microwave radio frequency receiver.

Summary of the Invention

Signal distribution systems, apparatus, and methods are disclosed in accordance with the independent claims. The claimed system allows signals from any one of a first number of input signals to be directed to any one of a number of destinations. Additionally, each of the first number of input signals can comprise signals in at least one frequency band from a number of predetermined input frequency bands. The claimed system also allows signals from each of the number of predetermined input frequency bands to be frequency translated to one of a number of predetermined output frequency bands. The predetermined input frequency bands can coincide with the predetermined output frequency bands. Additionally, an input signal in an input frequency band can be output to an output frequency band that is substantially the same as the input frequency band. Amplifiers within the system allow a signal from one signal source to be provided to any number of independent frequency translation blocks. Some or all of the claimed system can be implemented in a single integrated circuit.

Desired signals can be received from multiple distinct signal sources. The communication link from the signal sources to local receivers can be wired or wireless. Each of the signal sources provides one or more source signals that can be frequency translated to one of a number of predetermined input frequency bands, such as, for example, by a low noise block converter. Alternatively, one or more of the source signals can be provided in one or more of the predetermined input frequency bands. The input frequency bands are typically distinct and define a contiguous composite frequency band. However, the input frequency bands can overlap or define a disjoint composite frequency band. The input and output frequency bands may carry data for one or more channels originating on one or more transponders.

Brief Description of the Drawings

The features, objects, and advantages of the invention will become more apparent from the detailed description set forth below when taken in conjunction with the drawings in which like reference characters identify correspondingly throughout and wherein:

Figure 1 is a functional block diagram of a satellite communication system configured to provide signals from multiple satellites to multiple user devices.

Figure 2 is a functional block diagram of cascaded band translation switches.

Figure 3 is a functional block diagram of a band translation switch having one band translation device configured to provide pass through and one band translation device configured to provide translation.

Figure 4A illustrates a simplified switch diagram of a doubly balanced mixer as known in the art.

Figure 4B illustrates the doubly balanced mixer of Figure 4A as a Gilbert cell mixer circuit.

Figure 5 illustrates a common oscillator, multiple mixer system in which the mixer circuit could be employed.

Figure 6A illustrates a simplified switch diagram of a mixer circuit in accordance with one embodiment of the invention.

Figure 6B illustrates a method of operating the mixer circuit shown in Figure 6A.

Figure 6C illustrates the mixer circuit of Figure 6A as a modified Gilbert cell mixer circuit.

Figure 7 illustrates a second embodiment of the mixer circuit.

Figures 8A and 8B illustrates common oscillator, multiple mixer systems utilizing the mixer circuits of Figs. 3A and 4 in accordance with embodiments of the invention.

Figures 9A-9C are functional block diagrams of cascadable buffer amplifiers with switches.

Figure 10 is a functional block diagram of an integrated crosspoint switch with band translation.

Figures 11A-11D are functional block diagrams of switches.

Figure 12 is a functional block diagram of an integrated crosspoint switch with band translation.

Figure 13 is a functional block diagram of an integrated crosspoint switch with band translation.

Figure 14 is a functional block diagram of an integrated crosspoint switch with band translation.

Figure 15 is a functional block diagram of an integrated band translation switch interfacing with additional components to provide two signal outputs.

Figure 16 is a functional block diagram of a signal distribution system configured to receive signals from satellites and distribute them to multiple user devices.

Figures 17A-17D are functional block diagrams of AGC amplifiers.

Figures 18A-18B are functional block diagrams of cascaded amplifier configurations.

Figure 19 is a functional block diagram of cascaded integrated band translation switches.

Figure 20 is a flowchart of a method of distributing signals using cascadable AGC amplifiers.

Figure 21 is a functional block diagram of a band translation switch configured to frequency convert an input signal having a predetermined bandwidth.

Figure 22 is a functional block diagram of a band translation switch configured to switch and frequency translate signals from two sources to a single output.

Figure 23 is a flowchart of a method of frequency translating input frequency bands using an integrated band translation switch.

Detailed Description of the Preferred Embodiment

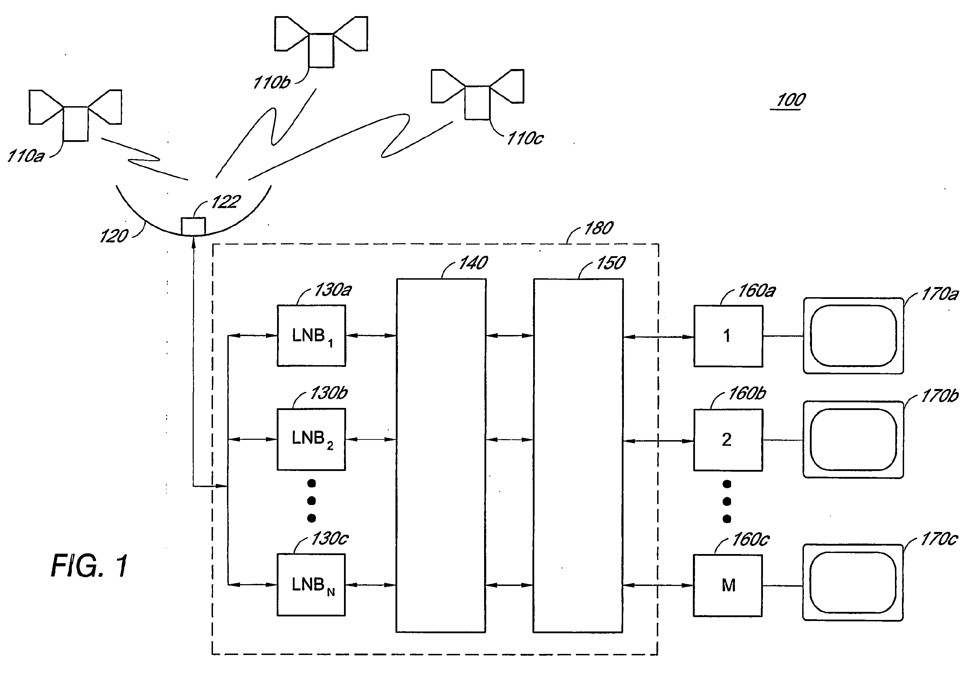

Figure 1 is a functional block diagram of one embodiment of a satellite based communication system, such as a satellite television system 100. However, the invention is not limited to application in a satellite based communication system, nor is the invention limited to use in a television system. The invention is applicable to any communication system where multiple signals in one or more input frequency bands can be distributed as signals in one or more output frequency bands to one or more receivers.

The satellite television system 100 includes one or more satellites 110a-110c that are set at various different orbital slots. Although three satellites 110a-110c are shown in figure 1, any number of satellites can exist in a particular satellite television system 100. The satellites can operate at different carrier frequencies and polarizations. The different carrier frequencies and polarizations that can be used by the satellites 110a-110c provide a degree of isolation of one satellite transmission from another. Additionally, the satellites 110a-110c can implement a directional antenna to provide further signal selectivity. Thus, a receiver can select the signals from a desired satellite, for example 110a, by receiving the broadcast signals with a corresponding polarized antenna oriented in the general direction of the desired satellite 110a and tuning to the desired satellite frequency. Because each satellite 110a-110c is configured in a similar manner, a more detailed description is provided for only one of the satellites 110a.

A satellite 110a in a satellite television system 100 can include a single transponder (not shown), but typically includes multiple transponders. Each of the transponders typically transmits at a different frequency and has an associated polarization. Two different transponders on the same satellite 110a can transmit on the same frequency but with different polarities if the selectivity provided by the difference in polarities is sufficient for the system. If each transponder transmits at a different frequency, the different transponders on a single satellite 110a can all transmit with the same polarity, or can use different polarities.

Additionally, some transponders can be configured with multiple carrier frequencies having various channel offsets. Other transponders may multiplex numerous digital channels on a single carrier. The integrated crosspoint switch with band translation described below can be configured to operate over one or more frequency bands with any transponder modulation type.

For example, a satellite 110a can include a first transponder that provides information on multiple carrier frequencies, with the carrier frequency spacing corresponding to a channel spacing for a television receiver. The transponders in a satellite 110a are typically arranged as transponder groups. For example, the transponder group can be configured to provide a contiguous group of channels. Alternatively, the signals in a particular transponder group can have varied channel offsets, with one or more channels having different carrier bandwidths or symbol rates. Additionally, the transponders in a satellite group can be configured to all transmit using the same polarization. A typical satellite 110a configured for a satellite television system 100 can include two transponder groups having sixteen transponders in each transponder group, with each group having a different polarity. Of course, the satellite 110a is not limited to any particular transponder configuration, nor are transponder groups necessarily limited to sixteen transponders.

A satellite 110a configured to operate in a satellite television system 100 typically transmits downlink signals in one of two frequency bands. Each frequency band can include one or more channels corresponding to one or more transponders. A first downlink frequency band is in the C-band and typically spans 3.6-4.2 GHz. A second downlink frequency band is in the Ku-band and typically spans 10.7-12.75 GHz. Of course, each satellite or some other signal source may transmit signals over one or more frequency bands. The frequency bands are not limited to the two listed frequency bands, and may be any suitable frequency bands, including one or more frequency bands that have yet to be defined and allocated by regulating bodies.

Of course, the upper and lower band edges for the one or more downlink frequency bands are not absolutes because of the practical limitations on constructing a brick wall filter. Rather, the frequency bands typically represent passbands and the operating transponder downlink frequency band typically comprises a frequency band that includes a frequency band having the upper and lower band edges within the passband. Alternatively, the band edges can define stop band edges and the transponder can transmit a substantially diminished energy outside of the band edge frequencies. Thus, practically, the downlink frequency bands can span about, or substantially, 3.6-4.2 GHz and 10.7-12.75 GHz. Additionally, while a satellite 110a can be configured to use a particular downlink frequency band, the satellite 110a may not actually transmit signals at all frequencies within the downlink frequency band. A satellite 110a is not limited to transmitting a downlink signal in these two frequency bands, and there can be additional downlink frequency bands implemented by the satellite 110a. These additional downlink frequency bands can be distinct from the previously described downlink frequency bands or can overlap some or all of the previously described downlink frequency bands.

The downlink signals transmitted by the satellites 110-110c can be received by a terrestrial television system and displayed to one or more televisions 170a-170c. An antenna 120 is typically used to receive the signals from the satellites 110a-110c. The antenna 120 is shown in figure 1 as a dish antenna but other antenna 120 configurations can also be used. In the embodiment implementing a dish antenna 120, a reflector can direct the downlink signals to an antenna feed 122. Although the antenna 120 is shown with only one antenna feed 122, one or more antenna feeds 122 can be implemented on a single antenna 120. Some antenna configurations suitable for operation within the system can not include an antenna feed 122. The antenna 120 or antenna feed 122 can be configured to receive signals from a particular downlink frequency band or a particular polarization. For example, the antenna 120 and antenna feed 122 can be configured to receive the 10.7-12.75 GHz frequency band having a left hand circular polarization. Another antenna feed (not shown) included as part of the antenna 120 can be configured to receive another downlink frequency band having the same or different polarization. Additionally, although one antenna 120 is shown in figure 1, multiple antennae can be implemented in a location or multiple locations as part of a single system.

The output from the antenna 120 is connected to a receiver 180 that is used to process the received signals. In a typical satellite television system 100 the receiver 180 includes low noise amplifiers that amplify the signals while minimizing the associated noise contribution. Additionally, the signals received at the satellite downlink frequencies are typically frequency translated to one or more predetermined frequency bands, or common Intermediate Frequency (IF) bands. The received downlink signals can also be filtered to remove out of band signals that can contribute interference.

In one embodiment the carrier frequency spacing of the downlink signals transmitted by the satellites 110a-110c typically corresponds to a channel spacing used by a television receiver or a set top box. In this embodiment, it can be advantageous to frequency convert the entire received downlink frequency band to one of the predetermined frequency bands used by television receivers or set top boxes. Alternatively, the received downlink frequency band can be frequency converted to predetermined frequency bands at intermediate frequencies for further processing prior to conversion to frequencies compatible with television receivers or set top boxes. In another embodiment, several channels may be multiplexed using a single carrier. In this embodiment, one or more multiplexed carriers can be frequency converted to input frequencies of a set top box.

The process of low noise amplification, filtering, and initial frequency conversion can be performed by low noise block converters (LNB) 130a-130c. Three LNB's are shown in Figure 1, though fewer or more can be used. A LNB, for example 130a, can be configured to receive signals from one or more antennae, for example 120, amplify, filter, and block frequency convert the signals to a common IF band. A first set of downlink signals, such as those from a first transponder group, can be block converted to a first common IF band and a second set of downlink signals, such as those from a second transponder group, can be block converted to a second common IF band. For example, the LNB 130a can receive downlink signals from two transponder groups. The multiple signals from two transponder groups can be received at one or more antennae 120, or one or more antenna feeds 122. Additionally, the downlink signals can originate from one satellite, for example 110a, or more than one satellite 110a-110c.

For example, the LNB 130a can block convert the signals from the first transponder group to a common IF band of 950-1450 MHz. Similarly, the LNB 130a can simultaneously block convert the signals from the second transponder group to a common IF band of 1650-2150 MHz. The block converted signals at the two common IF bands can be combined prior to being output from the LNB 130a. This process of block converting two transponder groups to different predetermined frequency bands and then combining the signals from the predetermined frequency bands is commonly referred to as band-stacking. In the previous example, the band stacked output from the LNB 130 comprises block converted transponder signals in a first common IF band at 950-1450 MHz and block converted transponder signals in a second common IF band at 1650-2150 MHz. Conceivably, based on the channel spacing and carrier bandwidths employed in particular transponder groups, signals from two transponder groups can be block converted to the same common IF band and combined without having two channels assigned to the same carrier frequency. Typically, two independent signals would not be combined at the same IF carrier frequency because each would appear as an interference source for the other, potentially making both signals unresolvable. In systems such as TDM or CDM systems, two signals can occupy the same frequency space and still be independently resolvable provided they occupy different spaces in other dimensions, such as time or code.

If the number of transponder groups exceeds the number of predetermined frequency bands, or common IF bands, it may not be possible to band-stack the signals from all of the transponder groups. In such a situation, the band-stacked output from a particular LNB 130a may constitute only a subset of all available transponder groups. Additional LNB's 130b-130c can be used to ensure that signals from all of the transponder groups are represented in one of the band-stacked outputs of the LNB's 130a-130c. However, the band-stacked outputs of the LNB's 130a-130c are not limited to having signals from distinct transponder groups. Thus, one or more of the band-stacked LNB outputs can have signals in common with another of the band-stacked LNB outputs. In other embodiments, band-stacking is not used, and each transponder group is outputted from the LNB independently.

The outputs from the LNB's 130a-130c are connected to the input of a switch configuration, referred to herein as an NxM crosspoint switch 140. The NxM crosspoint switch 140 includes N inputs and M outputs. Signals from each of the N inputs can be selectively routed to any of the M outputs. Thus, the band-stacked output from a first LNB 130a can be connected to a first input of the crosspoint switch 140 and can be selectively routed to any of the outputs of the crosspoint switch 140.

The crosspoint switch 140 can be configured such that only one input can be selectively routed to an output. Alternatively, the crosspoint switch 140 can be configured to selectively route more than one input to the same output. Additionally, the crosspoint switch 140 can also be configured such that an input signal can be selectively routed to only one output. Alternatively, the crosspoint switch 140 can be configured to selectively route an input signal to more than one output. Typically, the crosspoint switch 140 is configured to selectively route an input to a single output and only one input can be routed to the particular output. Where the crosspoint switch 140 configuration limits one output to one input, there can be some inputs that cannot be routed to outputs if the number if inputs, N, is greater than the number of outputs, M. Similarly, some input signals can not be able to be routed to an output if the crosspoint switch 140 configuration limits an output to a signal from only one input, and one input can be routed to multiple outputs.

Conversely, some outputs can not have any signals routed to them if the crosspoint switch 140 configuration only allows one input to be routed to one output and the number of inputs, N, is less than the number of outputs, M. Similarly, some outputs may not have any signals routed to them if multiple inputs can be routed to the same output and an input can only be routed to one output. The crosspoint switches in each of the embodiments can be configured in the various alternatives discussed above.

Each of the outputs of the crosspoint switch 140 is coupled to a corresponding input to a band translation section 150. The band translation section 150 can represent an integrated device that is configured to independently provide frequency band translation to signals at each of its inputs. Alternatively, the band translation section 150 can represent a collection of one or more band translation devices that are configured to frequency band translate signals at each of the inputs. In one embodiment, the band translation section 150 can include one or more band translation devices configured to frequency band translate one or more signals using a common local oscillator. In another embodiment, the band translation section can include one or more band translation devices configured to independently frequency band translate each of the input signals.

In one embodiment, a band translation device within the band translation section 150 has an input connected to an output of the crosspoint switch 140. An output of the band translation device represents an output of the band translation section 150. The band translation device can be configured to selectively couple an input signal directly to the output with no frequency translation, or alternatively to frequency translate the input signal to an output signal at a frequency band that differs from the input frequency band. The frequency translation device can further be configured, such that when frequency translation is selected, to selectively frequency translate the input signal from a first one of the predetermined frequency bands to a second one of the predetermined frequency bands.

In the satellite television embodiment described above, there are two predetermined frequency bands. A first predetermined frequency band spans 950-1450 MHz and the second predetermined frequency band spans 1650-2150 MHz. In this embodiment, a band translation device can frequency translate an input signal at one of the two predetermined frequency bands to an output signal at one of the same two predetermined frequency bands. It can be seen that there are four distinct possibilities. An input signal in the lower of the two predetermined frequency bands, 950-1450 MHz, can be frequency translated by the band translation device to either the lower, or the upper, of the two predetermined frequency bands. Thus, in the example, the signal output from the band translation device can be in the lower predetermined frequency band, 950-1450 MHz, or the upper predetermined frequency band, 1650-2150 MHz. Of course, in one of the conditions, there is no frequency translation, but rather, the input signal is coupled directly from the input of the band translation device to the output of the band translation device. The direct coupling from input to output without frequency translation can be referred to as a pass through state.

Similarly, an input signal provided to the band translation device at the upper frequency band can be output from the band translation device at the upper frequency band or the lower frequency band. In one state the band translation device is configured in pass through and in the other state the frequency translation device is configured to frequency translate the input signal.

The band translation section 150 can be configured to combine the outputs from one or more band translation section. Alternatively, external components (not shown) can combine one or more band translation device outputs.

Thus, a receiver 180 can implement the LNB's 130a-130c, the crosspoint switch 140, and the band translation section 150. The receiver 180 can implement all of these elements in a single integrated circuit or can implement one or more of the elements on separate integrated circuits or stand-alone devices. For example, the LNB's 130a-130c can each be implemented as stand-alone devices and the crosspoint switch 140 with the band translation section 150 can be implemented on a single integrated circuit. The LNB's 130a-130c, crosspoint switch 140 and band translation section 150 can be implemented in a single housing. This arrangement can be particularly advantageous where size of the components is of concern. Additionally, combining the crosspoint switch 140 with the band translation section 150 onto a single integrated circuit can greatly reduce the power requirements over a discrete configuration. Reducing the power requirements can result in additional advantages. For example, an integrated circuit crosspoint switch 140 and band translation section 150 having reduced power requirements may allow a system with a smaller power supply. Additionally, reduced power consumption typically corresponds to reduced heat dissipation. A system having reduced heat dissipation requirements can often use smaller heatsinks or may eliminate heatsinks. The use of smaller heatsinks can further reduce the size of the system. Additionally, an integrated circuit embodiment can advantageously have reduced cost as compared to a discrete system. The cost savings can be attributable to savings in components and materials that can be minimized or eliminated when the crosspoint switch 140 and band translation section 150 are configured as an integrated circuit.

In another receiver 180 embodiment, portions of the crosspoint switch 140 and portions of the band translation section 150 can be implemented on separate integrated circuits and one of the integrated circuits can be packaged within a LNB, for example 130a. In still another receiver 180 embodiment, the LNBs 130a-130c can be housed in a device that is remote from the crosspoint switch 140 and band translation section 150.

The outputs of the band translation section 150, and thus, the outputs of the receiver 180, are coupled to corresponding inputs of set top boxes 160a-160c. In the embodiment described, the predetermined frequency bands do not correspond to typical television receiver bands. Thus, the set top boxes 160a-160c can further frequency translate the signals to television receiver operating bands. Additionally, the output signals from the band translation section 150 can be in a format that is not compatible with standard television receivers 170a-170c. The set top boxes 160a-160c can then function as signal processing stages. For example, the satellite downlink signals can be digitally modulated in a format that is not compatible with a typical television receiver 170a-170c. The set top boxes 160a-160c can be configured to demodulate the digitally modulated signals, process the demodulated signals, and then modulate a television channel carrier frequencies with the signals for delivery to television receivers 170a-170c.

Alternatively, if the signals output from the band translation section 150 are in a format and are at a frequency band that is compatible with television receivers 170a-170c, the set top boxes 160a-160c may not be required. In still another alternative, one or more of the functions performed by the set top boxes 160a-160c can be integrated into the television receivers 170a-170c.

In the embodiment described in Figure 1 and in the embodiments described in the other figures, each of the television receivers 170a-170c can be connected to an output from one of the set top boxes 160a-160c. Each of the set top boxes 160a-160c can have one or more individually programmable outputs. However, more than one television receiver 170a-170c can be connected to an output from a single set top box, for example 160a. Alternatively, outputs from more than one set top box 160a-160c, or multiple outputs from one set top box such as 160a, can be combined or otherwise connected to a single television receiver, for example 170a, although such a configuration is not typical. A television receiver, for example 170a, can be configured to tune to a particular channel within the one or more frequency bands provided by the set top box, such as 160a. The television receiver 170a can process the signal from the selected channel to present some media content, such as video or audio, to the user.

A user is typically provided control, such as through a remote control for the television 170a or set top box 160a, to selectively configure the crosspoint switch 140 or band translation section 150. For example, a user can be allowed to select, using a remote control configured to operate with the set top box 160a, to receive signals from two distinct satellite transponder groups.

One of the satellite transponder groups can be received and frequency converted to a common IF band using the first LNB 130a. The first LNB 130a can be configured to frequency convert the signals to the upper IF band, 1650-2150 MHz. The second of the satellite transponder groups can be received and frequency converted to a common IF band using the Nth LNB 130c. The Nth LNB 130c can also be configured to frequency convert the signals to the upper IF band, 1650-2150 MHz. The LNB's of the other embodiments can be similarly configured. Thus, the block converted signals from the two transponder groups would ordinarily not be combinable if any two channels in the two transponder groups share signal bandwidths in the common IF bands.

However, in this example, the crosspoint switch 140 can be configured by control signals to output the signals from the first LNB 130a to a first crosspoint switch output and to output the signals from the Nth LNB 130c to a second crosspoint switch output. The band translation section 150 can then be configured, using the control signals provided by the set top box 160a, to pass frequency translate the signals from the first switch output from the upper IF band to the lower IF band. The band translation section 150 can also be configured to pass through the signals from the second switch output without frequency translation. A combiner within the band translation section can be configured to combine the output signals from the first and second band translation outputs. The composite signal then includes the signals from the first transponder group, located at the upper common IF band, and the signals from the second transponder group, located at the lower common IF band.

Thus, the example can be generalized to allow signals from any N signal sources, which can be satellite transponder groups, to be combined to M distinct band stacked signals. The band stacked signals can each include from one to M distinct frequency bands. Each of the band stacked signals can then be delivered to a set top box, multiple set top boxes, or one or more other receivers for presentation to one or more users.

For example, an output from a first output of the receiver 180 can be coupled to one or more set top boxes, for example 160a and 160b. Alternatively, multiple receiver 180 outputs that have information in mutually exclusive bands can be power combined and coupled to a single cable or distribution system for delivering the signal to one or more set top boxes or receivers. In still another embodiment, the crosspoint switch 140 may direct the same input signal to two separate inputs of the band translation section 150. The band translation section 150 may then frequency translate a portion of the input to a first frequency band and may also frequency translate a second portion of the input signal to a second frequency band. The two frequency bands can be combined into a signal that is directed to a single cable or distribution system. In still other embodiments, two separate LNB's with their own crosspoint switch with band translation section 150 having output signals in separate frequency bands can have their signals power combined at the LNB outside the house. In some embodiments, the LNBs 130a-130c, crosspoint swtich 140 and band translation section 150 are implemented as a single device that may be placed, for example, at the antenna 120. In other embodiments, the LNBs 130a-130c may be implemented in a first device and the crosspoint switch 140 and band translation section can be implemented as one or more devices that can be located locally or remotely from the LNBs.

The LNB's 130a-130c, crosspoint switch 140, band translation section 150, and set top boxes 160a-160c can be assembled in many different configurations. In each configuration, multiple independent users can each select different channels from one or more independent signals without affecting other users or devices.

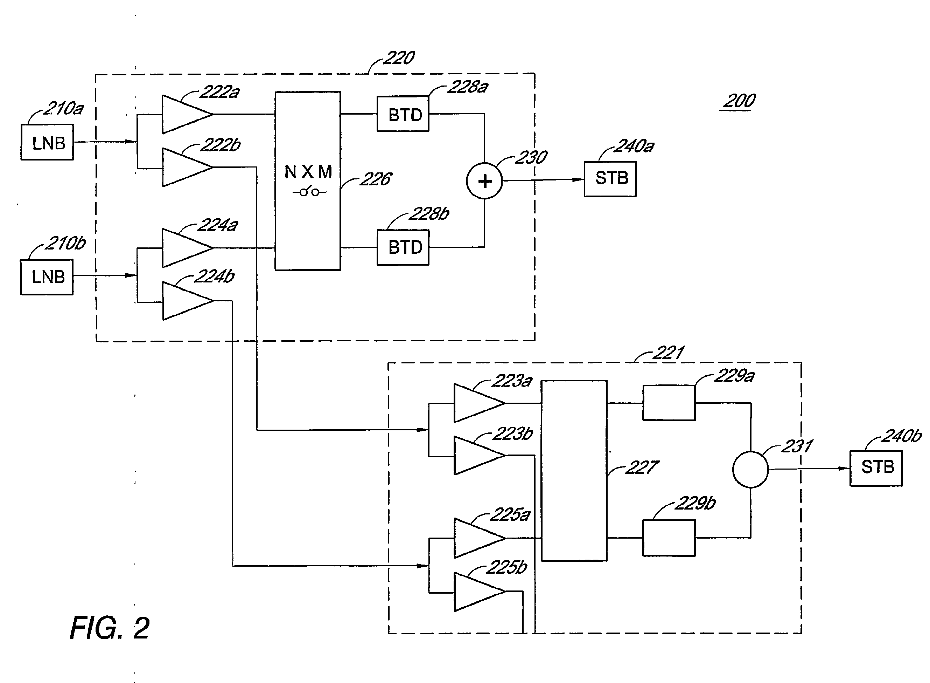

Other receiver embodiments can be assembled with multiple crosspoint switches connected to the same LNB's. Figure 2 is a functional block diagram of an embodiment of a receiver 200 having cascaded band translation switches 220, 221 that can be implemented as integrated circuits (IC). In this embodiment of a receiver 200, each of the band translation switches 220, 221 is configured with two inputs and a single output. As discussed earlier with respect to Figure 1, the band translation switches 220, 221 are not limited to any particular input and output configuration, but rather, can implement any number of inputs and outputs. Additionally, the first band translation switch 220 need not be configured the same as a second band translation switch 221, although the similar configurations are shown in Figure 2.

Two LNB's 210a, 210b are configured to provide the input signals to the first band translation switch 220. Each of the LNB's 210a, 210b can provide one or more signals in one or more frequency bands. A first LNB 210a is connected to a first set of buffer amplifiers 222a and 222b. The two buffer amplifiers 222a and 222b are configured in parallel.

Various alternative buffer amplifier configurations can be used, as will be discussed in greater detail below. A first internal buffer amplifier 222a connects the first input of the first band translation switch 220 to an input of a crosspoint switch 226. A first cascading buffer amplifier 222b connects the first input of the first band translation switch 220 to a first cascaded output. The first internal buffer amplifier 222a and the first cascading buffer amplifier 222b can be configured similarly or can be configured differently. Each of the first set of buffer amplifiers 222a, 222b, can be configured to provide gain or attenuation. The buffer amplifiers 222a, 222b can be unity gain amplifiers or can provide significant signal gain. Alternatively, the buffer amplifiers 222a, 222b can provide attenuation rather than gain.

The buffer amplifiers 222a, 222b can be configured such that changes at the output of one of the amplifiers, for example 222a, do not affect the other amplifier 222b. For example, the output of the internal buffer amplifier 222a is connected to an input of the crosspoint switch 226. The load that the input of the crosspoint switch 226 provides to the output of the internal buffer amplifier 222a can vary depending on various factors. For example, the impedance of the crosspoint switch 226 input can vary as a function of frequency. Alternatively, the impedance of the crosspoint switch 226 input can vary depending on the switch output selected or on the configuration of devices that can be connected to the selected crosspoint switch 226 output. Additionally, signals, such as local oscillator signals can be present at the output of the buffer amplifiers. Theoretically, the input of the crosspoint switch 226 can present any load from a short circuit to an open circuit, although in an actual configuration the actual variation in the load will not likely span the entire range. Ideally, the internal buffer amplifier 222a is configured such that its effect on the input of the band translation switch 220 does not vary for any load or signal presented at its output. Typically, the internal buffer amplifier 222a provides a level of signal isolation that is not infinite, but is great enough such that effects experienced at its input are minimal. Similarly, input load variation is not zero, but is minimal.

Similarly, the cascading buffer amplifier 222b can experience a load variation spanning from an open circuit to a short circuit because the output of the cascading buffer amplifier 222b is connected to an output of the first band translation switch 220. The cascading buffer amplifier 222b can likewise be configured to minimize the effect of load variations on the input of the amplifier.

The second input to the first band translation switch 220 is configured similarly to the first input. A second set of buffer amplifiers 224a, 224b have inputs connected to the second input. A second internal buffer amplifier 224a connects the second input to a second input of the crosspoint switch 226. A second cascading buffer amplifier 224b connects the second input to a second cascaded output of the first band translation switch 220. The second set of buffer amplifiers 224a, 224b are also configured to be insensitive to load variations and signals present at their outputs.

The crosspoint switch 226 in the first band translation switch 220 is configured to selectively couple each of the two internal buffer amplifier, 222a, 224a, outputs to one of two switch outputs. Although only two switch outputs are shown in the first band translation switch 220, any number of switch outputs can be incorporated into the crosspoint switch 226.

A first switch output is connected to a first band translation device 228a and a second switch output is similarly connected to a second band translation device 228b. As discussed earlier with respect to Figure 1, each of the band translation devices 228a-228b can be configured to frequency translate a signal or pass the signal to its output without frequency translation.

The outputs of the band translation devices 228a-228b are connected to inputs of a signal combiner 230, here represented as a signal summer. The output of the first band translation device 228a is connected to a first input of the signal combiner 230 and the output of the second band translation device 228b is connected to a second input of the signal combiner 230.

The signal combiner 230 is configured to combine the signals provided at its inputs and output a combined composite signal. The signal combiner 230 is shown as a signal summer, which is configured to sum the input signals and provide the composite signal at its output. Typically, the signal provided by the first band translation device 228a occupies a frequency band that is distinct from frequency band occupied by the signal provided by the second band translation device 228b. Because the signals from the two band translation devices 228a-228b are effectively frequency multiplexed, the input signals can be combined to provide a composite signal without experiencing destructive interference. Of course, the input signals are not required to occupy distinct frequency bands. The first input signal can occupy a band that overlaps some or all of the frequency band occupied by the second input signal. The resulting combined composite signal can experience some destructive signal interference if desired signals in the input signals occupy the same signal space. Alternatively, no signal interference can occur in the combined signal if the signal components in the input signals do not occupy the same signal space, for example frequency, time, or code space.

The composite output from the signal combiner 230 is connected to a first set top box 240a. Alternatively, the output from the signal combiner 230 can be coupled to more than one set top box, or to a signal distribution system (not shown) that can be coupled to one or more set top boxes and one or more receivers. As explained earlier with respect to Figure 1, the set top box 240a can be configured to further process the composite signal in order for the signals to be compatible with an end user device (not shown), such as a television.

A second band translation switch 221 is configured similarly to the first band translation switch 220. A first set of buffer amplifiers 223a, 223b receives a first input signal and a second set of buffer amplifiers 225a, 225b receives a second input signal. The first set of input buffers 223a, 223b includes an internal input buffer amplifier 223a that amplifies the first input signal and provides the amplified signal to an input of a crosspoint switch 227. The first set of input buffers 223a, 223b also includes a cascading buffer amplifier 223b that amplifies the first input signal and provides the amplified signal to an output of the second band translation switch 221.

The second set of input buffers 225a, 225b is similarly configured. The crosspoint switch 227, band translation devices 229a, 229b, and signal combiner 231 for the second band translation switch 221 are configured similarly to the corresponding element from the first band translation switch 220. The output of the second band translation switch 221 similarly is connected to a second set top box 240b and can be coupled to more than one set top box.

However, the input signals provided to the second band translation switch 221 are provided from the cascading buffer amplifiers 222b, 224b of the first band translation switch 220. Thus, by providing a cascading buffer amplifiers on the band translation switches 220, 221 the signals from LNB's 210a-210b can be provided to any number of band translation switches 220, 221 and ultimately to any number of set top boxes 240a-240b.

The LNB 210a-210b outputs can provide signals to multiple set top boxes 240a-240b without the number of set top boxes 240a-240b significantly affecting the quality of the signals to any other set top box, for example 240a. Thus, the signal quality from a particular LNB, for example 210a, at a particular set top box, for example 240a, is not significantly affected by the number of set top boxes 240a-240b that are ultimately connected to the LNB 210a. Additionally, connections from an LNB 210a to set top boxes 240a-240b can be added or subtracted, either through changes in the number of band translation switches 220, 221 cascaded or through selection at one of the crosspoint switches 226, 227, without substantially affecting the signal quality at a particular set top box 210a. The ability of the end user device to present the information, and the end users' ability to perceive differences in signal quality are factors that contribute to the amount of signal degradation that can occur in a signal to a set top box without there being a substantial affect on the signal quality at the set top box.

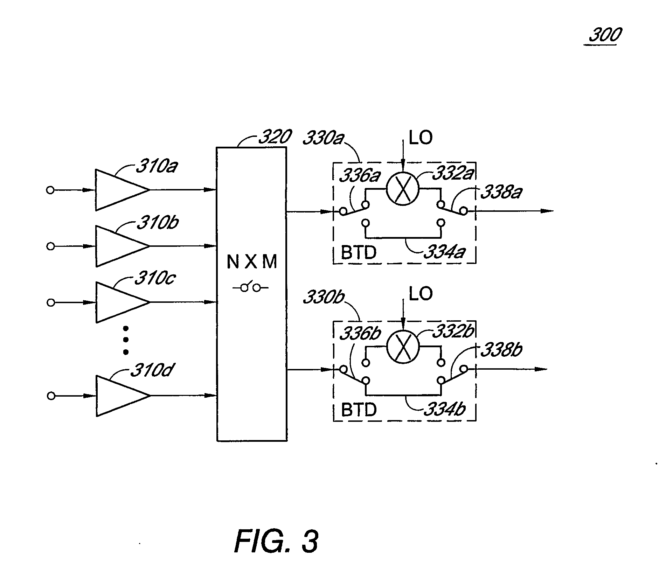

In addition to providing cascade outputs, a band translation switch can be configured to provide a pass through signal path in the band translation devices. The band translation switch Figure 3 shows a functional block diagram of an embodiment of a band translation switch 300 having band translation devices 330a-330b configured to selectively provide frequency translation or pass through. The band translation switch 300 can be implemented as a single integrated circuit.

A series of signal inputs are each coupled to the input of a corresponding buffer amplifier 310a-310d. In one embodiment, each of the signal inputs can receive a frequency multiplexed signal, such as an output from a LNB (not shown). The frequency multiplexed signal can be a band-stacked signal including signals from one or more predetermined frequency bands. In another embodiment, one or more of the signal inputs can receive information corresponding to a single channel. In still another embodiment, one or more of the signal inputs can receive a multiplexed signal containing several channels. The multiplexed signal can be, for example, a digitally modulated signal that is multiplexed to carry several channels.

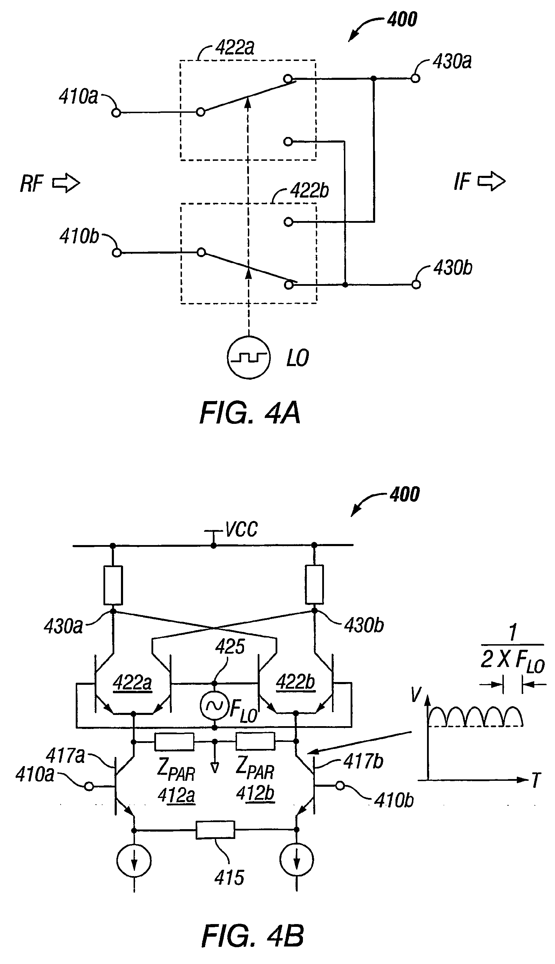

Each of the buffer amplifiers 310a-310d amplifies the received signal and couples the amplified output to a corresponding input of a crosspoint switch 320. The buffer amplifiers 310a-310d can be configured to couple the amplified signals solely to the respective crosspoint switch 320 inputs. Alternatively, one or more of the buffer amplifiers 310a-310d can be configured to also couple the amplified signals to corresponding cascade outputs (not shown) as will be disclosed in further detail below with respect to Figures 4A-4C.

As previously disclosed, the crosspoint switch 320 can be configured to selectively couple any one of its inputs to any one of its outputs. Thus, the amplified signals output from the buffer amplifiers 310a-310d and provided to the inputs of the crosspoint switch 320 can be selectively coupled to any of the outputs of the crosspoint switch 320. In the embodiment shown in Figure 3, the crosspoint switch 320 has two outputs, although the crosspoint switch 320 can typically implement any number of outputs.

A first output from the crosspoint switch 320 is coupled to a first band translation device 330a. Similarly, a second output of the crosspoint switch 320 is coupled to a second band translation device 330b. Although the two band translation devices 330a, 330b are typically similar structures, this is not a requirement. Each of the band translation devices 330a-330b can, for example, have a different structure.

The first band translation device 330a is configured with an input switch 336a which selectively routes an input signal to one of a frequency translation path or a pass through path in the band translation device 330a. The input switch 336a for the first band translation device 330a is shown in the frequency translation position.

When the input switch 336a is configured to route an input signal to a frequency translation path, the input signal is routed to an input of a frequency translation device, such as a mixer 332a. A signal from a local oscillator (LO) is coupled to a LO port on the mixer 332a. The LO can be integrated onto the same integrated circuit as other components of the band translation switch 300 or can be implemented externally to an integrated circuit band translation switch 300.

The band translated output frequency from the mixer 332a is a function of the input signal to the mixer and the LO frequency. As discussed above, the signals provided to the buffer amplifiers 310a-310d, and thus to the band translation devices 330a-330b, can be signals in predetermined frequency bands. The LO frequency can be programmable, or otherwise tunable, in order to allow an any one of the predetermined input frequency bands to be frequency translated to any one of the predetermined output frequency bands. Typically, the mixer 332a is configured such that the frequency translated output from the mixer 332a is optimized for ideal multiplier products. The desirable multiplier products can include the sum and difference frequency components or only one of the sum or difference frequency components. Typically, the input signal and the LO signal are undesirable signals at the output of the mixer. The mixer 332a can be configured such that higher order mixer products are negligible, that is, the higher order mixer products are below the desired mixer products by a predetermined amount, such as 40dB. Alternatively, higher order mixer products can be lower than 10dB, 15dB, 20dB, 30dB, 50dB, 60dB or some other level. Alternatively, the mixer 332a can be configured such that significant higher order mixer products appear at the output of the mixer 332a. Some or all of the higher order mixer products can be determined to not adversely affect the system. Alternatively, some or all of the higher order mixer products can be substantially reduced through filtering in subsequent stages (not shown). Filtering can be performed by implementing filters or can be accomplished as a result of the frequency response of elements that appear after the mixer 332a output. The filters can be implemented on the same substrate as the buffers 310a-310d, crosspoint switch 320, and mixers 332a and 332b. Alternatively, the filters can be implemented separate from the buffers 310a-310d, crosspoint switch 320, and mixers 332a and 332b and need not even be implemented locally to the other devices. The filters may have a passband that is greater than, equal to, or less than an input frequency bandwidth.

Some or all of the predetermined input frequency bands can be the same as, or different from, some or all of the predetermined output frequency bands. In one embodiment, the predetermined input frequency bands are distinct from one another and the predetermined output frequency bands are substantially identical to the predetermined input frequency bands. For example, the predetermined input frequency bands can include a first input frequency band of 950-1450 MHz and a second input frequency band of 1650-2150 MHz. The predetermined output frequency bands can then include a first output frequency band at 950-1450 MHz and a second output frequency band of 1650-2150 MHz, such that the predetermined input and output frequency bands are the same.

The frequency translated signal is output from the mixer 332a and coupled to an output switch 338a. The output switch 338a is configured to couple the signal output from the selected signal path to an output of the band translation switch 300. The output switch 338a for the first band translation device 330a is shown as selecting the frequency translation path.

The second band translation device 330b is configured similarly to the first band translation device 336a. An input switch 336b is configured to select a frequency translation signal path or a pass through signal path. The frequency translation path uses a mixer 332b driven by a LO to frequency translate the input signal. An output switch 338b couples the signal from the selected signal path to an output of the band translation switch 300.

The input switch 336b of the second band translation device 336b is shown as selecting the pass through signal path. Similarly, the output switch 338b or the second band translation device 330b is shown as selecting the pass through signal path. The pass through signal path is shown as a direct connection from the input switch 336b to the output switch 338b. However, any number of elements can be present in the pass through signal path. The only limitations are that the elements in the pass through signal path do not result in a frequency translation of the desired input signal to a different frequency at the output of the band translation device 330b. One or more filters or frequency selective devices placed after the band translation device 330b can be configured to filter the output of the band translation device 330b. The filters may have a passband that is greater than, equal to, or less than an input frequency bandwidth. Thus, even if the band translation device, for example 330a or 330b, is configured in pass through mode, the output band can be narrower than the input frequency band.

A band translation device, for example 330a, having an input switch 336a and an output switch 338a configured to select a signal path, typically controls the input switch 336a and the output switch 338a to select the same signal path. It can be advantageous to implement a band translation device 330a with both an input switch 336a and an output switch 338a in order to limit the effects the non-selected signal path has on the performance of the selected signal path. Of course, a band translation device, for example 330a, is not limited to any particular configuration, and need not incorporate two switches. Additionally, the band translation device, for example 330a, need not incorporate a pass through path, but instead, can incorporate two or more frequency translation paths.

Fig. 4A illustrates a simplified switch diagram of a doubly balanced mixer as known in the art. The mixer 400 includes RF and IF ports 410 and 430, respectively, each of which is shown differentially, but may be single-ended in another embodiment. The differential RF signal 410 is supplied to the input of SPDT switches 422, the states of which are switched at a rate determined by an LO signal 425 supplied thereto. The outputs of the switches 422 are coupled to differential IF ports 430 operable to provide the differential IF signal 430.

Fig. 4B illustrates the doubly balanced mixer of Fig. 4A as a Gilbert cell multiplier or mixer circuit known in the art. The mixer circuit includes two cross-coupled differential transistor pairs 422 whose base terminals are coupled to the LO source 425, collector terminals are coupled to the IF loads 430, and emitter terminals are coupled to buffer transistors 417. Responsive to the differential RF signal applied at terminals 410a and 410b, a voltage difference is established across resistor 415, resulting in the corresponding modulation of the quiescently-supplied current driving the transistor pairs 422 that comprise the mixer core. Those skilled in the art will appreciate that illustrated mixer circuit is only exemplary, and numerous variations of the circuit are also widely used.

While doubly balanced mixers provide a high level of even order mixing product suppression, circuit imperfections lead to degradation in that suppression. For example, a relatively low impedance parasitic 412 (e.g., capacitance) can load the emitter nodes of the mixers, the impedance operating to convert the rectified LO voltage into a common mode even order LO interferer current. The LO interferer can then pass through the mixer core and to the output loads.

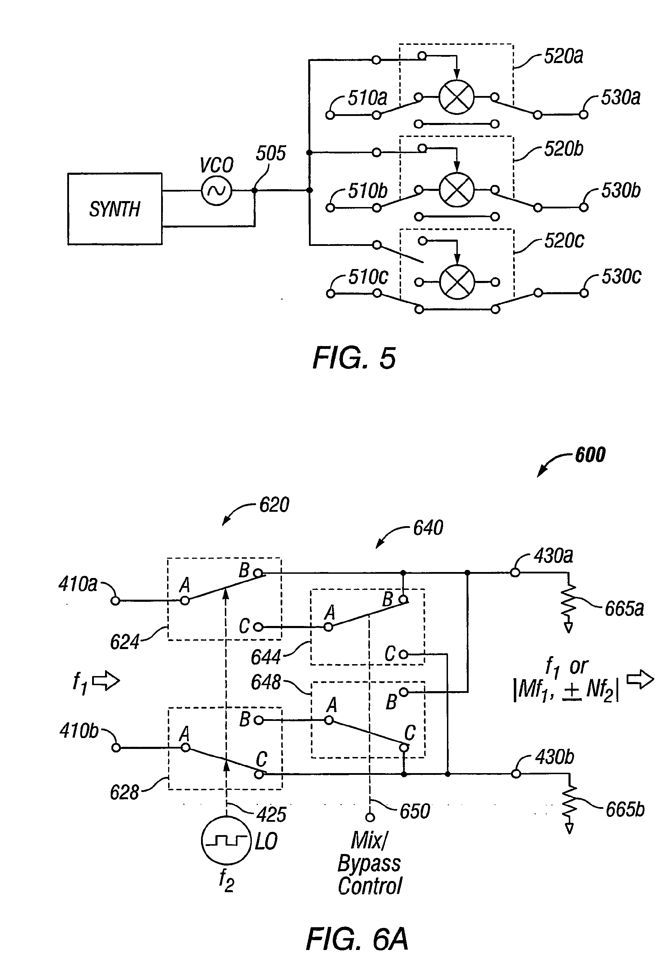

Reduced mixer even-order suppression can be especially problematic when the mixer is integrated with other circuitry. Fig. 5 illustrates one example of such an instance where multiple mixers are supplied by a single VCO. Each mixer is configured to operate in either a mixing mode, whereby the synthesized signal 505 and input signals 510a and 510b are provided to respective mixers 520a and 520b to produce respective mixed signals 530a and 530b, or in a bypass mode, whereby the synthesized signal 505 is not supplied to the mixer 520c and the input signal 510c is routed such that it bypasses the mixer 520c.

Fig. 6A illustrates a simplified switch diagram of a mixer circuit 600 in accordance with one embodiment of the invention. The mixer circuit 600 includes a mixer core 620 and a mode select circuit 640. The mixer core 620 includes two input switches 624 and 628, each switch having an input 624a, 628a, and two outputs 624b, 624c, and 628b, 328c, respectively. Switches are depicted to convey the component's general function, and those skilled in the art will readily appreciate that each may be realized using an variety of circuit elements, including transistors (BJT and FET types), diodes, and the like. Accordingly, as used herein, the term "switch" or "switches" shall denote any of these circuit elements, or equivalents thereof.

Input switches 624 and 628 are operable to accept a signal at a first frequency $f_1$ in either a differential or single-sided form. In a differential form, the first frequency signal $f_1$ will consist of a differential signal, wherein separate polarities of the first frequency signal $f_1$ are supplied to separate switch inputs 410a and 410b, respectively. During single-sided operation, only one of the switches' inputs (e.g., 410a) is needed to receive the first frequency signal $f_t$. In this embodiment, the input of the other switch (e.g., 410b) is coupled to an ac ground.

The first and second switches 624 and 628 are further configured to receive a switching signal 425, which operates to switch the first and second switches between their respective output states at a second frequency $f_2$, as will be further described below. In a particular embodiment shown, the first and second switches 624 and 628 are configured such that both, upon receiving the switching signal 425, switch to the opposite states (i.e., one to its first output, and the other to its second output). In such an embodiment, the switching signal 425 may be supplied in anti-phase to configure the first and second switches in opposite output states.

The mixer circuit 600 further includes a mode select circuit 640, implemented in one embodiment as third and fourth switches 644 and 648. Third switch 640 includes an input 644a switchable to two outputs 644b and 644c, and fourth switch 648 includes an input 648a switchable to two outputs 648b and 648c. As shown, the third switch's input 644a is coupled to the second output 624c of the first switch. The third switch's first output 644b is coupled to the first switch's first output 624b, and the third switch's second output 644c is coupled to the second switch's second output 628c. The fourth switch's input 648a is coupled to the second switch's first output 628b. The fourth switch's first output 648b is coupled to the first switch's first output 624b, and a second output 648c coupled to the second switch's second output 628c.

The third and fourth switches are further configured to receive a mode select signal 650 operable to select the output state of the third and fourth switches 644 and 648. In a specific embodiment, the third and fourth switches 644 and 648 are collectively configured to operate in one of two states: a bypass state or a mixing state. The bypass state is exemplified in Fig. 6A with the third switch 644 coupled to its first output 644b and the fourth switch 648 coupled to its second output 648c as shown in Fig. 6A. The mixing state could be alternatively realized by switching both states of the third and fourth switches, as will be further illustrated below. The resulting bypass or mixed signal is provided in differential form at output ports 430a and 430b. IF loads 665a and 665b are each coupled to a respective output port and an ac ground, as described below. In an alternative embodiment, a single IF load may be coupled between ports 665a and 665b. The term "IF" load shall not infer that the loads' frequency of operation is limited to those frequencies below the input signals, and in fact may be a higher operational frequency when the desired mixing product is an upconverted signal. Further, the IF load may comprise active or passive components as known in the art.

The switches (or their corresponding implementation in transistors, diodes, or other components) may be discretely or integrally formed using a variety of fabrication techniques known in the art, including monolithic fabrication in a Bipolar Complementary Metal Oxide Semiconductor (Bi-CMOS) process. Additional circuitry described herein, such as IF loads and oscillator circuitry, as well as other components may be monolithically formed onto an integrated circuit device in accordance with the invention.

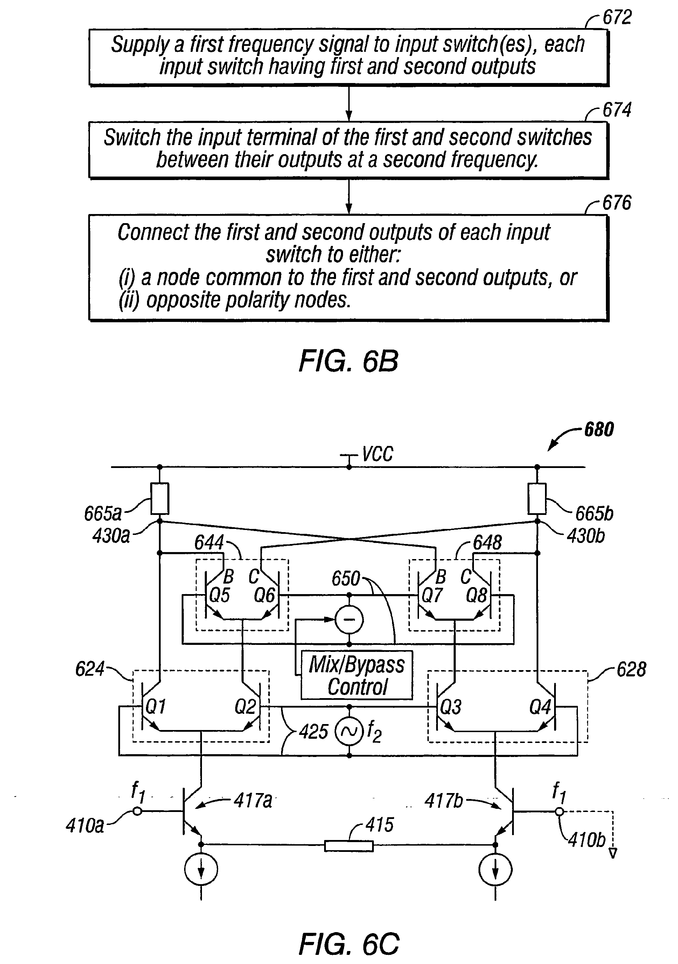

Fig. 6B illustrates a method for operating the mixer circuit shown in Fig. 6A in accordance with the invention. Initially at 672, a first frequency signal is supplied to one or both of the input switches 624 and 628. As explained above, the first frequency signal may be in the form of a single-sided signal, in which case the first frequency signal is applied to one of the inputs 410a or 410b, the other switch input being coupled to an ac ground. In the case of an applied differential signal, oppositely polarized signals are supplied to respective signal inputs 410a and 410b.

Next at 674, the input terminal of the first and second switches is switched between each switch's first and second output at a second frequency $f_2$. In a specific embodiment, this process is performed by using the second frequency signal as a switch control signal. In such an embodiment, an oscillator or other frequency source used to generate the second frequency signal may be local/integrated with one or more of the switches, or may be externally located and supplied to the first and second switches via a transmission medium.

Next at 676, the first and second outputs of each input switch are coupled to either: (i) a node common to the switch's first and second outputs, or (ii) nodes of opposite polarity. Connecting the two outputs to a common node results in the first frequency signal being output at 430 (bypass mode), and connecting the two outputs to opposite polarity nodes results in a mixing operation of the first and second frequency signals, and accordingly the generation of one or more mixing products therefrom. The process of 676 is performed by the mode select circuit 640 illustrated in Fig. 6A, whereby in the bypass mode of operation the third switch is configured to connect the first and second outputs of the first switch 624 to a common node 430a, and the fourth switch 648 is configured to connect the first and second outputs of the second switch 628 to a common node 430b. To operate in the alternate mixing mode, the process is performed by switching the states of the third and fourth switches. In this state, the first and second outputs of the first switch 624 will alternately connect to opposite polarity nodes 430a and 430b, and the first and second outputs of the second switch 628 will also alternately connect to opposite polarity nodes 430b and 430a. In this manner, the output states of the third and fourth switches 644 and 648 are configurable either in a bypass mode where the outputs of the first and second switches are connected to a common node, or in a mixing mode where the outputs of the first and second switches are connected to opposite polarity nodes. Further preferably, the connection between the mixer core (first and second switches) and the IF loads 665a and 665b is maintained during operation in either the bypass mode or mixing mode. Additionally, the first and second switches are controlled to continuously switch between their respective outputs at the second frequency during operation in either the bypass or mixing modes. As noted above, a single IF load may be coupled between nodes 430a and 430b in an alternative embodiment under the invention.

Fig. 6C illustrates the mixer circuit of Fig. 6A as a modified Gilbert cell mixer circuit 680 in accordance with the invention, with previously identified components retaining their reference numerals. As depicted, each of the switches 624, 628, 644, and 648 are implemented as a differential pair of npn bipolar junction transistors Q1-Q8. A mixer/bypass control circuit produces a control signal 650 which is supplied differentially to the base terminals of the mode select switches 644 and 648. The polarity of control signal may be reversed to switch circuit operation between bypass and mixing modes. A signal source (e.g., a LO source) is operable to provide the second frequency signal 425 to the mixer core switches 624 and 628. The input signal $f_1$ is applied to the input terminals 410a and 410b of buffer transistors 417, or alternatively may be provided as a single-ended signal, in which case one of the input terminals 410a or 410b is coupled to an ac ground, as described above.

In a specific embodiment of the mixer circuit 680, transistors Q1-Q8 are npn bipolar transistors 20 um x 0.4 um, IF loads 665a and 665b are 200 ohms, resistor 415 is 200 ohms, the first frequency signal $f_1$ operates at 950 - 2150 MHz, the second frequency signal $f_2$ operates at 3100 MHz, and the mode select signal 650 is 500 mV DC. The circuit's supply $V_{cc}$ operates at +6 VDC. Further specifically, the illustrated components are integrally formed using a 0.35 um Bi-CMOS photolithographic process. Skilled practitioners will appreciate that that the circuit 680 can be alternatively realized using various modifications, e.g., pnp-type bipolar transistors, n or p-type field effect transistors, or other components such as diodes, and the like.

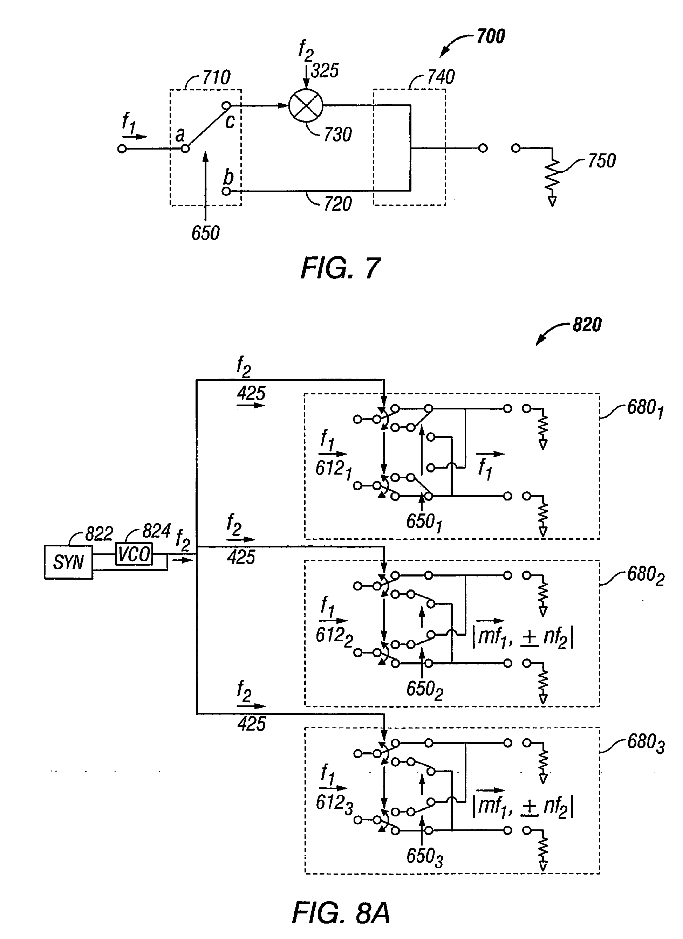

Fig. 7 illustrates a second embodiment of the mixer circuit in accordance with the invention. The mixer circuit 700 includes a mode select switch 710 having an input 710a to receive the first frequency signal $f_1$, a first output 710b coupled to a bypass circuit 720, and a second output 710c coupled to a mixing core 730. The bypass circuit 720 may be any transmission medium operable to support the propagation of the first frequency signal therealong, including printed/integrated circuit traces (including ungrounded lines or grounded lines such as microstrip, stripline, coplanar waveguide and the like), wire, twisted pair line, coaxial cable, conductive or dielectric waveguide, and the like. The mixer core 730 has an input coupled to the switch's second output 710c, a second input operable to receive the second frequency signal 425, and an output. The mixer core 730 can be of any conventional type (i.e., single-ended, singly-balanced, doubly balanced, etc.) and realized in any of the known forms, such as a Gilbert cell mixer.

The mixer circuit further comprises a signal combiner 740 coupled to the bypass circuit 720 and the mixer output. The signal combiner 740 has an output coupled to a common load 750. The signal combiner may be realized as a commonly connected port, power combiner (active or passive), or similar circuits. Selection of the bypass or mixing mode is provided by a mode select signal 650, which is supplied by a control circuit. The mixer core 730 is supplied the second frequency signal 425 via a local oscillator. One or more of the described components may be integrally fabricated into a monolithic circuit using semiconductor processing techniques appropriate for the particular material. Preferably, the operation of the mixer core continues and circuit connections between the mixer core 730 and the common load 750 is maintained during operation within or switching between the bypass and mixing modes.

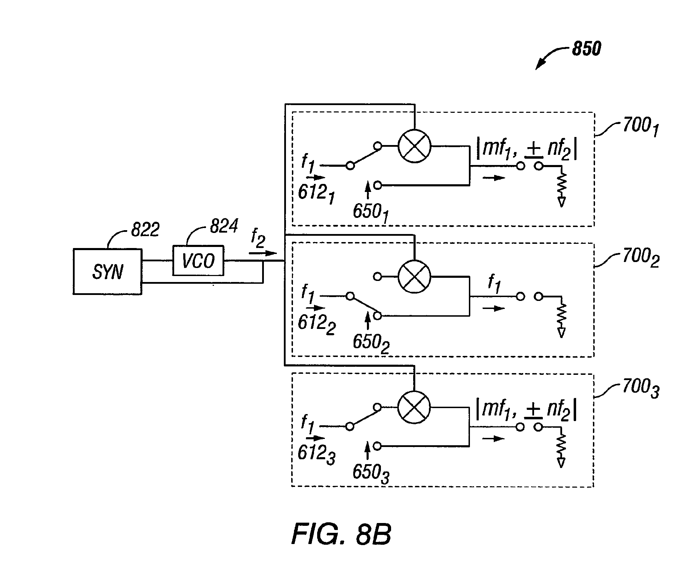

Figs. 8A and 8B illustrate exemplary systems using the improved mixer circuit of Fig. 6A or 7 in accordance with the invention, the exemplary systems comprising a common oscillator, multiple mixer system. Referring first to Fig 8A, the system 820 includes a frequency synthesizer 822 and a VCO 824 coupled to three mixer circuits $680_{1-3}$, the detailed architecture of each being described in Figs. 6A and 6C, above. The frequency synthesizer 822 and VCO 824 operate to produce the second signal frequency $f_2$, which is supplied to each of the three mixer circuits $680_{1-3}$. Each mixer circuit $680_{1-3}$ is additionally supplied with a first frequency signal $612_{1-3}$ in differential form. Each first frequency signal $612_{1-3}$ is identified as $f_1$ for convenience, and the reader will appreciate that each of these frequencies may be different.

The mixer circuits $680_{1-3}$ are supplied respective mode select signals $650_{1-3}$ to configure each corresponding mixer circuit to their desired output. In the shown embodiment, the first mixer circuit $680_1$ is supplied a "bypass" mode signal $650_1$, resulting in the (differential) output at the first signal frequency $f_1$. The second mixer circuit $680_2$ is supplied a "mix" mode signal $650_2$, resulting in the output of the mixing product described above. Similarly, the third mixer circuit $680_3$ receives the first and second frequency signals $f_1$, $f_2$, and the "mix" mode signal $650_3$, resulting in the mixing mode of operation. Preferably, the first and second switches of each mixer circuit $680_{1-3}$ continues to switch at the second frequency $f_2$ regardless of whether the supplied control signal $650_{1-3}$ sets the mixer circuit to a bypass mode or mixing mode. Additionally, the mixer circuit's coupling to the IF loads 665a and 665b (or to a single IF load coupled between differential nodes 430a and 430b) is maintained during and switching between the bypass and mixing modes.

Fig. 8B illustrates another embodiment of a common oscillator, multiple mixer system 850 in which the mixer circuit of Fig. 7 is employed. The system 850 similarly employs a frequency synthesizer 822 and a VCO 824 for generating the second frequency signal $f_2$ which is commonly supplied to the mixer circuits $700_{1-3}$. In this system, the first frequency signal $612_{1-3}$ (identified as $f_1$ for convenience only) is supplied to the input of each mixer circuit. A corresponding mode select signal $650_{1-3}$ is also supplied to set the switches in the desired bypass or mixing mode enabling the independent control of each mixer circuit in either a bypass or mixing mode. As described above with respect to the mixer embodiment of Fig. 7, the operation of the mixer continues and circuit connections between the mixer core 730 and the common load 750 can be maintained during operation within or switching between the bypass and mixing modes in order to maintain a substantially constant level of LO even-order interference.

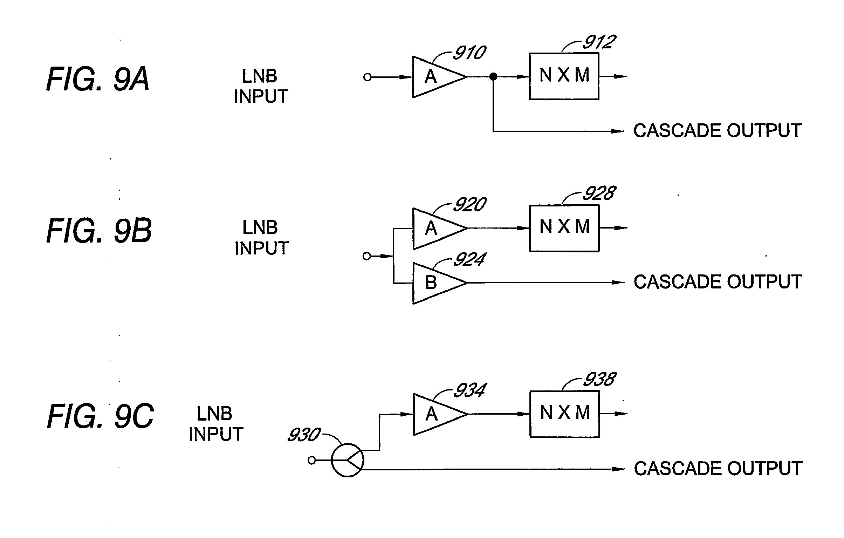

Just as there are various embodiments for the band translation devices, there are also various embodiments for cascadeable buffer amplifiers. Figures 9A-9C show functional block diagrams of various embodiments of cascadable buffer amplifiers with switches. Figure 9A shows a functional block diagram of an embodiment having a single buffer amplifier 910 configured to drive both the input to the crosspoint switch 912 as well as the cascade output. This configuration uses fewer elements than do the embodiments shown in Figures 9B or 9C. However, the design of the buffer amplifier 910 can be more complicated because the buffer amplifier 910 is configured to drive two potentially independent loads. Ideally, changes in the load placed on the cascade output should not affect the signal provided to the crosspoint switch 912. Similarly, changes in the configuration of the crosspoint switch 912 and devices (not shown) connected to the output of the crosspoint switch 912 should not affect the signal provided to the cascade output. Thus, the embodiment shown in Figure 9A can show the fewest elements, but can require a more complex buffer amplifier 910 design.

The embodiment of Figure 9B is equivalent to the buffer amplifier embodiment disclosed in Figure 2. The buffer amplifier embodiment uses two buffer amplifiers 920, 924 connected in parallel. The input signal provided, for example, by an LNB is coupled to an internal buffer amplifier 920 and a cascading buffer amplifier 924. The internal buffer amplifier 920 amplifies the input signal and drives the input to the crosspoint switch 928. The cascading buffer amplifier 924 amplifies the input signal and drives the cascade output. The cascade output can represent an output from an IC which includes the buffer amplifier embodiment. As discussed previously with respect to Figure 2, the internal buffer amplifier isolates load changes and interference at its output from its input. The internal buffer amplifier 920 thus provides signal isolation to the buffer amplifier input and the cascade output. Similarly, the cascading buffer amplifier 924 isolates load changes and interference at its output from its input, thereby providing signal isolation to the buffer amplifier input and the cascade output.

The two amplifier embodiment has the advantages of high isolation between the outputs of the buffer amplifiers and between the outputs of the buffer amplifiers to the input of the buffer amplifiers. However, the multiple amplifier embodiment can require more active devices, which consume power, generate heat, generate interference, and increase cost. Thus, the multiple amplifier configuration may not be the most desirable solution for all applications.

Another buffer amplifier embodiment is shown in the functional block diagram of Figure 9C. In the embodiment of Figure 9C, the input signal, for example the output from an LNB, is provided to the input of a power divider 930. The power divider 930 can for example, be a passive power divider or an active power divider. Additionally, the power divider 930 can be configured to provide substantially an equal power split or can be configured to provide a majority of the power to one of the output ports. The signals provided at each of the output ports of the power divider 930 can be in-phase or can be out of phase.

One of the output signals from the power divider 930 is coupled to a buffer amplifier 934 that is configured to amplify the signal and couple the amplified signal to an input of the crosspoint switch 938. The other output from the power divider 930 is coupled to the cascade output.

The embodiment of Figure 9C can be advantageous because the power divider 930 can be implemented as a passive device that consumes no power. Additionally, the power divider 930 provides a degree of isolation between the cascade output and the buffer amplifier output. There is also signal isolation between the output ports of the power divider 930. However, if the power divider 930 is a passive device, the signal isolation between the output ports is typically not as great as is obtainable from the two amplifier configuration. Additionally, a passive device can require considerable area on an integrated circuit or can not be feasible to implement on an integrated circuit. Also, the signal quality can be severely degraded if multiple passive power divider stages are cascaded.

Thus, various buffer amplifier embodiments have been shown. However, each of the embodiments has advantages and disadvantages and the optimal configuration will depend on the requirements of the system. Additionally, the embodiments disclosed are only examples and are not meant to be an exhaustive list of available configurations. Other configurations can be implemented.

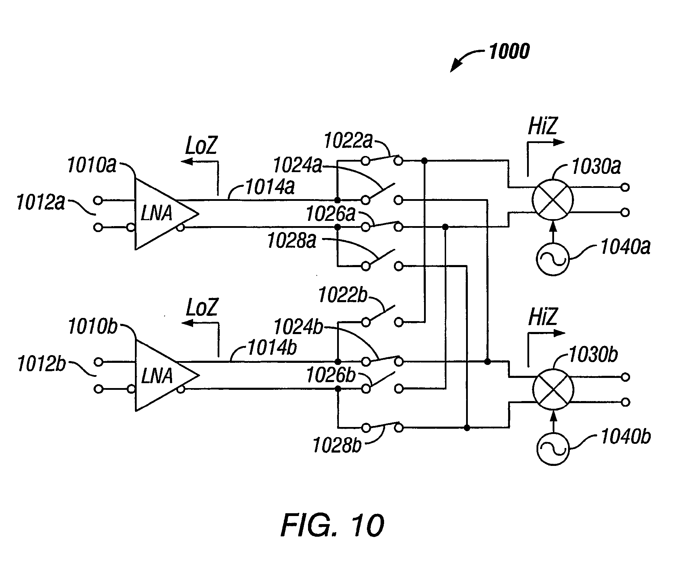

Figure 10 is a functional block diagram of a crosspoint switch with band translation 1000. A two input and two output version of the receiver 180 of Figure 1 can be implemented with the crosspoint switch with band translation 1000 of Figure 10 in combination with two LNB's. For example, the receiver of Figure 1 can include LNB modules connected to an integrated circuit implementation of the crosspoint switch with band translation 1000. This configuration of a receiver allows signal routing and band translation to be performed at a location physically close to the LNBs. The physical proximity of LNBs to the crosspoint switch with band translation 200 minimizes the loss and induced noise experienced by the received signals.

The crosspoint switch with band translation 1000 is not limited to having only two inputs and two outputs. Other embodiments of the crosspoint switch with band translation 1000 can include additional inputs and outputs. The number of inputs can be generalized to any number, N. The number of inputs, N, can be, for example, 2, 3, 4, 5, 6, 7, 8, 9, 10, 11, 12, 13, 14, 15, 16, or some other number. Similarly, the number of outputs can be generalized to any number, M. The number of outputs, M, can be, for example, 1, 2, 4, 6, 8, 10, 12, 14, 16, 18, 20, 22, 24, 26, 28, 30, 32, or some other number.

Additionally, the crosspoint switch with band translation 1000 can be located remote from a signal source, such as an antenna or LNB modules. For example, one or more coaxial cables can couple the outputs from LNB modules to inputs of the crosspoint switch with band translation 1000. In an example environment such as signal distribution within a residence, the LNB modules can be a distance of more than 250 feet away from the crosspoint switch and can couple to the LNB modules with coaxial cables.

The crosspoint switch with band translation 1000 can be configured using differential signal interconnections to improve signal isolation. The device can be implemented with single ended signal interconnections but differential signal interconnections typically provide greater isolation. Signal isolation is of greater concern when the device is implemented in a single integrated circuit.

The crosspoint switch with band translation 1000 has a first signal path and a second signal path. The first signal path includes a first low noise amplifier (LNA) 1010a connected to an arrangement of switches, 1022a, 1024a, 1026a, and 1028a, that can selectively route a signal at the output 1014a of the LNA 1010a to a first band translation device 1030a or a second band translation device 1030b. The crosspoint switch with band translation 1000 of Figure 10 is configured to provide voltage-mode switching of the signals.

The first LNA 1010a is configured with a differential input 1012a and a differential output 1014a. The differential input 1012a of the first LNA 1010a can be, for example, matched to 75 ohm differential. The differential output 1014a of the first LNA 1010a is configured to have a low impedance. The crosspoint switch with band translation 1000 maximizes signal isolation and minimizes switching transients by connecting a high isolation switch configuration to the output of the first LNA 1010a. Band translation devices 1030a, 1030b having high input impedances are connected to the outputs of the switch configuration.

In one embodiment, a low output impedance refers to a typical magnitude less than 10 ohms differential. In other embodiments, low impedances may refer to other impedance magnitudes that may be higher or lower than 10 ohms, and need not be defined differentially. For example, a low impedance can refer to a magnitude of substantially less than 33 ohms. In another embodiment, a high impedance refers to a magnitude of typically greater than 1 kohm differential. In other embodiments, high impedances may refer to other impedance magnitudes that may be higher or lower than 1 kohm, and need not be defined differentially. For example, in another embodiment, high impedance can refer to a magnitude of typically greater than 330 ohms. In general the terms low impedance and high impedance are defined relative to one another. That is, high impedance is defined to be greater than or equal to approximately ten times the low impedance value. Thus, for a low impedance value of 33 ohms, a high impedance value is greater than approximately 330 ohms.

The in-phase output of the first LNA 1010a is connected to switches 1022a and 1024a that selectively switch the signal to the in-phase inputs of the band translation devices 1030a, 1030b based on switch control signals provided by, for example, the controller in the set top box 160a of Figure 1. In an alternative embodiment, a microprocessor local to, or integrated with the crosspoint switch with band translation 1000 can process signals, such as one or more control messages, from an associated set top box or receiver. The inverted phase output of the first LNA 1010a is connected to switches 1026a, 1028a that selectively switch the signal to the inverted inputs of the band translation devices 1030a, 1030b. A switch connected to the in-phase output, for example 1022a, is typically paired with a switch on the inverted output, for example 1026a, such that a differential signal is selectively connected by the switch pair 1022a, 1026a.

Thus, the controller in the set top box can direct a first switch pair 1026a, 1026a to selectively connect the differential output of the first LNA 1010a to the differential input of the first band translation device 1030a. A second switch pair 1024a, 1028a selectively connects the differential output of the first LNA 1010a to the second band translation device 1030b.

The first band translation device 1030a can selectively frequency translate the signal at its input to an output frequency band. The first band translation device 1030a uses a signal from a first Local Oscillator (LO) 1040a to perform the frequency translation.

A second signal path is configured similar to the first signal path. A second LNA 1010b has a differential input 1012b and a differential output 1014b. The signal at the differential output 1014b of the second LNA 1010b is selectively connected to the first band translation device 1030a using a third switch pair 1022b, 1026b. The signal at the differential output 1014b of the second LNA 1010b is selectively connected to the second band translation device 1030b using a fourth switch pair 1024b, 1028b.

Typically, the signals from the first LNA 1010a and the second LNA 1010b are not switched to the same band translation device, for example 1030a. The output of a single LNA 1010a can be switched to both band translation devices 1030a, 1030b while the other LNA signal is not provided to any of the band translation devices 1030a, 1030b.

The crosspoint switch with band translation 1000 is configured to provide high signal isolation between the input signals and the output signals from the LNA's 1010a and 1010b, and high isolation through the crosspoint switch section 1022a-1028b. Additionally, the crosspoint switch with band translation 1000 provides high signal isolation at the input and output of the band translation devices 1030a and 1030b. Additionally, the crosspoint switch with band translation 1000 has high signal isolation and low switching transients. Low switching transients are achieved through the use of low impedance at the LNA outputs combined with high impedance inputs at the band translation devices 1030a, 1030b. High signal isolation is achieved using differential signal configuration and is also achieved through the use of high isolation switches.

High signal isolation typically refers to greater than 30 dB of isolation. It may be advantageous to achieve a high signal isolation that is greater than approximately 40 dB. In general, high signal isolation can refer to greater than 20 dB, 25 dB, 30 dB, 35 dB, 40 dB, 45 dB, 50 dB or some other greater level of isolation.

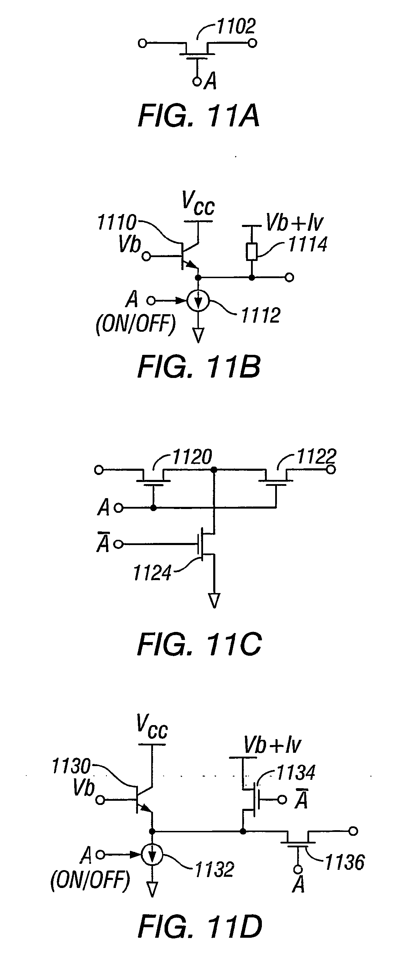

Figures 11A-11D are embodiments of high isolation switches. Each of the switch embodiments of Figures 11A-11D are single-ended configurations. The switch embodiments can be duplicated to allow switching of in-phase and inverted signals of differential signals. Thus, a pair of switches from Figures 11A-11D can be used as the switch pairs of Figure 10.

Figure 11A is a first switch embodiment having a single transistor 1102 controlled to selectively connect a signal from its input to its output based on the signal applied to the control input. The transistor 1102 can be controlled to selectively isolate a signal at its input from its output based on the signal applied to its control input. Signal isolation is controlled by the ability of the transistor 1102 to isolate the input from the output. A pair of transistors 1102 can be used to switch differential signals.

Figure 11B is a second switch embodiment. A signal is input at the base of a first transistor 1110 configured as an emitter follower. Additionally, a bias voltage, which is typically a DC bias voltage, is applied to the base of the first transistor 1110. The emitter of the first transistor 1110 is selectively biased with a controllable current source 1112. The first transistor 1110 selectively couples a signal from its base to its emitter when the controllable current source 1112 conducts. Conversely, a signal at the base of the first transistor 110 is isolated from the emitter when the controllable current source 1112 is off. A pull up device 1114 connects the emitter of the first transistor 1110 to a voltage that is greater than the bias voltage, for example ($V_b$ + 1V) to ensure the first transistor 1110 is cut off when the controllable current source 1112 is off.

Figure 11C is a third switch embodiment having multiple transistors configured to provide increased signal isolation. A signal is provided to a first transistor 1120. The output of the first transistor 1120 is connected to an input of a second transistor 1122. The output of the second transistor 1122 is the output of the switch. A third transistor 1124 is connected to the output of the first transistor 1120 and is configured to selectively couple the output of the first transistor 1120 and input of the second transistor 1122 to ground or signal return.

A differential control signal is used to control the third switch embodiment. An in-phase control signal controls the first transistor 1120 and second transistor 1122. An inverted control signal controls the third transistor 1124. Thus, when the first and second transistors 1120, 1122 are controlled to be conducting, the third transistor 1124 is controlled to be cut off. Conversely, when the first and second transistors 1120, 1122 are controlled to be cut off, the third transistor 1124 is controlled to be conducting.

Figure 11D is a fourth switch embodiment. The fourth switch embodiment is similar to the second switch embodiment with additional transistors configured to provide additional signal isolation.

A signal is input at the base of a first transistor 1130 configured as an emitter follower. Additionally, a bias voltage, $V_b$, which is typically a DC bias voltage, is applied to the base of the first transistor 1130. The emitter of the first transistor 1130 is selectively biased with a controllable current source 1132. The first transistor 1130 selectively couples a signal from its base to its emitter when the controllable current source 1132 conducts. Conversely, a signal at the base of the first transistor 1130 is isolated from the emitter when the controllable current source 1132 is off.

A second transistor 1134 is configured to selectively pull up the emitter of the first transistor 1130 to a voltage that is greater than the bias voltage, for example ($V_b$ + 1V), to ensure the first transistor 1130 is cut off when the controllable current source 1132 is off. Additionally, the second transistor 1134 can also shunt any signal leakage at the emitter node to AC ground via the bias point, thus improving signal isolation. A third transistor 1136 has an input connected to the emitter of the first transistor 1130 and an output that is the output of the switch. The third transistor 1136 is selectively controlled to couple the signal from the emitter of the first transistor 1130 to the switch output when the controllable current source 1132 is conducting. The third transistor 1136 is selectively controlled to isolate the signal from the emitter of the first transistor 1130 when the controllable current source is off.

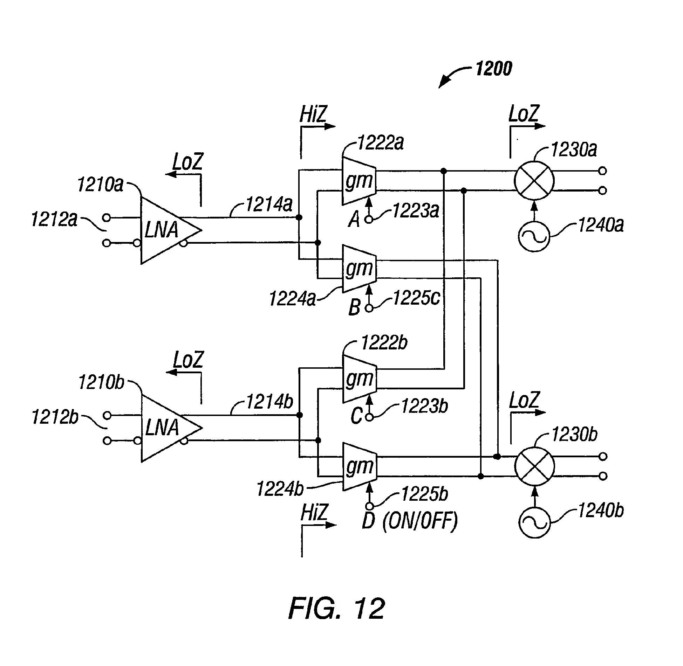

Figure 12 is a functional block diagram of a crosspoint switch with band translation 1200 that can also be integrated as a portion of the receiver 180 of Figure 1. A two input and two output version of the receiver 180 of Figure 1 can be implemented with the crosspoint switch with band translation 1200 of Figure 12 in combination with two LNB's.

The crosspoint switch with band translation 1200 is similar to the crosspoint switch with band translation 1000 of Figure 10 with the exception that the device of Figure 12 uses current mode switching while the device of Figure 10 uses voltage mode switching. Thus, the crosspoint switch with band translation 1200 can be used interchangeably with the device of Figure 10. However, in some instances, current mode switching can be advantageous because of the ability to sum currents into a common node.

The crosspoint switch with band translation 1200 has a first signal path and a second signal path. The first signal path includes a first LNA 1210a connected to a pair of transconductance devices, 1222a and 1224a that can selectively route a signal at the output 1214a of the LNA 1210a to a first band translation device 1230a or a second band translation device 1230b. The crosspoint switch with band translation 1200 uses the transconductance devices, for example 1222a and 1222b, to provide current-mode switching of the signals.

The first LNA 1210a is configured with a differential input 1212a and a differential output 1214a. The differential input 1212a of the first LNA 1210a can be matched to 75 ohm differential. The differential output 1214a of the first LNA 1210a is configured to have a low impedance. The crosspoint switch with band translation 1200 maximizes signal isolation and minimizes switching transients by connecting high isolation transconductance devices, 1222a and 1224a, to the output of the first LNA 1210a. Band translation devices 1230a, 1230b having low input impedances are connected to the outputs of the transconductance devices 1222a and 1224a.

The differential output 1214a of the first LNA 1210a is connected to the high impedance differential inputs of the transconductance devices 1222a and 1224a. The first LNA 1210a can drive both transconductance devices 1222a and 1224a because the differential inputs of the transconductance devices 1222a and 1224a are high impedance.

Each of the transconductance devices 1222a and 1224a includes a control input, 1223a and 1225a respectively, that is used to switch the transconductance device 1222a and 1224a on or off. When the signal from the first LNA 1210a is to be routed to the first band translation device 1230a, the first transconductance device 1222a is controlled to provide a current output to the input of the first and translation device 1230a. Similarly, the second transconductance device 1224a can be controlled to provide a current output to the input of the second band translation device 1230b. One or more transconductance devices, for example 1222a and 1224a connected to an LNA 1210a can simultaneously be enabled such that one input, for example a signal at 1212a, can be routed to all band translation devices 1230a and 1230b.

The first band translation device 1230a can selectively frequency translate the signal at its input to an output frequency band. The first band translation device 1230a uses a signal from a first LO 1240a to perform the frequency translation. The first band translation device 1230a has a low impedance input and thus, operates as a current summing node for the currents from the transconductance devices 1222a and 1222b to which its input is connected.

A second signal path is configured similar to the first signal path. A second LNA 1210b has a differential input 1212b and a differential output 1214b. The signal at the differential output 1214b of the second LNA 1210b is selectively connected to the first band translation device 1230a using a third transconductance device 1222b. The signal at the differential output 1214b of the second LNA 1210b is selectively connected to the second band translation device 1230b using a fourth transconductance device 1224b. The second band translation device 1230b operates in conjunction with a second LO 1240b.

The transconductance devices 1222a, 1222b, 1224a, and 1224b can be any type of transconductance devices, such as transistors, FETs, and the like. The transconductance devices 1222a, 1222b, 1224a, and 1224b have a high output impedance. Thus, multiple transconductance devices, for example 1222a and 1222b can selectively provide a signal to the same band translation device 1230a without the output impedance of the first transconductance device 1222a affecting the performance of the other transconductance device 1222b. The low input impedance band translation device 1230a operates as a current summing node.

In an alternative embodiment of the crosspoint switch with band translation 1200, the LNA's 1210a and 1210b are omitted and the input signals are directly coupled to the inputs of the transconductance devices 1222a, 1222b, 1224a, and 1224b. The inputs to the first and second signal paths can be matched to a predetermined impedance using a matching circuit (not shown) which can be as simple as a resistor placed across the differential inputs.

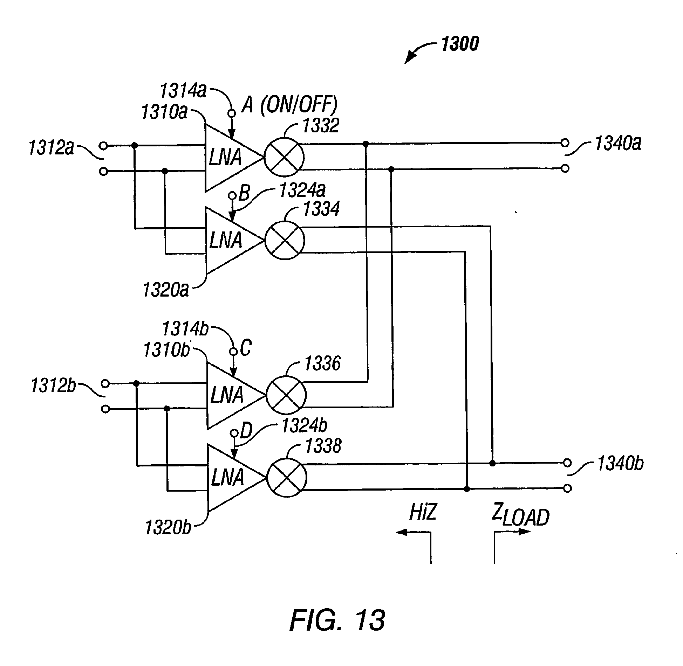

Figure 13 is a functional block diagram of a crosspoint switch with band translation 1300 having LNA/band translation device pairs for each input/output combination and summing the outputs of the band translation devices in the current domain. As with the crosspoint switch with band translation devices of Figures 10 and 12, the crosspoint switch with band translation 1300 can be combined with LNBs in the receiver 180 of Figure 1. The devices in the crosspoint switch with band translation 1300 utilize differential signals to minimize noise, but single-ended devices can be used in other embodiments.

Each LNA/band translation pair can selectively provide a signal to an output or be controlled to isolate the signal at the input from the output. The LNA can be selectively controlled to isolate the signal by removing the bias, or by reversing the bias on the amplifier. For example, the controller in the set top box 160a of Figure 1 can receive user input and control the bias control pins, labeled A, B, C, and D, to selectively enable or disable the bias to the LNAs 1310a-b, 1320a-b.

A first LNA/band translation device pair includes a first LNA 1310a connected to a first input 1312a. The first LNA 1310a is controlled to selectively amplify or isolate the input signal based on a signal provided to its control input 1314a. The output of the first LNA 1310a is connected to a first band translation device 1332 having a high output impedance. The output of the first band translation device 1332 is connected to a first signal output 1340a.

A second LNA/band translation device pair includes a second LNA 1320a having an input connected to the first input 1312a. The controller in the set top box can control the control input 1324a of the second LNA 1320a to selectively amplify or isolate the input signal. The output of the second LNA 1320a is connected to a second band translation device 1334 having a high output impedance. The output of the second band translation device 1334 is connected to a second signal output 1340b.

Thus, in order to selectively route a signal from the first input 1312a to the first signal output 1340a, the controller in the set top box selectively controls the first LNA 1310a to amplify the input signal by providing an enable signal to the control input, 1314a, on the first LNA 1310a. In order to isolate a signal at the first input 1312a from the first output 1340a, the first LNA 1310a is selectively controlled to isolate the signal.

A second differential input 1312b is connected to the inputs of a third LNA 1310b and a fourth LNA 1320b. The third LNA 1310b is controlled to selectively amplify or isolate the input signal based on a signal provided to its control input 1314b. The output of the third LNA 1310b is connected to a third band translation device 1336 having a high output impedance. The output of the third band translation device 1336 is connected to a first signal output 1340a.

Similarly, the fourth LNA 1320b is controlled to selectively amplify or isolate the input signal based on a signal provided to its control input 1324b. The output of the fourth LNA 1320b is connected to a fourth band translation device 1338 having a high output impedance. The output of the fourth band translation device 1338 is connected to a first signal output 1340b.

Thus, a signal provided to the second differential input 312b can selectively be routed to the first or second signal outputs, 1340a or 1340b or simultaneously to both signal outputs. In order to route the signal from the second input 1312b to the first signal output 1340a, a control signal is provided to the control input 1314b of the third LNA 1310b to enable the third LNA 1310b to amplify the second input signal. In order to route the signal from the second input 1312b to the second signal output 1340b, a control signal is provided to the control input 1324b of the fourth LNA 1320b to enable the fourth LNA 1320b to amplify the second input signal.

The outputs of the first and third band translation devices 1332, 1336 can be summed at the load if both signals are routed to the first signal output 1340a. Similarly, the outputs of the second and fourth band translation devices 1334 and 1338 can be summed at the load if both provide signals to the second signal output 1340b. Thus, by using current outputs from high impedance devices driving matched impedance loads, multiple signals can be summed in a common node.

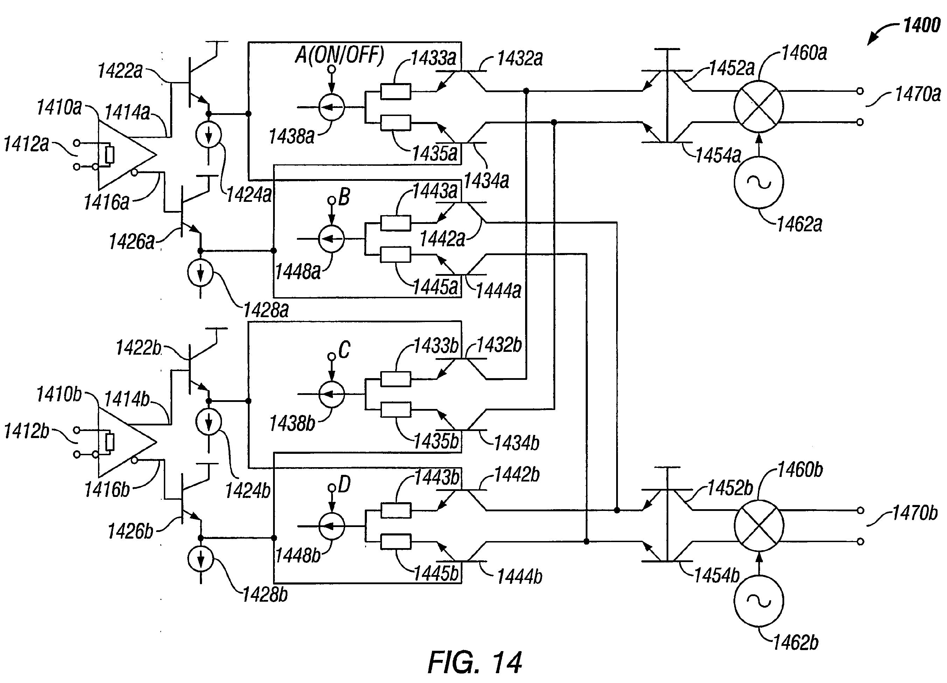

Figure 14 is another embodiment of a 2x2 crosspoint switch with band translation 1400. The specific embodiment is optimized for implementation within a single integrated circuit having impedance matched inputs and outputs. It is evident that the number of inputs or outputs can be expanded to any other number. The embodiment uses current mode switching. LNA's having a matched input, variable gain, and a low impedance output are used. Signals at a first input 1412a can be routed, using first and second transconductance devices, to one or both outputs 1470a and 1470b. Similarly, signals at a second input 1412b can be routed, using third and fourth transconductance devices, to one or both outputs 1470a and 1470b.

The 2X2 crosspoint switch with band translation 1400 receives the input signal at a matched signal input of the low noise amplifiers. The low noise amplifiers generate intermediate signals at their low impedance outputs. The intermediate signals are provided to high impedance inputs of current sources configured as transconductance devices. A controller can selectively control the transconductance devices to provide an output current based in part on the intermediate signal. Additionally, the controller can selectively enable or disable each of the transconductance devices. For example, the bias to each of the transconductance device may be controllable to selectively enable or disable the device. Alternatively, the bias current may be varied linearly to control the gain of the transconductance devices. Alternatively, the gain may be varied via other means and the transconductor may be enabled and disabled by other means.

The current output of the transconductance devices can then be received at low impedance inputs of band translation devices that can frequency translate the current signals from a first frequency band to a second frequency band. The band translation devices can have matched impedance outputs.

A first signal path is configured to amplify, band translate, and route a first signal to one of two outputs. A first LNA 1410a has a differential input 1412a configured to accept the first signal. The input 1412a of the first LNA 1410a can be a differential input that is matched to a predetermined impedance, such as 75 Ω or 50 Ω. The differential output of the first LNA 1410a has an in-phase output 1414a and an inverted output 1416a. The differential output of the first LNA 1410a can be a low output impedance, a matched output impedance, or a high output impedance. The output impedance of the first LNA 1410a can be, for example, 200 ohms differential.

The in-phase output 1414a of the first LNA 1410a is connected to a first emitter follower 1422a that has a low output impedance. The in-phase output 1414a of the first LNA is connected to the base of the first emitter follower 1422a. The emitter of the first emitter follower 1424a is connected to a current source 1424a that biases the first emitter follower 1424a. The output of the first emitter follower 1424a is connected to the in-phase inputs of the differential inputs to first and second transconductance devices. The transconductance devices have high input impedances. The transconductance devices can be bipolar devices that can be selectively enabled or disabled by controlling the bias currents.

Similarly, the inverted output 1416a of the first LNA is connected to the input of a second emitter follower 1426a. The second emitter follower 1426a is biased using a current source 1428a connected to its emitter. The output of the second emitter follower 1426a is connected to the inverted inputs of the first and second transconductance devices.

Alternatively, the first and second emitter followers, 1422a and 1426a, with their associated current sources, 1424a and 1428a, can be considered the low impedance output stage of the first LNA 1410a.

The first transconductance device includes a first transistor 1432a with the base of the first transistor 1432a serving as the in-phase input of the first transconductance device. A first resistor 1433a connects the emitter of the first transistor 1432a to a controllable current source 1438a. The base of a second transistor 1434a is used as the inverted input of the first transconductance device. A second resistor 1435a connects the emitter of the second transistor 1434a to the controllable current source 1438a.

The controllable current source 1438a provides the bias for the transistors, 1432a and 1434a of the first transconductance device. The controllable current source 1438a can be selectively enabled or disabled based on a control signal. The first transconductance device isolates a signal at its input from its output when the controllable current source 1438a is disabled, and conversely, provides a current output that can be proportional to the input signal when the controllable current source 1438a is enabled.

A first differential buffer amplifier having two transistors 1452a and 1454a is used to sum the currents from multiple transconductance devices and provide a differential signal to the first band translation device 1460a.

The first band translation device 1460a is configured with a low input impedance and an output impedance matched to a predetermined impedance. For example, the output of the first band translation device 1460a can be matched to 75 Ω. The differential output of the first band translation device 1460a is connected to the first signal output 1470a. The first band translation device 1460a is driven with a first LO 1462a. The first LO 1462a frequency can be tunable to allow the frequency translation of the first band translation device 1462a to be tuned. Alternatively the output frequency of the first LO 1462a can be fixed. The first band translation device 1462a can be configured to frequency translate the signal or to pass the signal without frequency translation.

The first LNA 1410a also provides a signal that can be selectively routed to a second output 1470b. The differential outputs from the first and second emitter followers, 1422a and 1426a are connected to the differential inputs of a second transconductance device.

The base of a first transistor 1442a in the second transconductance device is connected to the in-phase output from the first emitter follower 1422a. The base of a second transistor 1444a in the second transconductance device is connected to the inverted output from the second emitter follower 1426a. Resistors 1443a and 1445a connect the emitters of the first and second transistors 1442a and 1444a to a controllable current source 1448a that selectively provides bias to the first and second transistors 1442a and 1444a. The second transconductance device provides an output current when the controllable current source 1448a is enabled. Conversely, the second transconductance device does not provide an output current when the controllable current source 1448a is disabled.

The differential output from the second transconductance device is connected to the differential input of a second differential buffer amplifier. The second differential buffer amplifier includes two transistors 1452b and 1454b and is used to sum the currents from multiple transconductance devices and provide a differential signal to the second band translation device 1460b.

The output of the second differential buffer amplifier is connected to the differential input of a second band translation device 1460b. The second band translation device 1460b has with a low input impedance and an output impedance matched to a predetermined impedance such as 75 $\Omega$. The differential output of the second band translation device 1460b is connected to the second signal output 1470b. The second band translation device 1460b is driven with a second LO 1462b. The second LO 1462b frequency can be tunable to allow the frequency translation of the second band translation device 1462b to be tuned. Alternatively the output frequency of the second LO 1462b can be fixed. The second band translation device 1462b can be configured to frequency translate the signal or to pass the signal without frequency translation.

The second signal input 1412b is connected to the second LNA 1410b and through third and fourth transconductance devices to the first and second differential buffer amplifiers in a configuration that is similar to the path from the first signal input 1412a to the differential buffer amplifiers.

The second signal input 1412b is connected to the input of the second LNA 1410b. The differential output of the second LNA is connected to a pair of emitter followers, one emitter follower for each of the signal outputs of the second LNA 1410b.

The in-phase LNA output 1414b is connected to a first emitter follower 1422b that includes a first current source 1424b connected to its emitter to provide a bias. The inverted LNA output 1416b is connected to a second emitter follower 1426b that includes a second current source 1428b connected to its emitter to provide a bias.

The output of the first emitter follower 1422b is connected to the in-phase inputs of third and fourth transconductance devices. The output of the second emitter follower 1426b is connected to the inverted inputs of the third and fourth transconductance devices.

The third transconductance device includes first and second transistors 1432b and 1434b arranged in a differential configuration. The base of the first transistor 1432b is the in-phase input of the transconductance device and the base of the second transistor 1434b is the inverted input of the third transconductance device. The emitters of the first and second transistors, 1432b and 1434b, are connected via first and second resistors, 1433b and 1435b, to a controllable current source 1438b. The controllable current source selectively enables or disables the third transconductance device. The collectors of the first and second transistors, 1432b and 1434b, are connected to the differential inputs of the first differential buffer amplifier.

Similarly, the fourth transconductance device includes first and second transistors 1442b and 1444b arranged in a differential configuration. The base of the first transistor 1442b is the in-phase input of the transconductance device and the base of the second transistor 1444b is the inverted input of the fourth transconductance device. The emitters of the first and second transistors, 1442b and 1444b, are connected via first and second resistors, 1443b and 1445b, to a controllable current source 1448b. The controllable current source 1448b selectively enables or disables the fourth transconductance device. The collectors of the first and second transistors, 1442b and 1444b, are connected to the differential inputs of the second differential buffer amplifier. Of course, the transconductance devcies shown in Figure 6 only represent embodiments of typical transconductance devices. Other embodiments of transconductance devices may be used in other embodiments.

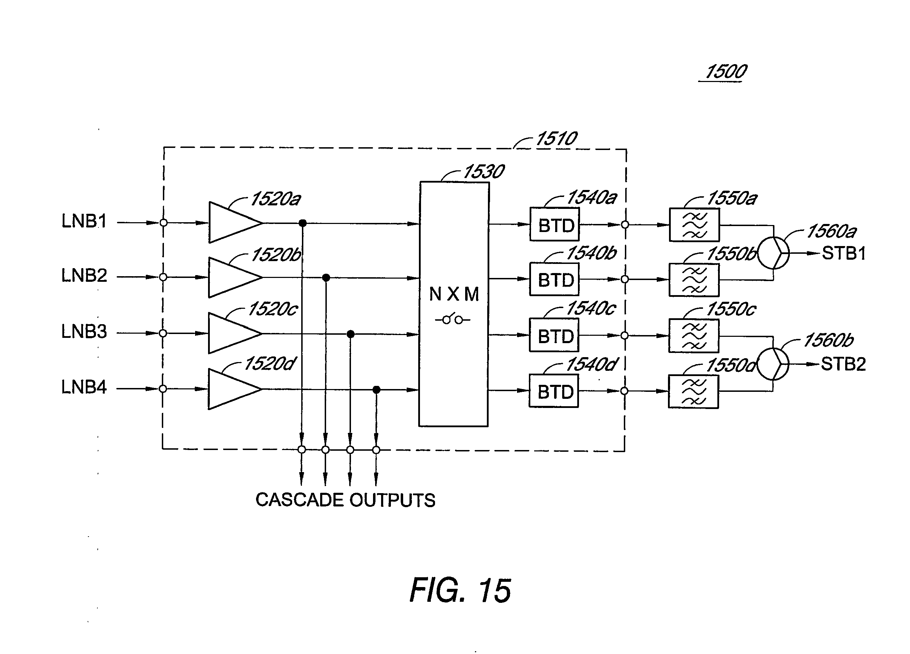

Thus, a designer can choose between many buffer amplifier embodiments, crosspoint switch embodiments, and band translation device embodiments in designing a band translation switch. Figure 15 is a functional block diagram of a specific embodiment of signal distribution system 1500 including an integrated crosspoint switch with band translation (band translation switch) 1510 and external components. The band translation switch 1510 includes four inputs for LNB's, a cascadable output corresponding to each of the inputs, and two outputs configured to interface with set top boxes. The band translation switch 1510 is configured to interface with LNB's signals having a dual band-stacked frequency plan. The dual band-stacked frequency plan includes an upper band block and a lower band block. The band translation switch outputs maintain the dual band-stacked frequency plan, but allow the upper or lower band block from any of the LNB signals to be configured as an output upper band block. Similarly, the upper or low band block from any of the LNB signals can be configured as an output lower band block. A more detailed description of the band translation switch 1510 is provided below.

The band translation switch 1510 includes four inputs configured to interface with up to four LNB's. Each LNB provides a signal conforming to a dual band-stacking frequency plan having an upper band block and a lower band block. For example, the LNB signals can be satellite downlink signals from selected transponder groups. The lower band block can be 950-1450 MHz and the upper band block can be 1650-2150 MHz.

Each of the signal inputs is connected to the input of an amplifier 1520a-1520d. The amplifiers 1520a-1520d are configured as Low Noise Amplifiers (LNA's) that both buffer and amplify the input signals from the LNB's. The output from each of the amplifiers 1520a-1520d is connected to a corresponding input on a crosspoint switch 1530. Additionally, the output from each of the amplifiers 1520a-1520d is connected to a corresponding cascade output of the band translation switch 1510.

The crosspoint switch 1530 is configured as a 4X4 switch. Any of the four amplified LNB input signals can be selectively routed to any of the four outputs of the crosspoint switch 1530 independently and simultaneously. For example, the crosspoint switch 1530 can include a two-bit control for each output. The value of the two-bit control can be programmed to selectively route the signal from one of the four inputs. The band translation switch 1510 can, for example, receive the two bit control words from a set top box. Alternatively, the set top box may send one or more control messages to a microprocessor implemented local to the crosspoint switch and the microprocessor can generate the one or more two bit control words. In the embodiment shown in Figure 15, each of the four outputs from the crosspoint switch 1530 is connected to a band translation device 1540a-1540d. One or more outputs from the crosspoint switch 1530 can be coupled to the same band translation device, for example 1540a.

The band translation devices 1540a-1540d are configured to selectively frequency translate the signals or to pass the signals without frequency translation. Each of the band translation devices 1540a-1540d can select frequency translation or pass through independently of the other devices. Because a dual band-stacked frequency plan is used in this embodiment, the band translation devices 1540a-1540d are configured to swap the positions of the upper and lower band blocks when frequency translation is selected.

Each of the band translation devices 1540a-1540d includes a mixer. The band translation switch 1510 also includes one or more local oscillators (LO). In one embodiment with a dual band-stacked frequency plan, a single LO can be routed to all of the band translation devices 1540a-1540d. In another embodiment, the local oscillator frequency can be fixed when a dual band-stacked frequency plan is implemented. An LO frequency of 3.1 GHz, or 2x (the band center mean), can be used to perform the frequency translation.

In another embodiment, a plurality of variable frequency LOs can be used with the band translation devices 1540a-1540d. For example, each of the band translation devices 1540a-1540d can have a separate independently controlled LO output frequencies. Thus, each of the band translation devices 1540a-1540d can frequency translate its input signal independently of the frequency translation performed by any other band translation device.

LO buffer amplifiers (not shown) distribute the signal from the LO output to each of the band translation devices 1540a-1540d. The output of the band translation devices 1540a-1540d are connected to the outputs of the band translation switch 1510.

Each of the outputs of the band translation switch 1510 is a dual band-stacked signal. Each of the outputs of the band translation switch 1510 is connected to a filter 1550a-1550d. The filters 1550a-1550d are configured to pass signals in one of the predetermined frequency bands in the dual band-stacked frequency plan. The filters 1550a-1550d reject signals outside of the passband, including the signals at the undesired frequency band. The filters 1550a-1550d can be configured with tunable passbands or can be configured to have fixed passbands.

In the present embodiment, the filters 1550a-1550d are configured as bandpass filters with fixed passbands. The first filter 1550a is configured as a bandpass filter that passes the upper band block of the frequency plan. A second filter 1550b is configured as a bandpass filter that passes the lower band block. Similarly, a third filter 1550c is configured to pass the upper band block and a fourth filter 1550d is configured to pass the lower band block. The outputs of the first and second filters 1550a-1550b are connected to respective first and second inputs of a first signal combiner 1560a. Similarly, the outputs of the third and fourth filters 1550c-1550d are connected to first and second inputs of a second signal combiner 1560b. The filters 1550a-1550d are not limited to bandpass filters, but can be, for example, bandpass filters (BPF), lowpass filters (LPF) or highpass filters (HPF). In other embodiments, other frequency selective devices can be used to limit the frequency response of the outputs. The filters 1550a-1550d can have passbands that are narrower than the frequency bandwidth of the input signals. For example, an input to a filter, for example 1550a, can include multiple carriers. However, the filter 1550a can be configured to pass a subset of all of the carriers.

The signal combiners 1560a-1560b are configured to sum the signals provided at their inputs and to provide the summed signal at an output. The outputs from the signal combiners 1560a-1560b are the band translated outputs of the signal distribution system 1500. Each of the outputs is connected to a set top box for further processing and for distribution to an end user device.

As discussed above, one or more frequency selective devices can be used as the filters 1550a-1550d. For example, a diplexer can be used to filter and to band-staclc signals. The diplexer can be used as the filters, for example 1550a and 1550b, and signal combiner 1560a.

Of course, the band translation switch 1510 is not limited to operating with band stacked input signals. For example, each of the LNB's can provide signals in the same frequency band. The band translation switch 1510 can be configured to frequency translate and combine portions of the single band input signals. The crosspoint switch 1530 can, for example, route the output of the first amplifier 1520a to a first band translation device 1540a. An LO in the first band translation device 1540a can be configured to frequency translate the signal such that one or more channels from the input signal are translated to desired output frequencies. The first filter 1550a can be configured to pass only those desired channels and reject all undesired frequencies and channels.

Similarly, the crosspoint switch 1530 can be configured to route the output of the second amplifier 1520b to a second band translation device 1540b. The second band translation device 1540b can be configured to frequency translate a portion of the input signal to desired output frequencies. The second filter 1550b can be configured to pass only those desired channels and reject all undesired frequencies and channels.

The first and second band translation devices 1540a-1540b in conjunction with the first and second filters 1550a-1550b can be configured to produce selected channels in mutually exclusive frequency bands. The combiner 1560a can then sum the filtered outputs to produce a composite output signal from independent single band input signals, where each filter includes one or more channels. In one embodiment of the single band input signal configuration, each band translation device and filter pair, for example 1540a and 1550a, is configured to frequency translate one or more channels from each of one or more input signal bands. The frequency translated signals can be combined into a single band signal or a multiple band signal.

Similarly, some embodiments can have multiple band translation devices and multiple filters. Each of the multiple band translation devices can frequency translate one or more channels from one or more input bands. The outputs of the multiple filters can be summed to provide a single composite signal having a desired channel line up.

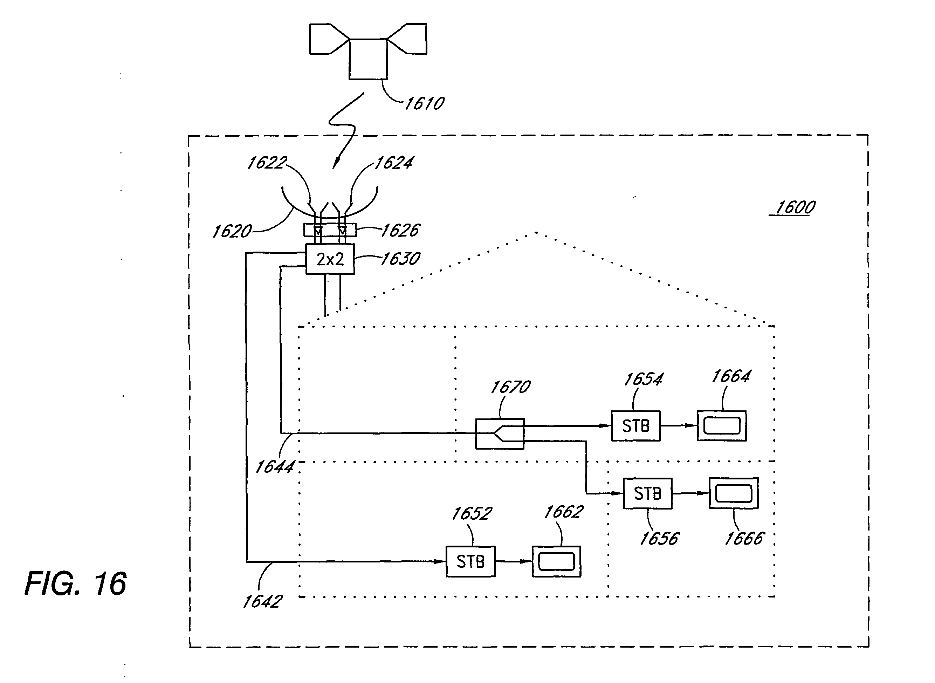

Figure 16 is a functional block diagram of a signal distribution system 1600 that is typical of a satellite television system that can be implemented at a residence or other building. The signal distribution system 1600 includes an antenna 1620 having antenna feeds 1622, 1624 coupled to two inputs of a low noise block 1626. The outputs of the low noise block 1626 are coupled to two inputs of a distribution switch 1630. The distribution switch outputs are connected to first, second, and third set top boxes 1652, 1654, 1656, using first and second transmission lines 1642, 1644. The output of the first set top box 1652 is connected to a first output device 1662. A signal splitter 1670 splits into two signals the signal coupled from the distribution switch 1630 by the second transmission line 1644. A first signal splitter 1670 output is coupled to the second set top box 1654 and the second signal splitter 1670 output is coupled to the third set top box 1656. The output of the second set top box 1654 is connected to a second output device 1664 and the output of the third set top box 1656 is connected to a third output device 1666.

The antenna 1620 includes two antenna feeds 1622, 1624. However, multiple antennae can be used. Additionally, each antenna 1620 can have one or more antenna feeds 1622, 1624, and each antenna 1620 is not limited to having only two feeds 1622, 1624. Alternatively, the antenna 1620 can be a configuration that does not utilize an antenna feed, such as a whip or horn.

The antenna 1620 receives one or more signals from a satellite 1610. Additionally, the satellite 1610 can provide a signal of a particular polarization and modulation type. Again, there may be more than one satellite 1610 providing signals to the antenna 1620. The signals from a particular satellite 1610 can be in the same frequency band as signals from another satellite (not shown) or can be in distinct frequency bands. The signals from multiple satellites can each have the same polarity and modulation type or can be different from each other.

In the signal distribution system 1600 of Figure 16, each of the antenna feeds 1622, 1624 is connected to an independent input of a low noise block 1626 that outputs signals to the distribution switch 1630. Of course, the distribution switch 1630 is not limited to a 2x2 switch but can have any number of input ports and output ports, for example, the distribution switch 1630 can be, for example, a 2x4 switch, a 4x4 switch, or some other switch arrangement.

The distribution switch 1630 is configured to process the received satellite signals. The distribution switch 1630 can, for example, amplify, filter, and frequency downconvert the received satellite signals. The distribution switch 1630 can be configured as a pair of low noise block converters (LNB's) that each block convert the signals from one of the distribution switch 1630 inputs to an intermediate frequency. The distribution switch 1630 can also be configured to allow each of the input signals provided to the inputs to be connected to any one of multiple switch outputs. Thus, the signal provided from the first antenna feed 1622 can be block converted in the distribution switch 1630 and routed to any of the switch outputs. Similarly, the signal provided from the second antenna feed 1624 can be block converted in the distribution switch 1630 and routed to any of the switch outputs. Typically, the distribution switch 1630 is configured such that the signals from only one signal source are routed to a particular switch output. Alternatively, one or more of the block converted signals can be routed to the same distribution switch 1630 output.

The outputs of the distribution switch 1630 can be connected to remote locations using cabling when the antenna 1620 and distribution switch 1630 are installed in a geographically remote location from the desired signal destinations. The outputs of the distribution switch 1630 are typically routed to remote destinations with transmission lines, which can be coaxial cables. The distribution switch 1630 can be positioned local to the low noise block 1626 and antenna feeds 1622 and 1624, or may be positioned remote from the low noise block 1626 and antenna feeds 1622 and 1624.

In one embodiment, the distribution switch 1630 is co-located with the antenna 1620, low noise block 1626, and antenna feeds 1622 and 1624. In another embodiment, the distribution switch 1630 can be located remote from the antenna 1620. For example, cables or transmission lines can couple the signals from the low noise block 1626 to a distribution switch 1630 positioned inside a structure near one or more set top boxes 1652 and 1654. Similarly, in other embodiments, the distribution switch 1630 can be positioned in an intermediate location between the antenna 1620 and the set top boxes 1652 and 1654. In some embodiments, the low noise block 1626 is omitted and signals from the antenna feeds 1622 and 1624 can be coupled to the distribution switch 1630 using cables. Similarly, output signals from the distribution switch 1630 can be coupled to set top boxes or other destination devices using cables or some other distribution system.

In a first embodiment, the distribution switch is positioned local to the low noise block 1626 and antenna 1620. A first transmission line 1642 distributes the signal from the first output port of the distribution switch 1630 to a remote location within the signal distribution system 1600. The end of the first transmission line 1642 is connected to a first set top box 1652 located remote from the distribution switch 1630.

A second transmission line 1644 distributes the signal from the second output port of the distribution switch 1630 to a signal splitter 1670. A first output of the signal splitter 1670 is coupled to the second set top box 1654. The second set top box 1654 can be located at a location remote from the distribution switch 1630 and signal splitter 1670 and can also be at a location remote from the first set top box 1652. A second output of the signal splitter 1670 is coupled to a third set top box 1656. The output of the third set top box 1656 is coupled to a third output device 1666.

The first and second transmission lines, 1642 and 1644, can be parallel lines, twisted pairs, coaxial line, waveguide, and the like, or any other means for distributing the signal. Additionally, although transmission lines are typically used to minimize signal loss and signal reflections, the system can use other means for distributing the signal that are not transmission lines. For example, wires, wire bundles, and the like, can be used for distributing the signals from the distribution switch 1630 to the set top boxes 1652, 1654. However, for signals that can be considered Radio Frequency (RF) signals, the signals are typically distributed using transmission lines. The RF information signals can, for example, be in the range of KHz up to several GHz. Of course, the signal distribution system 1600 is not limited to distributing RF signals, but can distribute other signals, such as baseband signals or optical signals.

The transmission lines 1642, 1644, are typically non-ideal passive devices. Thus, the transmission lines attenuate the signal power. However, the attenuation contributed by the transmission lines 1642, 1644 typically do not attenuate the noise power to the same degree as the signal power. For example, a passive attenuator, such as a length of transmission line may not significantly degrade the thermal noise. Additionally, the transmission lines 1642, 1644 can contribute other types of cable related signal degradation. For example, the transmission lines can affect flatness, tilt, phase distortion, group delay distortion, reflection, interference, noise pick-up and microphonic noise of the distributed signals. Thus, the losses contributed by the transmission lines 1642, 1644 typically degrade the SNR of the signal distributed to the set top boxes 1652, 1654.

The first and second transmission lines 1642 and 1644 are coupled to corresponding inputs of set top boxes 1652, 1654, and 1656. The second transmission line 1644 couples to the second and third set top boxes, 1654 and 1656, via the signal splitter 1670. In one embodiment, the frequency bands for the signals output from the distribution switch 1630 do not correspond to frequency bands used by the output devices 1662 and 1664. Thus, the set top boxes 1652, 1654 can further frequency translate the signals to operating bands compatible with the output devices 1662, 1664, and 1666. Additionally, the output signals from the distribution switch 1630 can be in a format that is not compatible with the format used by the output devices 1662, 1664, and 1666. The set top boxes 1652, 1654, and 1656 can then function as signal processing stages. For example, the satellite downlink signals can be digitally modulated in a format that is not compatible with the output devices 1662, 1664, and 1666 which can be typical television receivers. The set top boxes 1652, 1654, and 1656 can be configured to demodulate the digitally modulated signals, process the demodulated signals, and then modulate television channel carrier frequencies with the signals for delivery to the television output devices 1662, 1664, and 1666.

Alternatively, if the signals output from the distribution switch 1630 are in a format and are at a frequency band that is compatible with the output devices 1662, 1664, and 1666 the set top boxes 1652, 1654, and 1656 may not be required. In still another alternative, one or more of the functions performed by the set top boxes 1652, 1654, and 1656 can be integrated into the output devices 1662, 1664, 1666. In still another embodiment, the signal splitter 1670 can be configured to perform signal processing, such as frequency conversion or demodulation.

In the embodiment described in Figure 16, each of the set top boxes 1652, 1654, and 1656 is connected to a single output device 1662, 1664, and 1666. However, more than one output device e.g. 1662, 1664 can be connected to the output from a single set top box, for example 1652. Alternatively, outputs from more than one set top box 1652, 1654, and 1656 can be combined or otherwise connected to a single output device, for example 1662, although such a configuration is not typical.

An output device, for example 1662, can be configured to tune to a particular channel within the one or more frequency bands provided by the set top box, such as 1652. The output device 1662 can process the signal from the selected channel to present some media content, such as video or audio, to a user.

For example, the output devices, 1662, 1664, and 1666 can be television receivers and can display a television signal corresponding to a signal transmitted by the satellite 1610. The output devices 1662, 1664, and 1666 can be other types of devices in other signal distribution systems. For example the output devices 1662, 1664, and 1666 can be telephones, radio receivers, computers, networked devices, and the like, or other means for outputting a signal.

The output devices 1662, 1664, and 1666 can have a range of signal quality over which the output is considered acceptable. For example, the output devices 1662, 1664, and 1666 can provide acceptable outputs for input SNR above a predetermined level, which may represent a desired minimum SNR. However, the SNR at the input to the output devices, 1662, 1664, and 1666 is typically determined by the signal processing performed in the set top boxes 1652, 1654 and 1656. Thus, the signal quality is typically related to the signal quality at the input of the set top boxes 1652, 1654, and 1656. Thus, the signal distribution system 1600 is typically configured to provide a signal at the input to the set top boxes 1652, 1654, and 1656 having a SNR greater than the desired minimum.

Although Figure 16 is a functional block diagram of a satellite signal distribution system, other signal distribution systems have similar structures. For example, cable distribution systems, which may distribute television, radio, data, and/or telephony signals, typically provide a single access point to a geographic area, such as a residence. The signal from the one access point is then typically split, amplified, distributed, and can be combined with other signals, such as, for example the satellite television signals. Communication systems having wireless communication links can also have similar structures. For example, a terrestrial television or radio system can include a single antenna and distribute the signals received at the single antenna to multiple output devices using a signal distribution system 100 that can amplify, split, distribute, and/or combine the received signals.

The signal distribution system is not limited to a residence, but can span many residences, businesses, or locations not associated with dwellings or buildings. The signal distribution system is characterized by its features and is not limited to any particular application.

Additionally, although Figure 16 shows only the signal splitter 1670 interposed between the distribution switch 1630 and set top boxes 1654 and 1656, elements other than the transmission lines 1642, 1644, and signal splitter 1670 can be interposed between the distribution switch 1630 and the set top boxes 1652, 1654, and 1656. The additional distribution devices can include active or passive power dividers, active or passive power combiners, amplifiers, attenuators, filters, switches, crosspoint switches, multiplexers, de-multiplexers, frequency translation devices, encoders, decoders, and the like or any other means for distributing a signal. Each of these additional signal distribution devices can contribute to the noise experienced by the distributed signal.

For example, a two-way passive power divider allows a signal at one input to be split equally into two output signals, each having half the original signal power, while maintaining an impedance match at all ports. An ideal two-way passive divider reduces the SNR by 3 dB. However, in practice, the degradation is often higher.

Active signal distribution devices can contribute to signal degradation, for example by generating distortion products that degrade SNR. The distortion contributed by an active device typically increases as the input signal power to the device increases. Additionally, the location of an active device within the signal distribution system 1600 can affect the impact that the device has on SNR. An active device located at an input to the signal distribution system can experience a larger signal power, and thus degrade the SNR more than an identical device located at a the end of a transmission line, e.g. 1642, where the signal power can be significantly attenuated.

Because the distortion typically increases at a rate greater than the rate of increase in signal power, the SNR degrades for input signals that are large in relation to the device capabilities. A large input signal can be defined as a signal that generates a predetermined level of distortion in an active device. For example, a signal can be large when measured in relation to the input signal level required to generate a 1 dB amplifier output compression. Alternatively, a signal can be large when measured in relation to an input signal level required to generate a particular third order product. That is, a signal can be defined to be large if a two-tone intermodulation test produces a third order intermodulation distortion product that is a predetermined level below the output signal, for example 40 dB. The definition of a large signal is relative to the signal distribution system in which a device is used and the previous definitions are not exhaustive.

Conversely, when the signal is small, the uncorrelated noise level may dominate the determination of SNR. Because an attenuator typically degrades signal power and may not degrade the uncorrelated noise power by an equivalent amount, the SNR following the attenuator can degrade. The placement of a passive device can also affect the amount of SNR degradation contributed by the device. Attenuators placed where the signal is large may not affect the SNR while identical attenuators placed where the signal is small may significantly degrade the SNR.

Thus, there exists an optimum signal range that maximizes SNR in the system. The optimum depends on the precise signal distribution system and the nature of the information signal distributed. The Automatic Gain Control (AGC) amplifier that is detailed below can help the system maintain the optimal operating range and thus help to maintain an optimum SNR in the system. The AGC amplifier can diminish the effects that subsequent distribution devices have on the SNR at the set top boxes 1652, 1654, and 1656. Additionally, the AGC amplifier can minimize adverse effects of adding or removing distribution paths in the signal distribution system 1600. The AGC amplifier can, for example, be integrated into the distribution switch 1630 or signal splitter 1670.

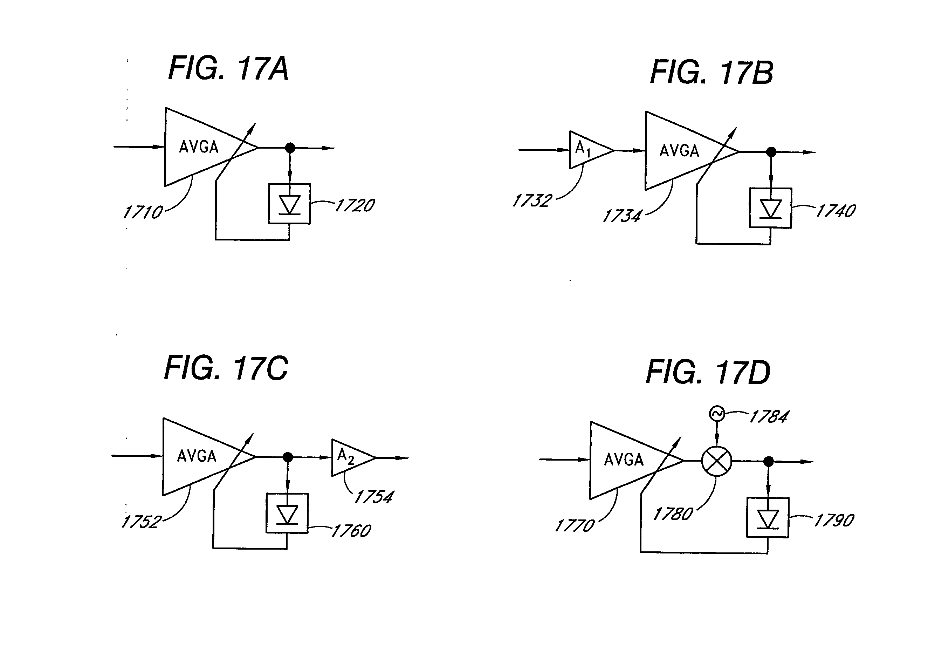

Figures 17A through 17D are functional block diagrams of AGC amplifiers that can be, for example, integrated into the distribution switch 1630 and/or signal splitter 1670 of Figure 16. The AGC amplifier can also be implemented in an intermediate signal processing device, such as the signal splitter 1670 or some other signal distribution device, alternatively referred to as a distribution device or signal processing device. Typically, the AGC amplifiers are not added as stand alone devices, but are implemented in conjunction with other distribution devices.

In some embodiments, intermediate signal distribution devices may not include AGC amplifiers. Such intermediate signal processing devices lacking an AGC amplifier may be configured for use in particular locations within the signal distribution system. In other embodiments, the intermediate signal distribution devices can, for example, include an AGC amplifier as the initial signal processing element.

Implementing an AGC amplifier with a signal distribution device allows the performance of the signal distribution system 1600 to be substantially unaffected by the physical location of the signal distribution device. That is, the performance of the signal distribution system 1600 is substantially indifferent to the placement of a signal distribution device at the front end of a cable run or at the back end of the cable run.

Implementing the AGC amplifier in the distribution device 1630 immediately following the low noise block 1626 can compensate for gain variations in the low noise block 1626. Thus, embodiments implementing the distribution device 1630 and low noise block 1626 locally or in a single housing may advantageously eliminate a production adjustment of the low noise block 1626 gain. Thus, the AGC function implemented in the distribution block 1630 can provide a lowered production cost by eliminating a production tuning step.

Each of the AGC amplifier embodiments shown in Figures 17A through 17D can be implemented with a signal distribution device as an integrated circuit, as discrete devices, or as a combination of integrated circuits and discrete devices. An integrated circuit can, for example, incorporate multiple independent AGC amplifiers in parallel, with each AGC amplifier controlling the power of a signal received from a satellite downlink. The integrated circuit can be manufactured on a variety of substrate materials such as silicon, germanium, gallium arsenide, indium phosphide, sapphire, diamond, and the like, or any other suitable substrate material. Additionally, the AGC amplifier embodiments can be manufactured using a variety of manufacturing techniques including bipolar, FET, BiCMOS, CMOS, SiGe, and the like.

Figure 17A is a functional block diagram of a first AGC amplifier embodiment. The AGC amplifier includes a variable gain amplifier (VGA) 1710 and a detector 1720 connected to the output of the VGA 1710. An output of the detector 1720 is connected to a gain control input of the VGA 1710 to control the gain of the amplifier.

The AGC amplifier implements an output referred AGC function to attempt to maintain the output power of the power amplifier at a predetermined optimal level, also referred to as the AGC set point. The AGC function is a process that attempts to maintain a signal power at the AGC setpoint. The AGC function increases the gain of the amplifier 1710 when the output signal is below the AGC set point. The AGC function can continue to increase the gain of the VGA 210 as required, up to a maximum gain value. The VGA 210 continues to provide the maximum gain value as long as the output signal power remains below the AGC set point.

Conversely, the AGC function decreases the gain of the VGA 1710 when the output signal power is above the AGC set point. The AGC function can continue to decrease the gain of the VGA 1710 as required, down to a minimum value. The AGC function continues to provide the minimum gain value as long as the output signal power remains greater than the AGC set point.

Within a system such as the signal distribution system 1600 of Figure 16, there is typically a limit of input signal range. That is, the input to the signal distribution system 1600 typically falls within a predetermined range. In such a system, it is possible to configure the AGC range such that one or more of the AGC limits is not ever reached. For example, the input signal from the satellite 1610 may vary over a predetermined range. If the AGC amplifier in the distribution switch 1630 or signal splitter 1670 has an AGC range that is greater than the input signal range, the AGC function may never reach its limits.

Initially, an input signal having an input signal power, Pin, is provided to the input 1715 of the VGA 1710. The control signal provided to the VGA 1710 can initially be set to control the VGA 1710 to provide the maximum available gain, Gmax. The VGA 1710 then provides an output signal having an output power, Pout, substantially equal to Pin + Gmax, for example, measured in terms of decibels relative to a milliwatt (dBm).

The output from the VGA 1710 is connected to an input of a power detector 1720. The power detector 1720 measures the output signal power and generates a control signal that can correlate with the output signal power. For example, the power detector 1720 can be configured to provide an output voltage that correlates with a given power level. Alternatively, the power detector 1720 can be configured to provide an output current that correlates with a given power level.

The power detector 1720 can be configured to measure the power of the composite amplifier output signal, including desired signals, noise, and distortion. Such a power detector 1720 can be a broadband detector and can detect a power level over a broad frequency band. Alternatively, the power detector 1720 can measure the power of only a portion of the output power from the VGA 1710. For example, the power detector 1720 can measure the power in a predetermined bandwidth, where the predetermined bandwidth represents only a portion of the bandwidth of the signal output from the VGA 1710. The predetermined bandwidth can, for example, be entirely within a desired signal bandwidth of the output from the VGA 1710. Alternatively, the predetermined bandwidth can partially overlap or be exclusive of a desired signal bandwidth of the VGA 1710 output.

The output of the power detector 1720 is connected to a control input of the VGA 1710. The AGC amplifier can be configured to provide an output referred AGC function. For example, the power detector 1720 can detect an output power of the VGA 1710. The power detector 1710 can also include a comparator having an AGC setpoint coupled to one comparator input. The detected output power can be provided to the second input of the comparator and compared to a AGC setpoint. The output of the comparator can be filtered, for example using an integrator. The output of the integrator can be the detector output control signal that controls the gain of the amplifier.

For example, a high power signal, one that is greater than the AGC set point, at the input to the power detector 1720 produces a control voltage. The control voltage value corresponds with an amplifier gain value that is smaller than the original gain value. The high power detector 1720 output reduces the gain of the VGA 1710 such that the power detected at the output of the VGA 1710 is substantially equal to the AGC set point.

Although the VGA 1710 is shown as an amplifier, the AGC function can be implemented with gain only, a combination of gain and attenuation, or attenuation only. Additionally, the VGA 1710 can be implemented with multiple stages and multiple devices. For example, the VGA 1710 can be configured as multiple cascaded variable gain amplifiers, or as amplifiers cascaded with variable attenuators, or as multiple variable gain amplifiers in parallel, and the like.

Additionally, the power detector 1720 can be a diode detector, a crystal detector, and the like. The power detector 1720 can be configured to sample mean power, peak power, RMS voltage, mean voltage, peak voltage, mean current, RMS current, peak current, or some other value correlated to signal level. The power detector can be a single device or can be constructed of multiple devices. As discussed above, the power detector 1720 can include, for example, a detector, a comparator, and integrator, or some other signal conditioning block.

Although the power detector 1720 is shown to provide an output referred AGC function, the power detector 1720 can be configured detect the signal power at other locations, such as at the input of the VGA 1710. The power detector 1720 can be configured to detect the signal power at some other location that is remote from the VGA 1710, such as at the input to a set top box of Figure 16.

The actual AGC function can be implemented using a variety of techniques, including feedback and feed-forward. Regardless of whether the AGC function is configured as output referred using feedback, or output referred using feed-forward techniques, the AGC function can operate to provide a substantially stable output level over an predetermined AGC range.

Figure 17B is a functional block diagram of an embodiment of an AGC amplifier. The AGC amplifier includes a constant gain amplifier 1732 at the input to the AGC amplifier. The output of the constant gain amplifier 1732 is connected to the input of a VGA 1734. The output of the VGA 1734 is connected to a power detector 1740. The output signal from the power detector 1740 is connected to the control input of the VGA 1734 to control the gain of the VGA 1734.

The AGC amplifier embodiment in Figure 17B is similar to the embodiment of Figure 17A except that a constant gain amplifier 1732 is implemented before the VGA 1734. The AGC amplifier of Figure 17B operates effectively the same as the AGC amplifier of Figure 17A. The gain of the constant gain amplifier 1732 can set a lower limit on the gain of the AGC amplifier. However, the gain of the constant gain amplifier 1732 can be negated by attenuation in the VGA 1734 if the VGA is configured to provide attenuation. The constant gain amplifier 1732 can be included in an AGC amplifier, for example, in order to provide a front end amplifier in the AGC amplifier having a low noise figure.

Figure 17C is a functional block diagram of another AGC amplifier embodiment. The AGC amplifier includes a VGA 1752 at the input of the AGC amplifier. The output of the VGA 1752 is connected to a constant gain amplifier 1754. The output of the constant gain amplifier 1754 is the output of the AGC amplifier. The output of the VGA 1752 is also connected to the input of the power detector 1760. The detected output is provided to the control input of the VGA 1752. Thus, in the embodiment of Figure 17C, the power detector 1760 detects the power of an intermediate stage, rather than the input or output of the AGC amplifier. Of course, the embodiment of Figure 17A can be modified to correspond to the embodiment of Figure 17C by cascading the AGC amplifier with a constant gain amplifier. Although a constant gain amplifier 1754 is implemented after the VGA 1752, the composite AGC amplifier can be interpreted as being output referred.

Figure 17D is another embodiment of an AGC amplifier. The AGC amplifier is an embodiment of a VGA coupled with a signal distribution device. The AGC amplifier includes a VGA 1770 at the input of the AGC amplifier. The output of the VGA 1770 is connected to the input of a mixer 1780. A LO 1784 drives an LO port of the mixer 1780. The output of the mixer 1780 is the output of the AGC amplifier. The output of the mixer 1780 is also connected to the input of the power detector 1790. The detected output is provided to the control input of the VGA 1770.

In this AGC amplifier configuration, the AGC function is combined with band translation. The AGC amplifier power controls the output to track the AGC set point and can also frequency convert the signal from an input frequency band to an output frequency band. As noted earlier, a VGA such as 1770 can be combined with a variety of signal distribution devices. The signal splitter 1670 of Figure 16 can represent another embodiment of a VGA coupled with a signal distribution device.

The VGA 1770 operates in a manner as described above in relation to the other AGC amplifier embodiments. The output of the VGA 1770 is connected to an input port of the mixer 1780. The mixer 1780 operates to frequency convert the signal from a first frequency band to a second frequency band. An LO 1784, which can be a fixed frequency LO or a variable frequency LO, drives the LO port of the mixer 1780. The mixer 1780 provides an output signal that includes a frequency component that is at the sum of the input signal frequencies and the LO frequency and a frequency component that is at the difference of the input signal frequencies and the LO frequency.

The power detector 1790 can be configured to detect signals within a predetermined frequency band. Thus, the power detector 1790 can detect the signals in the desired frequency band while ignoring signals outside the frequency band of interest. The AGC amplifier can thus be configured to provide a controlled signal amplitude combined with a frequency conversion.

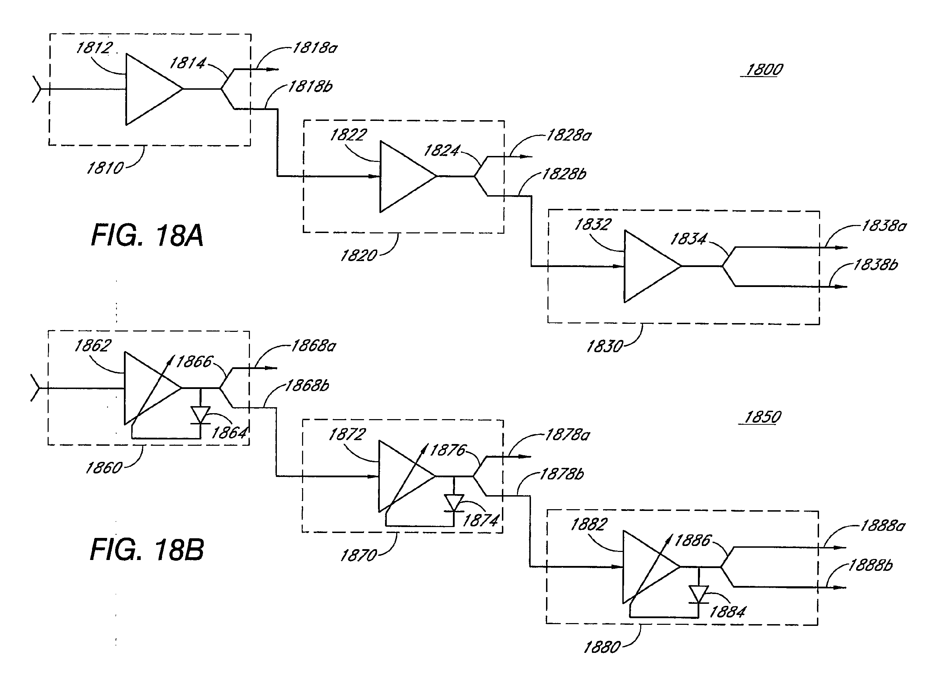

The benefits of including an AGC stage in the signal distribution system, such as within the distribution switch 1630 or signal splitter 1670 in the system of Figure 16, can be illustrated with a comparison of an AGC signal distribution implementation with a fixed gain signal distribution implementation. Figures 18A and 18B show embodiments of cascaded amplifier configurations. The configuration in Figure 18A includes fixed gain amplifiers while the configuration of Figure 18B includes the AGC amplifiers. Such cascaded amplifier configurations can be included in the signal distribution switch of Figure 16, for example, to provide three independent copies of a single input signal destined for three different geographic locations within the signal distribution system.

Figure 18A is an embodiment of a fixed gain signal distribution section 1800, such as a distribution section that can be implemented in the distribution switch of Figure 16. For example, the devices in the distribution section 1800 can be distributed at front end, intermediate location, or near a termination of a signal distribution system. The fixed gain distribution section 1800 includes three gain devices 1810, 1820, and 1830 connected in series. Each of the gain devices, for example 1810, can be configured as an active power divider having a fixed gain of 0 dB, a noise figure (NF) of 3 dB, and an input third order intercept point (IIP3) of +30 dBm. Alternatively, each of the gain devices can include an amplifier in conjunction with some other type of signal distribution device.

A first fixed gain device 1810 includes a fixed gain amplifier 1812 followed by a passive power divider 1814 having a first output 1818a and a second output 1818b. The composite gain through the fixed gain amplifier 1812 and passive power divider 1814 to one of the outputs, for example 1818b, can be configured to be 0 dB. The second output 1818a of the first fixed gain device 1810 is connected to the input of a second fixed gain device 1820. The second fixed gain device 1820 also contains a fixed gain amplifier 1822 and a passive power divider 1824 having a first output 1828a and a second output 1828b. The second output 1828b of the second fixed gain device 1820 is connected to the input of a third fixed gain device 1830. The third fixed gain device 1830 is similarly configured with a fixed gain amplifier 1832 followed by a passive power divider 1834 having two outputs 1838a, 1838b.

An alternative signal distribution section 1850 including AGC amplifiers is shown in Figure 18B. The embodiment of the signal distribution section 1850, including the AGC amplifiers, can be implemented in the distribution switch of Figure 16.

Three gain devices, 1860, 1870, and 1880 are cascaded in the signal distribution section. Each of the gain devices 1860, 1870, and 1880 includes an AGC amplifier followed by a passive power divider. Each of the gain devices, 1860, 1870, and 1880 may also include an AGC amplifier in conjunction with one or more other signal distribution devices.

Each of the gain devices, for example 1860, can have an output referred AGC function with an AGC set point of 0 dBm, an IIP3 of +30 dBm, and a NF of 3dB at 0 dB of gain. The gain device, for example 1860, can have a gain range of from -20 dB to +20 dB. Each of the AGC amplifiers can be, for example, one of the AGC amplifier configurations shown in FIG.s 17A-17C.

An input signal is provided to an input of the first gain device 1860. The input signal is coupled to the input of an AGC amplifier 1862. The output of the AGC amplifier 1862 is connected to the input of a power detector 1864. The output of the power detector 1864 is connected to a control input of the AGC amplifier. The output of the AGC amplifier 1862 is also connected to the input of a power divider 1866 that has first and second outputs, 1868a and 1868b respectively.

The second output 1868b of the first gain device 1860 is connected to the input of a second gain device 1870. The output from the first gain device 1860 is coupled to the input of an AGC amplifier 1872. The output of the AGC amplifier 1872 is connected to the input of a power detector 1874. The output of the power detector 1874 is connected to a control input of the AGC amplifier. The output of the AGC amplifier 1872 is also connected to the input of a power divider 1876 that has first and second outputs, 1878a and 1878b respectively.

The second output 1878b of the second gain device 1870 is connected to the input of a third gain device 1880. The output from the second gain device 1870 is coupled to the input of an AGC amplifier 1882 in the third gain device 1880. The output of the AGC amplifier 1882 is connected to the input of a power detector 1884. The output of the power detector 1884 is connected to a control input of the AGC amplifier. The output of the AGC amplifier 1882 is also connected to the input of a power divider 1886 that has first and second outputs, 1888a and 1888b respectively.

The performance of the fixed gain distribution section 1800 can be compared against the performance of the variable gain distribution section 1850 for two operating conditions. In the first operating condition, the input signal is relatively small and uncorrelated noise is a significant factor limiting the SNR. In the second operating condition, the input signal is relatively large, and distortion products are significant factors limiting the SNR.

In the first operating condition, the input signal is relatively small. The configuration of the fixed gain distribution section 1800 does not change. However, the variable gain distribution section 1850 automatically configures itself to provide gain, up to a maximum gain level.

An active device, such as an amplifier, typically has multiple noise sources associated with it. The noise contribution of cascaded amplifiers can be reduced if the front end device has significant gain. The noise contribution of subsequent stages can become insignificant, and thus, the degradation to SNR can be minimized. Additionally, other noise contributors after the first gain stage, or front end device, degrade the SNR less than without the front end gain device. Thus, including the front end gain stage reduces the overall system SNR degradation. The performance of the fixed gain distribution section 1800 can be compared to the variable gain distribution section 1850 by examining the noise figures. The noise figure in a cascaded system is given by the following formula:

$$nf_{\text{cascade}} = nf_1 + \sum_{i=2}^{N} \frac{nf_i - 1}{\prod_{j=1}^{i-1} A_j} \text{, where N = number of stages, } A_j = \text{gain of } j\text{th stage}$$

The noise figure values in the formula are given as ratios, while noise figure specified for the devices are given in dB. Thus, the NF for the gain devices, for example 1810 or 1870, needs to be converted from decibels to ratios before application of the formula. Table 1 provides a summary of the cascaded noise figures for the two gain distribution sections, 1800, 1850. Psig represents the signal power, in dBm at either the input or output of the gain devices. The gain of the elements is provided in dB. The noise figure, in dB, is provided for each gain device and the corresponding cascaded noise figure, in dB, is provided at the output of each gain device.

Table 1

| Fixed Gain Distribution Section | | | | | | | |
|---|---|---|---|---|---|---|---|
| Psig (dBm) | -20 | - | -20 | - | -20 | - | -20 |
| Gain (dB) | | 0 | | 0 | | 0 | |
| NF (dB) | | 3 | | 3 | | 3 | |
| NFtot (dB) | | 3 | | 4.8 | | 6 | |
| Variable Gain Distribution Section | | | | | | | |
| Psig (dBm) | -20 | - | 0 | - | 0 | - | 0 |
| Gain (dB) | | 20 | | 0 | | 0 | |
| NF (dB) | | 3 | | 3 | | 3 | |
| NFtot (dB) | | 3 | | 3.02 | | 3.04 | |

Thus, it can be seen that the ability of the variable gain distribution section 1850 to include gain in an initial amplifier section results in greatly reduced signal degradation due to noise contributed by subsequent stages when compared to the fixed gain distribution section 1800. Noise contributors after the initial gain section degrade the SNR less than without the gain section. Therefore, overall system degradation of SNR can be reduced with the inclusion of an initial gain section.

In the second operating condition, the input signal is relatively large. The configuration of the fixed gain distribution section 1800 does not change. However, the variable gain distribution section 1850 automatically configures itself to provide attenuation, up to a maximum attenuation level. When input signal levels are relatively large, distortion components, such as third order intermodulation distortion products, can be the dominant factor in degrading SNR. A cascaded IIP3 for the signal distribution sections, 1800, 1850 can be calculated and compared to illustrate the advantages of variable gain distribution over fixed gain distribution. The cascaded IIP3 of a gain section is given by the formula:

$$\frac{1}{IP_{tot}} = \frac{1}{IP3_1} + \sum_{i=2}^{N} \frac{\prod_{j=1}^{i-1} A_j}{IP3_i}$$

The IP3 values in the formula are the linear terms and are not the values in dBm. Similarly, the gain values are provided as ratios and are not in dB. Table 2 provides a summary of the cascaded IIP3 for the two gain distribution sections 1800, 1850. Psig represents the signal power, in dBm at either the input or output of the gain devices. The gain of the elements is provided in dB. The IIP3, in dBm, is provided for each gain device and the corresponding cascaded IIP3, in dBm, is provided at the output of each gain device.

Table 2

| Fixed Gain Distribution Section | | | | | | | |
|---|---|---|---|---|---|---|---|
| Psig (dBm) | +20 | | +20 | | +20 | | +20 |
| Gain (dB) | | 0 | | 0 | | 0 | |
| IIP3 (dBm) | | +30 | | +30 | | +30 | |
| IIP3tot (dBm) | | +30 | | +27 | | +25.2 | |
| Variable Gain Distribution Section | | | | | | | |
| Psig (dBm) | +20 | | 0 | | 0 | | 0 |
| Gain (dB) | | -20 | | 0 | | 0 | |
| IIP3 (dBm) | | +30 | | +30 | | +30 | |
| BP3tot (dBm) | | +30 | | +29.96 | | +29.91 | |

Thus, it can be seen that the ability of the variable gain distribution section 1850 to include attenuation in an initial amplifier section results in greatly reduced signal degradation due to noise contributed by subsequent stages when compared to the fixed gain distribution section 1800. Distortion contributors after the initial attenuation stage degrade the SNR less than without the attenuation stage. The overall system degradation of SNR can be reduced with the inclusion of an initial attenuation section.

The inclusion of an AGC function in a signal distribution section can thus improve the quality of the signal compared to a fixed gain configuration. The advantages of the variable gain section over the fixed gain section under the extreme conditions of low input signal power and high input signal power show that the variable gain distribution section has flexibility as to its position within a signal distribution system. The variable gain distribution section need not be placed at the front end or as a final stage in a signal distribution system.

One embodiment of the band translation switch 1510 can be used in a signal distribution system designed to provide distribution of satellite television signals in a residence. The AGC amplifiers 1520a-1520d provide variable gain and attenuation based on the power of the input signal. The measurement point for the AGC function is at the output of the AGC amplifiers 1520a-1520d and the gain of the crosspoint switch 1530 and the band translation devices 1540a-1540d are fixed.

Each AGC amplifier 1520a-1520d followed by a crosspoint switch 1530, band translation device 1540a-1540d, filter 1550a-1550d, and signal combiner 1560a-1560b can be configured to provide a total gain that ranges from a minimum of -7 dB to a maximum of +7 dB. The corresponding NF of a path through the band translation switch 1510 from the AGC amplifier, for example 1520a, through to the output of a band translation device, for example 1540a, can vary from, for example, a high of 24 dB to a low of 10 dB. The signal path experiences a higher NF when providing attenuation and has a lower NF when the gain is unity or greater. Similarly, the IIP3 associated with the signal path can range from a minimum of -7 dBm to a maximum of +7 dBm. For example, the IIP3 of the signal path can be -15, -10, -7, -6, -5, -4, -3, -2, -1, 0, +1, +2, +3, +4, +5, +6, +7, +10, +15, +20, +25, or +30 dBm.

The IIP3 of the AGC amplifier 1520a is typically higher when the amplifier is configured to provide attenuation, which contributes to the composite IIP3 of the signal path. The IIP3 of the AGC amplifier 1520a can vary in proportion to the gain of the amplifier.

Because the AGC amplifier 1520a also provides the signal to a cascade output, the characteristics of the AGC function at the cascade output are substantially the same as the characteristics of the AGC amplifier 1520a. Also because the AGC function is provided before the cascade output, the benefits of the AGC function are experienced in the main signal path as well as the signal path through the cascade output.

This band translation switch 1510 configuration can be used in a signal distribution system where the input to the band translation switch 1510 can be expected to vary over the range of -50 dBm through -10 dBm. The AGC amplifiers 1520a-1520d can be configured to have an output referred AGC setpoint of -17 dBm, where the output refers to the output signal of the switch 1500. The band translation switch 1510 need not actually measure the power at the output of the switch 1500. Because the devices following the band translation switch 1510 have fixed gains, the AGC output can be interpreted as being output referred to any point past an AGC amplifier where the gain or attenuation is fixed.

Using this AGC setpoint, the AGC amplifier, for example 1520a, provides a gain of 7 dB when the input signal is -24 dBm or below. Additionally, the AGC amplifier 1520a provides -7 dB of gain, or 7 dB of attenuation, when the input signal is -10 dBm or greater. Thus, within the input power range of -24 dBm through -10 dBm the AGC amplifier 1520a provides a constant output power of -17 dBm.

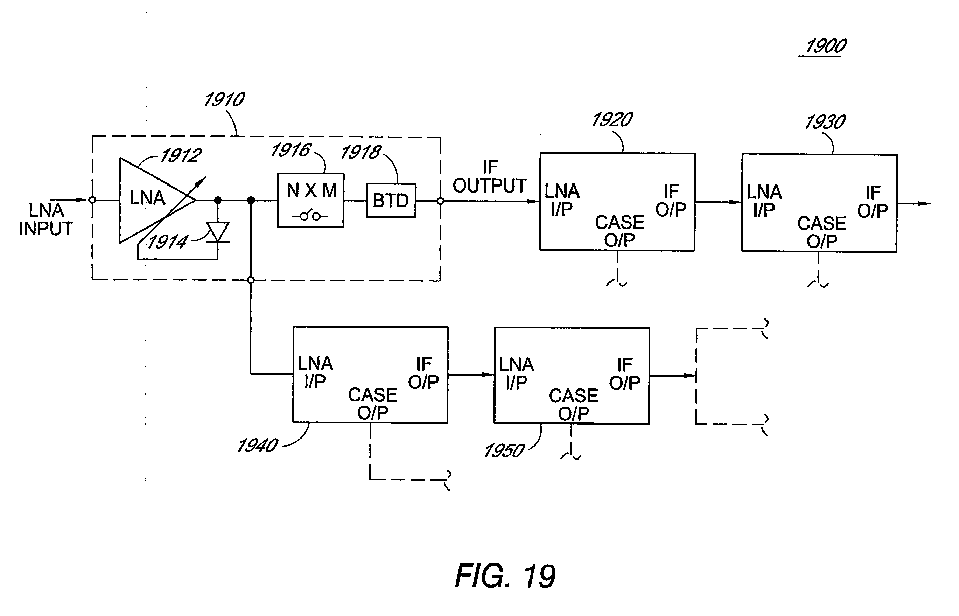

Figure 19 is a functional block diagram of multiple band translation switches 1910, 1920, 1930, 1940, and 1950, connected in a signal distribution system. The band translation switches 1910, 1920, 1930, 1940, and 1950, can be configured with LNBs to provide the distribution switch of Figure 16. However, as noted earlier, one or more of the band translation switches 1910, 1920, 1930, 1940, and 1950 can be positioned at other locations within the signal distribution system. For example, one or more of the band translation devices can be positioned near the signal input, at an intermediate position within the signal distribution system, or near a termination or destination device of the signal distribution system.

A first band translation switch 1910 includes an LNA input that can be connected to an LNB that block converts a satellite downlink transmission. The output of the first band translation switch 1910 is connected to an input of a second band translation switch 1920 that, in turn, has an output connected to a third band translation switch 1930. A cascade output of the first band translation switch 1910 is connected to the input of a fourth band translation switch 1940. The output of the fourth band translation switch 1940 is connected to the input of a fifth band translation switch 1950.

Each of the band translation switches, 1910, 1920, 1930, 1940, and 1950, can be the band translation switch of Figure 15 and can include one of the AGC amplifiers of Figures 17A-17C. Each of the band translation switches, 1910, 1920, 1930, 1940, and 1950, can be configured similarly to the first band translation switch 1910. In the first band translation switch 1910, an input VGA 1912 receives the input signal from the LNB's. The VGA 1912 typically has a low noise figure, such that the noise figure of the band translation switch 1910 from the input to a band translation output is below 3 dB, 4 dB, 5 dB, 6 dB, 8 dB, 10 dB, 12 dB, 14 dB, 15 dB, 20 dB, 25 dB, 30 dB, 35 dB or 40 dB. The noise figure of the band translation switch 1910 from an input to the cascade output is typically closer to the value of noise figure of the VGA 1912 and can be, for example less than 3 dB, 4 dB, 5 dB, 6 dB, 8 dB, 9 dB, 10 dB, 12 dB, 14 dB, 15 dB, 20 dB, 24 dB, 25 dB, 30 dB, 35 dB or 40 dB.

Additionally, the VGA 1912 contributes to the IIP3 of the band translation switch 510. The band translation switch 1910 typically has an IIP3, measured from an input to an output of a band translation device, of greater than -40, -30, -20, -10, -8, -7, -6, -5, -4, -3, -2, -1, 0, +1, +2, +3, +4, +5, +6, +7, or +8, +15, +20, +22, +25, +26, +27, +28, +29, or +30 dBm. Similarly, the band translation switch 1910 typically has an IIP3, measured from an input to the cascade output of greater than -10, -5, +1, +2, +3, +4, +5, +6, +7, +8, +9, +10, +15, +20, +25, or +30 dBm.

The output of the VGA 1912 is connected to a detector 1914 and NxM crosspoint switch 1916. The detector 1914 detects the power output by the VGA 1912 and provides a detected output that is connected to the control input of the VGA 1912. Additionally, the output of the VGA 1912 drives the cascade output of the first band translation switch 1910. The output of the NxM crosspoint switch 1916 is connected to a band translation device 1918.

Although only one VGA 1912 and detector 1914 are shown in the first band translation switch 1910, more than one VGA 1912 and cascade output can be included in a band translation switch, as shown in Figure 19. Thus, the benefits of having an AGC function in line with a signal distribution path can be provided to two signal paths originating from a single VGA, for example 1912, in a single band translation switch, 1910.

Each of the subsequent band translation switches 1920, 1930, 1940 and 1950, can also be connected to signal paths at their cascade outputs and can likewise control the signal level and minimize the subsequent noise contributions by utilizing an input AGC stage. The fourth band translation switch 1940 connected to a cascade output of the first band translation switch 1910 does not contribute noise to the originating signal path and further controls noise contributions from subsequent stages.

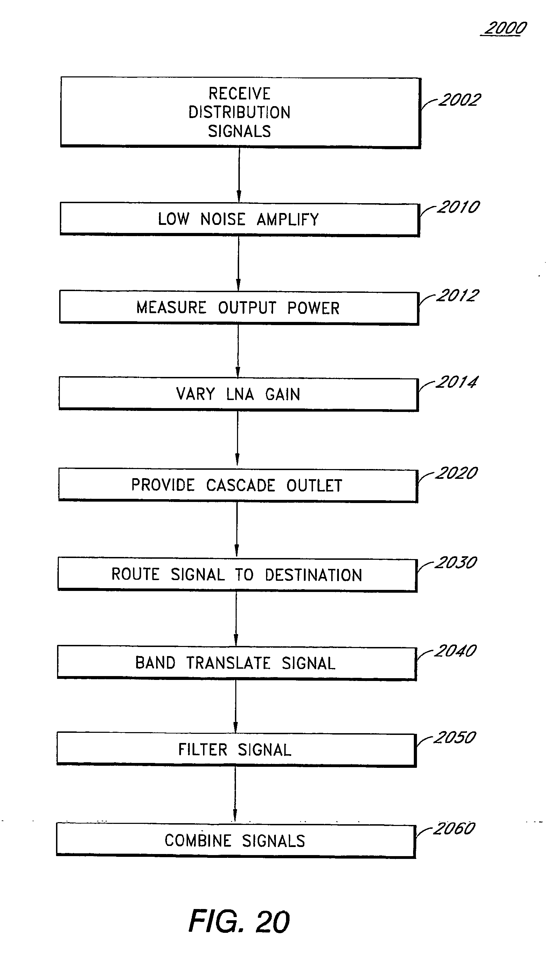

Figure 20 is a flowchart of a signal distribution method 2000 for use in a signal communication system, such as the satellite communication system shown in Figure 16. The method 2000 begins at block 2002 where the distribution signals are received. The signals can be received from a satellite, as in Figure 16, or can be received from an antenna configured to receive terrestrial signals, a cable, or an optical link. Additionally, the signals can be received from a combination of sources.

After receiving the signals to be distributed, the signals are amplified, typically by a low noise amplifier, as shown in block 2010. Because the gain can be varied from a positive gain value to a negative value, the amplifier may not be a low noise amplifier under all operating conditions and can be an attenuator under some operating conditions. In this context, a negative gain value refers to attenuation.

After amplification, the output power is measured, block 2012. Because output power is measured after the gain stage, the subsequent AGC function based on the measured output power can be referred to as output referred AGC. The measured output power is then used as a factor for varying the gain, block 2014. As previously discussed, the gain can typically be varied over a range spanning positive gain to attenuation.

A cascade output is also provided, block 2020, and can be provided after the AGC function. The gain controlled signal can be provided as a cascade output, as is shown in Figures 15 and 19.

Additionally, the signal is routed to a destination path, block 2030, such as by the NxM crosspoint switch shown in Figure 15. The signal that is routed to the destination by the NxM crosspoint switch is typically independent of the signal provided to the cascade output. Thus, as is shown in the band translation switch of Figure 15, the output of the AGC section is provided as a cascade output and is also provided to the input of the NxM crosspoint switch to be routed to one of M possible distribution paths.

The signal that is routed to a distribution path can then be band translated, block 2040. A band translation block can include a mixer to selectively translate the signal from a first frequency block to a second frequency block. Additionally, the band translation block can be configured to have a pass through path where the signal is not frequency translated.

Following band translation, the signal output from the band translation block can be filtered, block 2050, to remove noise and unwanted frequency components that are outside of a band of interest. Two or more of the filtered signals can be combined to produce a composite signal, block 2060. The two or more filtered signals can originate from one or more independent signal distribution paths. Each of the filtered signals can be in a distinct frequency band. Alternatively, one or more of the filtered signals can be in a frequency band that overlaps the frequency band of another of the filtered signals.

Although the method 2000 is shown with flow from one block to the next, the order of the method blocks is not limited to the order shown in Figure 20.

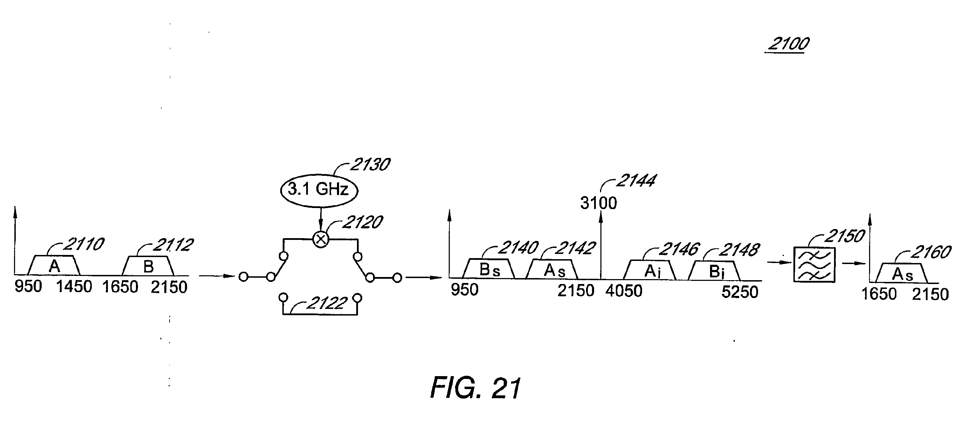

A mixer with a fixed frequency LO can be implemented in the band translation device to provide frequency translation. Figure 21 is a functional block diagram of a band extraction system 2100 for a dual band-stacked frequency plan. The band extraction system 2100 is configured to position input signals from either an upper or lower band block into the upper band block. The band extraction system 2100 is also configured to bandpass the upper band block and reject signals from the lower band block.

The band extraction system 2100 implements a band translation device 2118 and a bandpass filter 2150. The band translation device 618 includes a pass through signal path 2122 and a frequency translation signal path. The frequency translation signal path includes a mixer 2120 and a LO 2130.

As discussed earlier, one embodiment of a dual band-stacked frequency plan has a lower band block at 950-1450 MHz and an upper band block at 1650-2150 MHz. Thus, the filter 2150 is configured as a bandpass filter that passes 1650-2150 MHz and rejects signals in at least the 950-1450 MHz band.

The input signal is a band stacked signal having an input lower band signal 2110 and an input upper band signal 2112. Band extraction for the pass through configuration is trivial. The pass through signal path 2122 of the band translation device 2118 is selected. The input signal is pass through the band translation device 2118 without frequency translation. The upper band block is then extracted using the filter 2150 to produce an output signal.

The frequency translation signal path is used when the input lower band signal 2110 is to be frequency translated to the upper band block. The input signals are directed to an input of the mixer 2120 for frequency translation. A LO 2130 is connected to a LO port of the mixer 2130. A LO 2130 tuned to a frequency of 2x the band block center mean will result in a frequency translation of signals in the upper band block to the lower band block and frequency translation of signals in the lower band block to the upper band block. The LO frequency for the frequency plan shown in Figure 21 is 3.1 GHz. Thus, this LO frequency can be used when extracting either the upper band block or the lower band block. Only the bandpass filter needs to be changed to extract the desired band block. The mixer 2130 provides output signals that are at the sum of the input signal frequency and the LO frequency and output signals that are at the difference of the input signal frequency and the LO frequency.

An input lower band signal is frequency translated by the mixer 2130 to an upper difference band 2142 and a lower sum band 2146. An input upper band signal 2112 is frequency translated by the mixer 2130 to a lower difference band 2140 and an upper sum band 2148. The sum and difference signals, 2140, 2142, 2146 and 2148, are provided to the filter 2150 which passes only the desired output upper band signal 2160 and rejects at least the other mixer products as well as the LO frequency. Thus, the input lower band signal, in the 950-1450 MHZ band, is frequency translated to an output upper band signal in the 1650-2150 MHz band.

The sum and difference bands are symmetric about the LO frequency 2144. Thus, this LO frequency swaps the positions of the input upper and lower signal. However, the difference bands are frequency inverted. A signal that is in the upper sideband of the input lower band 2110 is translated to the lower sideband of the upper difference signal. Frequency inversion does not pose any problems for double sideband signals. Similarly, spectral inversion does not pose problems for digitally modulated signals that are processed by a demodulator with built in spectral inversion. The frequency inverted signals can be further processed if the system designer requires, or desires, a particular frequency relationship. The two band-stacked configuration allows for a single LO to simultaneously rearrange the band stack. In other embodiments, each frequency component in the final composite output signal may be translated through a different band translation device. For example, a first band translation device may frequency translate a first signal to a first output signal band. Similarly, a second band translation device can frequency translate a second signal to a second output frequency band, and so on up to M frequency bands. Multiple output frequency bands can then be combined in one or more combiners. Each output frequency band can be one or more channels corresponding to signals from one or more transponders.

Although the previous embodiments show the frequency translation device as a single mixer, other frequency translation means can be used. A single frequency translation device can be a mixer, sampled switch, switching mixer such as diode ring, Gilbert cell, FET ring mixers, or nonlinear mixers such as diodes, linear multipliers such as translinear bipolar devices, variable resistors, or the like. Alternatively, the frequency translation device can perform multiple frequency translations. The input band blocks can be upconverted to a high Intermediate Frequency (IF) that is at a frequency greater than the highest frequency in the input band blocks. The IF signal can then be filtered to extract the band block of interest, where the desired band block can correspond to one or more channels from one or more transponders. The desired band block can then be downconverted to the desired output band block. The high IF can be a common IF or can be different for different band translation devices. Each high IF signal can be downconverted to a portion of an output frequency band. Multiple downconverted signals can be combined into a composite output signal.

Alternatively, the input band blocks can be downconverted to a low IF that is lower than the lowest frequency component of the input band blocks. The low IF signal can then be filtered to select the desired band block. The filtered band block is then upconverted to the desired output band block. For example, independent input signals can each be downconverted to a common IF where one or more channels are passed in a filter. The low IF can be a common IF or can be different for different band translation devices. Each of the filtered signals at the IF can then be upconverted to a desired frequency band. Multiple upconverted signals can then be combined to form a composite signal. The composite signal can then be output to a set top box or boxes.

In another alternative, the desired input band block can be downconverted to a baseband signal. The baseband signal can then be filtered, for example with a lowpass filter, before being upconverted to the desired output band block. If the input signals are quadrature modulated or if the two sidebands have different information, the input signal can be downconverted into two baseband channels in quadrature. Typically, a quadrature downconverter can frequency translate the signals to baseband In-phase (I) and Quadrature (Q) channels. The baseband I and Q channels can then be filtered, such as by a LPF, and the filtered signals I and Q upconverted to the desired band block.

For example, multiple signals can be frequency translated to baseband signals in a corresponding number of band translation devices. Each of the baseband signals can be upconverted to a portion of an output frequency band. The multiple upconverted signals can be combined to form a composite signal.

In other embodiments, more than two frequency translations can be used with various combinations of simple mixers, image reject mixers, IQ down converters, Single Side-Band upconverters, and filters to provide the frequency translation and filtering functions.

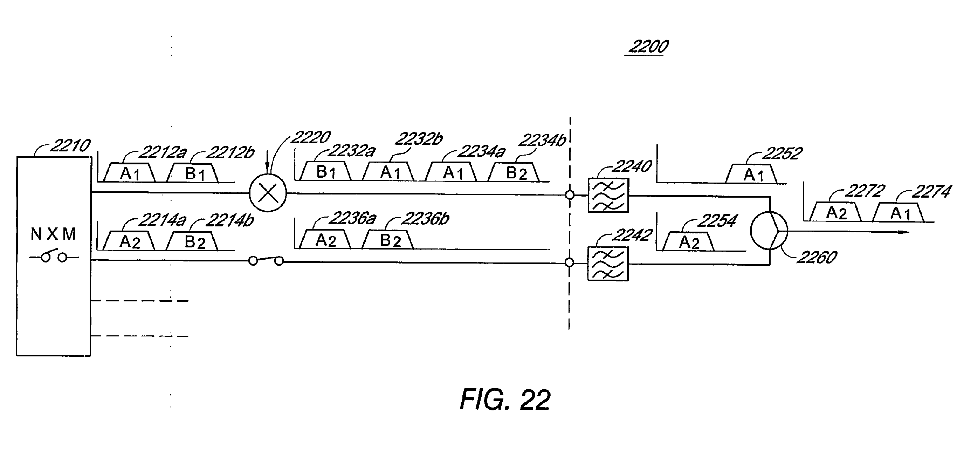

Figure 22 is a functional block diagram of an embodiment a portion of a band translation switch configured to switch and frequency translate signals from two sources to a single output. The functional elements are shown along with a depiction of the signal spectrum output from the element.

A crosspoint switch 2210 can be configured to have N inputs and M outputs, where N and M can be the same or different integers. Figure 7 shows two of the outputs from the crosspoint switch 2210.

A first crosspoint switch 2210 output provides a first composite signal. The first composite signal includes a first lower input band signal 2212a and a first upper input band signal 2212b. Similarly, a second crosspoint switch 2210 output provides a second composite input signal. The second composite signal includes a second lower input band signal 2214 and a second upper input band 2214b signal.

The first composite signal is band translated in a band translation device 2220, such as a mixer having an LO tuned to 2x (block center mean). The output of the band translation device 2220 includes signals at a lower input band 2232a, an upper band 2232b, a lower sum band 2234a, and an upper sum band 2234b. The output of the band translation device 2220 is connected to a first filter 2240 that is configured to pass the upper band and substantially reject all other signals. The output of the first filter 2240 includes the upper band 2252 with the remaining signal components substantially rejected. The output of the first filter 2252 is connected to a first input of a signal combiner 2260.

The second output of the crosspoint switch 2210 is connected to a band translation device 2222 configured for pass through. Thus, the output of the band translation device 2222 appears substantially the same as the output from the crosspoint switch 2210. The signal includes a lower band 2236a and an upper band 2236b. The output of the band translation device 2222 is connected to a second filter 2242. The second filter 2242 is configured to pass the lower band and substantially reject all other signals. The output of the second filter 2242 is connected to a second input of the signal combiner 2260.

The signal combiner 2260 is configured to combine the signals provided to its first and second inputs. The output of the signal combiner is thus a band-stacked signal having a lower band signal 2272 and an upper band signal 2274. The lower band signal 2272 is provided by the second crosspoint switch output and the upper band signal 2274 is provided by the first crosspoint switch output. Thus, it can be seen how a band-stacked output having signal components from any number of predetermined input bands can be constructed.

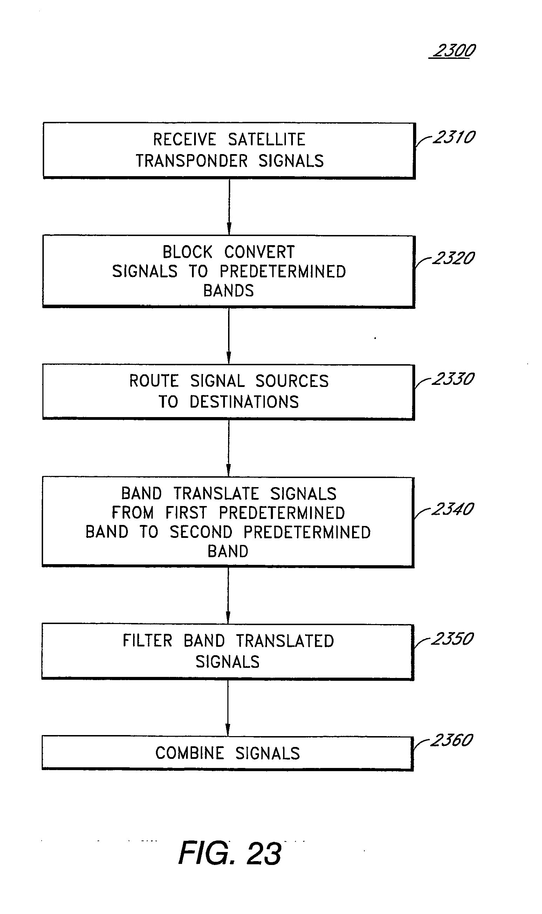

Figure 23 shows a flowchart of an embodiment of a method 2300 of frequency translating input frequency bands using an integrated band translation switch. An initial function performed is receiving satellite transponder signals 2310. The satellite transponder signals can be received from one or more satellite transponder groups located on one or more satellites. The satellite transponder signals are typically received in an antenna. However, satellite transponder signals can be received from signal distribution devices, such as a cable television headend, that use an antenna to directly receive the satellite transponder signals.

After receiving the satellite transponder signals, the received signals are block converted to first predetermined bands 2320. The first predetermined bands can also be referred to as predetermined input bands. One or more block converters can be used to convert the transponder signals to the first predetermined bands. The block converters can be low noise block converters configured to block convert signals from multiple transponder groups and band-stack the converted transponder group signals into one or more of the first predetermined bands. Each of the band-stacked signals can then be provided to an input to a routing device or assembly.

The block converted signals are then routed to destinations 2330. The routing can be a selective routing that is controlled using one or more control lines communicating one or more control signals. Additionally, the routing can be performed by a switch, such as a crosspoint switch, that is configured to route any of the LNB signals to one or more outputs. There can be any number N of LNB's. The crosspoint switch can be configured to have N inputs corresponding to the N LNB's. The crosspoint switch can also be configured to have M outputs, where the number of outputs M can be the same, or different, from the number of inputs N. The crosspoint switch can be configured to route a signal from any one of the crosspoint switch inputs to any one or more of the crosspoint switch outputs.

After routing the band-stacked transponder signals, the signals are band translated from the first predetermined frequency band to a second predetermined frequency band. Each of the band-stacked signals are translated independently of the others. The first predetermined band can be the same, or different, from the second predetermined band.

The band translated signals in the second predetermined frequency bands are then filtered 2350. Alternatively, filtering can occur prior to band translation. The filter is configured to pass the desired signal in the desired band and reject substantially the remaining frequency components.

The filtered signals are then combined 2360. One or more of the filtered signals can be combined to produce a band-stacked output signal. A combiner can be configured to combine any number of filtered signals. Additionally, more than one combiner can be used to provide more than one band-stacked output signal. In an alternative embodiment, a diplexer can be used to filter and combine signals.

One or more of the method steps can be performed by a single integrated circuit. For example, the block conversion can be performed by an integrated circuit. Similarly, routing the signals to destinations can be performed by an integrated circuit that can be the same, or different from the integrated circuit that performs the block conversion. In another embodiment, band translating the signals is performed on an integrated circuit that can be the same, or different from, the integrated circuit used for routing the signals or block converting the signals. Similarly filtering and combining the signals can be performed on one or more integrated circuits that are the same as, or different from, any of the other integrated circuits. One or more of the integrated circuits can include a semiconductor substrate such as a silicon substrate. Alternatively, the integrated circuit substrate can include germanium, gallium arsenide, indium phosphide, sapphire, diamond, and the like, or any other suitable substrate material. Additionally, the integrated circuit can be manufactured using any suitable technology, such as Silicon Germanium (SiGe), bipolar, FET, and the like.

Thus, an integrated crosspoint switch with band translation has been disclosed. Input band-stacked signals from one or more satellite transponder groups can be reconfigured to provide band-stacked output signals having a signal band from any transponder group positioned in any of the predetermined output bands. A LNB can receive one or more transponder group signals to create an band-stacked input signal. A low noise amplifier in an integrated circuit can amplify the LNB output and also provide a cascade output signal. The output from the low noise amplifier can be connected to a crosspoint switch on the same integrated circuit. The crosspoint switch can be configured to route signals from any one of its signal inputs to any one of its signal outputs. Each of the crosspoint signal outputs is connected to a band translation device. The band translation device can also be configured on the same integrated circuit. Each of the band translation devices is configured to frequency translate or pass through an input signal. The band translation device can frequency translate a predetermined input band to a predetermined output band. The output from one or more band translation devices can be combined to produce a band-stacked output signal.

Electrical connections, couplings, and connections have been described with respect to various devices or elements. The connections and couplings can be direct or indirect. A connection between a first and second device can be a direct connection or can be an indirect connection. An indirect connection can include interposed elements that can process the signals from the first device to the second device.

Those of skill in the art will understand that information and signals can be represented using any of a variety of different technologies and techniques. For example, data, instructions, commands, information, signals, bits, symbols, and chips that can be referenced throughout the above description can be represented by voltages, currents, electromagnetic waves, magnetic fields or particles, optical fields or particles, or any combination thereof.

Those of skill will further appreciate that the various illustrative logical blocks, modules, circuits, and algorithm steps described in connection with the embodiments disclosed herein can be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled persons can implement the described functionality in varying ways for each particular application, but such implementation decisions should not be interpreted as causing a departure from the scope of the invention.

The various illustrative logical blocks, modules, and circuits described in connection with the embodiments disclosed herein can be implemented or performed with a general purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general-purpose processor can be a microprocessor, but in the alternative, the processor can be any processor, controller, microcontroller, or state machine. A processor can also be implemented as a combination of computing devices, for example, a combination of a DSP and a microprocessor, a plurality of microprocessors, one or more microprocessors in conjunction with a DSP core, or any other such configuration.

The steps of a method or algorithm described in connection with the embodiments disclosed herein can be embodied directly in hardware, in a software module executed by a processor, or in a combination of the two. A software module can reside in RAM memory, flash memory, ROM memory, EPROM memory, EEPROM memory, registers, hard disk, a removable disk, a CD-ROM, or any other form of storage medium. An exemplary storage medium can be coupled to the processor such the processor can read information from, and write information to, the storage medium. In the alternative, the storage medium can be integral to the processor. The processor and the storage medium can reside in an ASIC.

The above description of the disclosed embodiments is provided to enable any person skilled in the art to make or use the invention. Various modifications to these embodiments will be readily apparent to those skilled in the art, and the generic principles defined herein can be applied to other embodiments of the invention. Thus, the invention is not intended to be limited to the embodiments shown herein but is to be accorded the widest scope consistent with the principles and novel features disclosed herein.

**Claims**

1. An apparatus for distributing one or more channels included within a plurality of N signals to one or more output devices (170), the apparatus including a crosspoint switch (140, 226, 320, 1530), and a plurality of frequency translation devices (150, 228, 330, 1540), the crosspoint switch (140, 226, 320, 1530) including a plurality of N crosspoint switch inputs and a plurality of crosspoint switch outputs, each of the N crosspoint switch inputs coupled to receive one of the N signals, the crosspoint switch (140, 226, 320, 1530) operable to switchably couple any of the plurality ofN crosspoint switch inputs to any one or more of the plurality of crosspoint switch outputs, and wherein each of the plurality of frequency translation devices includes an input coupled to a respective one of the crosspoint switch outputs and an output configured to couple to one or more output devices (170), each of the plurality of frequency translation devices (150, 228, 330, 1540) operable to frequency translate one or more of the channels as supplied to respective one or more channels, wherein the outputs of at least two of the plurality of frequency translation devices (150, 228, 330, 1540) are coupled together, the apparatus further including:

   at least a portion of the signal path within the crosspoint switch (140, 226, 320, 1530) or one or more of the plurality of frequency translation devices (150, 228, 330, 1540) configured as a differential signal path operable to support the propagation of a differential mode signal; and
   a plurality of filters (1550, 2150, 2240, 2242), each coupled to a respective one of the plurality of frequency translation devices (150, 228, 330, 1540) and each operable to reject at least one channel of a band of channels supplied thereto and to pass at least one channel of said band of channels supplied thereto,

   wherein two or more of the plurality of frequency translation devices (150, 228, 330, 1540) are coupled to respective different variable local oscillator sources.

2. The apparatus of claim 1, wherein the one or more channels included within one or more of the N signals comprises respective one or more frequency division multiplexed channels, each of the one or more frequency division multiplexed channels having a different carrier frequency.

3. The apparatus of claim 1, wherein the one or more channels included within one or more of the N signals comprises at least one multiplexed channel, the multiplexed channel operating at a predetermined carrier frequency and comprising the content of two or more channels.

4. The apparatus of claim 3, wherein the content of the two or more channels comprises digital content, and wherein the multiplexed channel comprises a multiplexed digital channel.

5. The apparatus of claim 1, wherein at least one of the N signals comprises a plurality of frequency bands.

6. The apparatus of claim 1, wherein the crosspoint switch and the plurality of frequency translation devices (150, 228, 330, 1540) are included within an integrated circuit.

7. The apparatus of claim 1, wherein the output of each one of the frequency translation devices (150, 228, 330, 1540) is configured to couple to a single output device.

8. The apparatus of claim 1, further comprising at least one low noise block converter (130, 210, 1626) operable to provide the N signals.

9. The apparatus of claim 1, wherein the coupled output of the two or more frequency translation devices (150, 228, 330, 1540) is configured to couple to a single output device (170).

10. The apparatus of claim 1, wherein the output of at least one of the frequency translation devices (150, 228, 330, 1540) is configured to couple to a plurality of output devices (170).

11. The apparatus of claim 1, further comprising a signal combiner (150, 230, 1560a, 2260) having (i) a plurality of inputs coupled to respective plurality of frequency translation device outputs, and (ii) an output coupled to one or more output devices (170), said output comprising the coupled output of the two or more frequency translation devices (150, 228, 330, 1540).

12. The apparatus of claim 11, wherein the output of the signal combiner (150, 230, 1560a, 2260) is coupled to each of the one or more output devices (170).

13. The apparatus of claim 11, wherein the output of the signal combiner (230, 1560a) is coupled to a first subset of the one or more output devices (170), the apparatus further comprising a second signal combiner (231, 1560b) having a plurality of inputs coupled to respective plurality of frequency translation device outputs, and an output coupled to a second subset of one or more output devices (170).

14. The apparatus of claim 11, wherein each respective filter is coupled between a frequency translation device output and a signal combiner input.

15. The apparatus of claim 14, wherein each of the plurality of filters (1550, 2150, 2240, 2242) is selected from the group consisting of a high pass filter, a lowpass filter, a bandpass filter, and a diplexer.

16. The apparatus of claim 14, wherein the plurality of filters (1550, 2150, 2240, 2242) are implemented separately from the crosspoint switch (140, 226, 320, 1530).

17. The apparatus of claim 14, wherein the plurality of filters (1550, 2150, 2240, 2242), the crosspoint switch (140, 226, 320, 1530) and the plurality of frequency translation devices (150, 228, 330, 1540) are monolithically formed on an integrated circuit.

18. The apparatus of claim 1, further comprising a plurality of variable gain amplifiers (1710, 1734, 1752, 1770, 1912) coupled to the crosspoint switch, each of the plurality of variable gain amplifiers (222, 310, 1520) operable to apply gain or attenuation to a signal input thereto.

19. The apparatus of claim 18, wherein each of the plurality of variable gain amplifiers (1710, 1734, 1752, 1770, 1912) comprises an input coupled to receive a respective one of the N signals, a control input, and an output coupled to one of the inputs of the crosspoint switch (140, 226, 320, 1530), wherein each of the variable gain amplifiers (1710, 1734, 1752, 1770, 1912) is operable, responsive to a control signal received at the control input, to apply gain or attenuation to a signal input thereto.

20. The apparatus of claim 19, further comprising a respective plurality of detectors (1720, 1740, 1760, 1770) each detector having an input coupled to the input of one variable gain amplifier and an output coupled to the control port of said variable gain amplifier, each of the detectors operable to control the gain or attenuation level of the variable gain amplifier as a function of the power detected.

21. The apparatus of claim 19, further comprising a respective plurality of detectors (1720, 1740, 1760, 1790, 1914), each detector having an input coupled to the output of one variable gain amplifier and an output coupled to the control port of said variable gain amplifier, each of the detectors operable to control the gain or attenuation level of the variable gain amplifier as a function of the power detected.

22. The apparatus of claim 19, wherein the crosspoint switch (140, 226, 320, 1530), the plurality of frequency translation devices (150, 228, 330, 1540), and the plurality of variable gain amplifiers (1710, 1734, 1752, 1770, 1912) are included within an integrated circuit.

23. The apparatus of claim 1, wherein said crosspoint switch comprises a first crosspoint switch (226, 1916), said plurality of frequency translation devices comprises a plurality of first frequency translation devices (228, 1918), and said output devices comprise first output devices, the apparatus further including a plurality of second frequency translation devices (229, 1920, 1940), each having an input coupled to a respective one of the second crosspoint switch outputs and an output configured to couple to one or more second output devices, each of the one or more second frequency translation devices (229, 1920, 1940) operable to frequency translate one or more of the channels as supplied to respective one or more channels, the apparatus further **characterized by**:

a second crosspoint switch (227, 1920, 1940) having a plurality of N crosspoint switch inputs and a plurality of crosspoint switch outputs, each of the N second crosspoint switch inputs coupled to either: (i) a respective one of the first crosspoint switch inputs, or (ii) a respective one of the first crosspoint switch outputs, each of the second crosspoint switch outputs configured to couple to one or more second output devices, the second crosspoint switch (227, 1920, 1940) operable to switchably couple any of the plurality ofN second crosspoint switch inputs to any one or more of the plurality of second crosspoint switch outputs;
a second plurality of filters (1550, 2150, 2240, 2242), each coupled to a respective one of the plurality of second frequency translation devices (229, 1920, 1940) and each operable to reject at least one channel of a band of channels supplied thereto and to pass at least one channel of said band of channels supplied thereto,

wherein two or more of the plurality of frequency translation devices (150, 228, 330, 1540) are coupled to respective different variable local oscillator sources, and
wherein the outputs of at least two of the plurality of second frequency translation devices are coupled together, and at least a portion of the second crosspoint switch or at least a portion of one or more of the plurality of second frequency translation devices comprises a differential signal path.

24. The apparatus of claim 23, wherein the second crosspoint switch (227, 1920, 1940) and the plurality of second frequency translation devices (229, 1920, 1940) are included within a second integrated circuit (221, 1920, 1940).

25. The apparatus of claim 23, wherein the output of each one of the second frequency translation devices is configured to couple to a single second output device.

26. The apparatus of claim 23, wherein the coupled output of the two or more second frequency translation devices is configured to couple to a single second output device.

27. The apparatus of claim 20, wherein the output of at least one of the second frequency translation devices is configured to couple to a plurality of second output devices.

28. The apparatus of claim 23, wherein the output of at least one of the first frequency translation devices is coupled to at least one output of the second frequency translation devices.

29. The apparatus of claim 23, further comprising a second signal combiner (231) having

(i) a plurality of inputs coupled to respective plurality of second frequency translation device outputs, and (ii) an output coupled to one or more second output devices, said output comprising the coupled output of the two or more second frequency translation devices (229).

30. The apparatus of claim 29, further comprising a respective plurality of second filters, each respective second filter coupled between a second frequency translation device output and a second signal combiner input.

31. The apparatus of claim 23, further comprising a plurality of second variable gain amplifiers (223, 225, 1920, 1940) coupled to the second crosspoint switch (227, 1920, 1940), each of the plurality of second variable gain amplifiers operable to apply gain or attenuation to a signal input thereto.

32. The apparatus of claim 31, wherein the second crosspoint switch (227, 1920, 1940), the plurality of second frequency translation devices (229, 1920, 1940), and the plurality of second variable gain amplifiers (223, 225, 1920, 1940) are included within a second integrated circuit (221, 1920, 1940).

33. A method for distributing one or more channels included within any one of a plurality of N received signals to one or more output devices (170) using a signal distribution system, the signal distribution system including (i) a crosspoint switch (140, 226, 320, 1530) having N inputs operable to receive a respective plurality of N signals and a plurality of crosspoint switch outputs, (ii) a respective plurality of frequency translation devices (150, 228, 330, 1540) coupled to the crosspoint switch outputs, (iii) a respective plurality of filters (1550, 2150, 2240, 2242), each coupled to a respective one of the frequency translation devices (150, 228, 330, 1540), and (iv) one or more output devices (170) coupled to at least one of the plurality of frequency translation devices, the crosspoint switch being selectively switchable, such that any of the plurality of N received signals is coupled, via one or more signal paths, to any one or more of the crosspoint switch outputs, wherein one or more crosspoint switch output signals are supplied to respective frequency translation devices, each of the one or more crosspoint switch output signals including one or more channels, and further wherein one or more of the plurality of the frequency translation devices includes a signal path, each frequency translation device operable to frequency translate one or more of the channels as supplied to respective one or more channels, the outputs of at least two of the plurality of frequency translation devices being coupled together; and wherein the frequency-translated channels are output to one or more output devices operable to render the one or more channels supplied thereto, the method further comprising the steps of:

    filtering a signal coupled to the input of an output device (170) using a filter (1550, 2150, 2240, 2242), said filtering comprising rejecting at least one channel of a band of channels included within a signal supplied to said filter (150, 1550, 2150, 2240, 2242), and passing at least one channel of said band of channels included within said signal supplied to said filter (1550, 2150, 2240, 2242); and

    propagating the one or more channels from the respective crosspoint switch input to at least one frequency translation device output along one or more of said signal paths, wherein at least a portion of said one or more signal paths comprises a differential signal path operable to support the propagation of a differential mode signal, wherein two or more of the plurality of frequency translation devices (150, 228, 330, 1540) are coupled to respective different variable local oscillator sources.

34. The method of claim 33, wherein said crosspoint switch (140, 226, 320, 1530) comprises the only crosspoint switch operable to distribute, to the one or more coupled output devices, one or more channels included within any of the plurality of N received signals.

35. The method of claim 33, wherein at least one of the N received signals comprises a plurality of frequency bands.

36. The method of claim 33, wherein:

    one or more channels are grouped into a frequency band; and
    controlling comprises frequency translating the one or more channels to the same frequency band.

37. The method of claim 33, wherein:

    one or more channels are grouped into a frequency band; and
    controlling comprises frequency translating the one or more channels to a different frequency band.

38. The method of claim 33, wherein outputting the frequency-translated channels comprises outputting each of the frequency-translated channels onto a single line coupled to each of the one or more output devices (170).

39. The method of claim 33, wherein outputting the frequency-translated channels comprises:

    outputting one or more first frequency-translated channels onto a first line coupled to a first of the one or more output devices (170); and
outputting one or more second frequency-translated channels onto a second line coupled to a second of the one or more output devices (170).

40. The method of claim 33, wherein controlling comprises:

upconverting at least one of the channels from the first frequency to an intermediate frequency; and
downconverting at least one of the channels from the intermediate frequency to the second frequency.

41. The method of claim 33, wherein controlling comprises:

downconverting at least one of the channels from the first frequency to an intermediate frequency; and
upconverting the at least one of the channels from the intermediate frequency to the second frequency.

42. The method of claim 41, wherein downconverting comprises downconverting the at least one channel to baseband.

43. The method of claim 33, wherein filtering comprises filtering the frequency-translated band of channels output from the one or more frequency translation devices (150, 228, 330, 1540).

44. The method of claim 33, wherein frequency translating comprises either (i) downconverting at least one of the channels from a first frequency to the second frequency, or (ii) up converting at least one of the channels from a first frequency to a second frequency.

45. The method of claim 33, further comprising variably adjusting a power level of one or more of the N signals.

46. The method of claim 45, wherein variably adjusting a power level comprises attenuating one or more of the N signals.

47. The method of claim 45, wherein variably adjusting a power level comprises amplifying one or more of the N signals.

48. The method of claim 33, further comprising:

receiving the plurality of the N signals into a second crosspoint switch (227, 1920, 1940), the second crosspoint switch input having a respective plurality of N inputs;
selectively switching the second crosspoint switch (227, 1920, 1940), whereby any one of the plurality of N received signals is coupled to any one or more of the second crosspoint switch outputs;
supplying one or more second crosspoint switch output signals to respective second frequency translation devices (229, 1920, 1940), each of the one or more second crosspoint switch output signals including one or more channels, wherein the outputs of at least two of the plurality of second frequency translation devices (229, 1920, 1940) being coupled together;
controlling one or more of the plurality of the second frequency translation devices (229, 1920, 1940) to frequency translate one or more of the channels as supplied to respective one or more channels; and
outputting the frequency-translated channels to one or more second output devices (170) operable to render the one or more channels supplied thereto,
filtering a signal coupled to the input of a second output device (1920, 1940) using a second filter (1920, 1940), said filtering comprising rejecting at least one channel of a band of channels included within a signal supplied to said second filter (1920, 1940), and passing at least one channel of said band of channels included within said signal supplied to said second filter (1920, 1940),

wherein two or more of the plurality of second frequency translation devices (229, 1920, 1940) are coupled to respective different variable local oscillator sources, and
wherein at least a portion of the second crosspoint switch (227, 1920, 1940) or at least a portion of one or more of the plurality of second frequency translation devices (229, 1920, 1940) comprises a differential signal path.

49. An apparatus for distributing one or more channels included within each of a plurality of N satellite signals to one or more output devices, the apparatus comprising:

a first Low Noise Block, further referred to as LNB unit, operable to receive a plurality of the N satellite signals, the first LNB unit comprising:

a first LNB converter (130a) coupled to receive a plurality of the N satellite signals and operable to produce a plurality of first satellite IF signals;

a first crosspoint switch (140) having a plurality of first crosspoint switch inputs coupled to receive respective first satellite IF signals and a plurality of first crosspoint switch outputs, the first crosspoint switch operable to switchably couple any of the first crosspoint switch inputs to any one or more of the first crosspoint switch outputs; and

respective plurality of first frequency translation devices (150), each first frequency translation device having an input coupled to a respective one of the first crosspoint switch outputs and an output configured to couple to one or more output devices, each of the first frequency translation devices operable to frequency translate one or more of the channels as supplied to respective one or more channels, wherein the outputs of the first frequency translation devices (150) are coupled together to provide a first LNB unit output,

respective plurality of first filters (1550, 2150, 2240, 2242) operable to reject at least one channel of a band of channels supplied thereto and to pass at least one channel of said band of channels supplied thereto, each of the first filters coupled to a respective one of the first frequency translation devices (150),

wherein two or more of the plurality of first frequency translation devices (150) are coupled to respective different variable local oscillator sources, and

wherein at least a portion of the first crosspoint switch or at least a portion of one or more of the plurality of first frequency translation devices comprises a differential signal path;

a second LNB unit operable to receive a plurality of the N satellite signals, the second LNB unit comprising:

a second LNB converter (130b) coupled to receive a plurality of the N satellite signals and operable to produce a plurality of second satellite IF signals;

a second crosspoint switch (140) having a plurality of second crosspoint switch inputs coupled to receive respective second satellite IF signals and a plurality of second crosspoint switch outputs, the second crosspoint switch operable to switchably couple any of the second crosspoint switch inputs to any one or more of the second crosspoint switch outputs; and

respective plurality of second frequency translation devices (150), each second frequency translation device having an input coupled to a respective one of the second crosspoint switch outputs and an output configured to couple to one or more output devices, each of the second frequency translation devices operable to frequency translate one or more of the channels as supplied to respective one or more channels, wherein the outputs of the second frequency translation devices (150) are coupled together to provide a second LNB unit output;

respective plurality of second filters (1550, 2150, 2240, 2242) operable to reject at least one channel of a band of channels supplied thereto and to pass at least one channel of said band of channels supplied thereto, each of the second filters coupled to a respective one of the second frequency translation devices (150),

wherein two or more of the plurality of second frequency translation devices (150) are coupled to respective different variable local oscillator sources, and

wherein at least a portion of the second crosspoint switch or at least a portion of one or more of the plurality of second frequency translation devices comprises a differential signal path, and

a signal combiner having inputs coupled to receive the first and second LNB unit outputs and an output coupled to one or more output devices (170).

**Patentansprüche**

1. Eine Vorrichtung zur Verteilung eines oder mehrerer Kanäle, die innerhalb einer Vielzahl von N Signalen enthalten sind, an ein oder mehrere Ausgabegeräte (170), wobei die Vorrichtung ein Koppelfeld (140, 226, 320, 1530) und eine Vielzahl von Frequenzumsetzungsgeräten (150, 228, 330, 1540) aufweist, wobei das Koppelfeld(140, 226, 320, 1530) eine Vielzahl von N Koppelfeldeingängen und eine Vielzahl von Koppelfeldausgängen aufweist, wobei jeder der N Koppelfeldeingänge verbunden ist, um eines der N Signale zu empfangen, das Koppelfeld(140, 226, 320, 1530) so betreibbar ist, dass jeder beliebige Eingang der Vielzahl der N Koppelfeldeingänge mit einem oder mehreren Ausgängen der Vielzahl der Koppelfeldausgänge schaltbar verbunden werden kann, und wobei jedes der Vielzahl der Frequenzumsetzungsgeräte einen Eingang, der mit einem entsprechenden Koppelfeldausgang verbunden ist, und einen Ausgang aufweist, welcher zur Verbindung mit einem oder mehreren Ausgabegeräten (170) konfiguriert ist, wobei jedes der Vielzahl der Frequenzumsetzungsgeräte (150, 228, 330, 1540) so betreibbar ist, dass die Frequenz von einem oder mehreren Kanälen, die an die jeweiligen einen oder mehreren Kanäle geliefert werden, umgesetzt wird, wobei die Ausgänge von mindestens zwei der Vielzahl der Frequenzumsetzungsgeräten (150, 228, 330, 1540) miteinander verbunden sind,
wobei die Vorrichtung weiterhin folgendes aufweist:

mindestens einen Teil des Signalpfades innerhalb des Koppelfeld s (140, 226, 320, 1530) oder eines oder mehreren der Vielzahl der Frequenzumsetzungsgeräte (150, 228, 330, 1540), konfiguriert als ein Differenzsignalpfad, betreibbar zur Unterstützung der Ausbreitung eines Differenzsignals, und
eine Vielzahl von Filtern (1550, 2150, 2240, 2242), wobei jeder mit einem entsprechenden Frequenzumsetzungsgerät der Vielzahl von Frequenzumsetzungsgeräten (150, 228, 330, 1540) verbunden ist und betreibbar ist, um mindestens einen Kanal eines Bands von Kanälen, die dahin eingespeist werden, abzuweisen und um mindestens einen Kanal des Bands von Kanälen, die dahin eingespeist werden, durchzulassen,
und wobei eines oder zwei der Vielzahl von Frequenzumsetzungsgeräten (150, 228, 330, 1540) mit entsprechenden unterschiedlichen, variablen örtlichen Oszillatorquellen verbunden sind.

2. Die Vorrichtung gemäß Anspruch 1, wobei der eine oder mehrere Kanäle innerhalb des einen oder der mehreren N Signale einen oder mehrere entsprechende Frequenzmultiplexkanäle aufweisen, wobei jeder des einen oder mehreren Frequenzmultiplexkanäle eine unterschiedliche Trägerfrequenz hat.

3. Die Vorrichtung gemäß Anspruch 1, wobei der eine oder die mehreren Kanäle innerhalb des einen oder der mehreren N Signale mindestens einen Multiplexkanal aufweisen, wobei der Multiplexkanal mit einer vorbestimmten Trägerfrequenz arbeitet und den Inhalt von zwei oder mehreren Kanälen aufweist.

4. Die Vorrichtung gemäß Anspruch 1, wobei der Inhalt der zwei oder mehreren Kanälen einen digitalen Inhalt aufweist und wobei der Multiplexkanal einen digitalen Multiplexkanal aufweist.

5. Die Vorrichtung gemäß Anspruch 1, wobei mindestens eines der N Signale eine Vielzahl von Frequenzbändern umfasst.

6. Die Vorrichtung gemäß Anspruch 1, wobei das Koppelfeld und die Vielzahl von Frequenzumsetzungsgeräten (150, 228, 330, 1540) in einem integrierten Schaltkreis eingeschlossen sind.

7. Die Vorrichtung gemäß Anspruch 1, wobei die Ausgabe eines jeden Frequenzumsetzungsgerätes (150, 228, 330, 1540) konfiguriert ist, um mit einem einzelnen Ausgabegerät verbunden zu werden.

8. Die Vorrichtung gemäß Anspruch 1, weiterhin mindestens einen rauscharmen Blockumsetzer (130, 210, 1626) aufweisend, der betreibbar ist, um N Signale zur Verfügung zu stellen.

9. Die Vorrichtung gemäß Anspruch 1, wobei der verbundende Ausgang der zwei oder mehreren Frequenzumsetzungsgeräte (150, 228, 330, 1540) zur Verbindung mit einem einzigen Ausgabegerät (170) konfiguriert ist.

10. Die Vorrichtung gemäß Anspruch 1, wobei der Ausgang von mindestens einem Frequenzumsetzungsgerät (150, 228, 330, 1540) zur Verbindung mit einer Vielzahl von Ausgabegeräten (170) konfiguriert ist.

11. Die Vorrichtung gemäß Anspruch 1, weiterhin aufweisend einen Signalkombinierer (150, 230, 1560a, 2260) mit (i) einer Vielzahl von Eingängen, die mit einer entsprechenden Vielzahl von Frequenzumsetzungsgeräteausgängen verbunden sind und (ii) einem Ausgang, der mit einem oder mehreren Ausgabegeräten (170) verbunden ist, wobei der Ausgang den verbundenen Ausgang der zwei oder mehr Frequenzumsetzungsgeräte (150, 228, 330, 1540) aufweist.

12. Die Vorrichtung gemäß Anspruch 11, wobei der Ausgang des Signalkombinierers (150, 230, 1560a, 2260) mit jedem des einen oder der mehreren Ausgabegeräten (170) verbunden ist.

13. Die Vorrichtung gemäß Anspruch 11, wobei der Ausgang des Signalkombinierers (230, 1560a) mit einer ersten Untermenge des einen oder der mehreren Ausgabegeräte (170) verbunden ist, wobei die Vorrichtung weiterhin einen zweiten Signalkombinierer (231, 1560b) mit einer Vielzahl von Eingängen aufweist, die mit einer entsprechenden Vielzahl von Frequenzumsetzungsgeräteausgängen verbunden ist, sowie einen Ausgang, der mit einer zweiten Untermenge des einen oder der mehreren Ausgabegeräte (170) verbunden ist.

**14.** Die Vorrichtung gemäß Anspruch 11, wobei jeder entsprechende Filter zwischen einem Frequenzumsetzungsgerät und einem Signalkombinierereingang verbunden ist.

**15.** Die Vorrichtung gemäß Anspruch 14, wobei die Vielzahl der Filter (1550, 2150, 2240, 2242) aus einer Gruppe bestehend aus einem Hochpassfilter, einem Tiefpassfilter, einem Bandpassfilter und einem Diplexer, ausgewählt wird.

**16.** Die Vorrichtung gemäß Anspruch 14, wobei die Vielzahl der Filter (1550, 2150, 2240, 2242) separat vom Koppelfeld (140, 226, 320, 1530) implementiert wird.

**17.** Die Vorrichtung gemäß Anspruch 14, wobei die Vielzahl der Filter (1550, 2150, 2240, 2242), das Koppelfeld(140, 226, 320, 1530) und die Vielzahl der Frequenzumsetzungsgeräte (150, 228, 330, 1540) monolithisch auf einem integrierten Schaltkreis gebildet werden.

**18.** Die Vorrichtung gemäß Anspruch 14, weiterhin aufweisend eine Vielzahl von variablen Verstärkern (1710, 1734, 1752, 1770, 1912), die mit dem Koppelfeldverbunden sind, wobei jeder der Vielzahl der variablen Verstärker (222, 310, 1520) betreibbar ist, um bei einem hier eingegangenen Signal eine Verstärkung oder Abschwächung vorzunehmen.

**19.** Die Vorrichtung gemäß Anspruch 18, wobei jeder aus der Vielzahl von variablen Verstärkern (1710, 1734, 1752, 1770, 1912) einen Eingang aufweist, der verbunden ist, um ein entsprechendes der N Signale zu empfangen, einen Steuereingang und einen Ausgang, der mit einem der Eingänge des Koppelfelds (140, 226, 320, 1530) verbunden ist, wobei jeder der variablen Verstärker (1710, 1734, 1752, 1770, 1912) so betreibbar ist, reagierend auf ein Steuersignal, das an dem Steuereingang empfangen wird, um bei einem hier eingegangenen Signal eine Verstärkung oder Abschwächung vorzunehmen.

**20.** Die Vorrichtung gemäß Anspruch 19, weiterhin aufweisend eine entsprechende Vielzahl von Detektoren (1720, 1740, 1760, 1770), wobei jeder Detektor einen mit einem Eingang des variablem Verstärkers verbundenen Eingang hat und einen mit dem Steueranschluss des Verstärkers verbundenen Ausgang hat, wobei jeder der Detektoren betreibbar ist, um das Niveau der Verstärkung oder Abschwächung des Verstärkers in Abhängigkeit der festgestellten Energie zu steuern.

**21.** Die Vorrichtung gemäß Anspruch 19, weiterhin aufweisend eine entsprechende Vielzahl von Detektoren (1720, 1740, 1760, 1770), wobei jeder Detektor einen mit einem Ausgang des variablem Verstärkers verbundenen Eingang hat und einen mit dem Steueranschluss des Verstärkers verbundenen Ausgang hat, wobei jeder der Detektoren betreibbar ist, um das Niveau der Verstärkung oder Abschwächung des Verstärkers in Abhängigkeit der festgestellten Energie zu steuern.

**22.** Die Vorrichtung gemäß Anspruch 19, wobei das Koppelfeld(140, 226, 320, 1530), die Vielzahl von Frequenzumsetzungsgeräten (150, 228, 330, 1540) und die Vielzahl von variablen Verstärkern (1710, 1734, 1752, 1770, 1912) in einem integrierten Schaltkreis enthalten sind.

**23.** Die Vorrichtung gemäß Anspruch 1, wobei das Koppelfeld ein erstes Koppelfeld(226, 1916) aufweist, die Vielzahl von Frequenzumsetzungsgeräten eine Vielzahl von ersten Frequenzumsetzungsgeräten (228,1918) aufweist und die Ausgabegeräte erste Ausgabegeräte aufweisen, wobei die Vorrichtung weiterhin eine Vielzahl von zweiten Frequenzumsetzungsgeräten (229, 1920, 1940) aufweist, wobei jedes einen Eingang hat, der mit einem entsprechenden Ausgang der zweiten Koppelfeldausgänge verbunden ist, und einen Ausgang, der zur Verbindung mit einem oder mehreren zweiten Ausgabegeräten konfiguriert ist, wobei jedes der einen oder mehreren zweiten Frequenzumsetzungsgeräte (229, 1920, 1940) so betreibbar ist, dass die Frequenz eines oder mehrerer Kanäle umgesetzt werden kann, die an entsprechende einen oder mehrere Kanäle zugeführt werden, wobei die Vorrichtung weiter **gekennzeichnet ist durch**:

ein zweites Koppelfeld (227, 1920, 1940) mit einer Vielzahl von N Koppelfeldeingängen und einer Vielzahl von Koppelfeldausgängen, wobei jeder der N zweiten Koppelfeldeingänge entweder verbunden ist mit:

(i) einem entsprechenden der ersten Koppelfeldeingänge oder (ii) einem entsprechenden der ersten Koppelfeldausgänge, wobei jeder der zweiten Koppelfeldausgänge zur Verbindung mit einem oder mehreren zweiten Ausgabegeräten konfiguriert ist, wobei das zweite Koppelfeld (227, 1920, 1940) so betreibbar ist, dass jeder der Vielzahl der N zweiten Koppelfeldeingänge mit einem oder mehreren der Vielzahl der zweiten Koppelfeldausgänge schaltbar verbunden werden kann;

einer zweiten Vielzahl von Filtern (1550, 2150, 2240, 2242), wobei jeder Filter mit einem entsprechenden der zweiten Frequenzumsetzungsgeräte (229, 1920, 1940) verbunden ist und jeder Filter betreibbar ist, um mindestens einen Kanal eines Bands von Kanälen, die dahin eingespeist werden, abzuweisen und um mindestens einen Kanal eines Bands von Kanälen, die dahin eingespeist werden, durchzulassen,

wobei zwei oder mehrere der Vielzahl von Frequenzumsetzungsgeräten (150, 228, 330, 1540) mit entsprechenden unterschiedlichen variablen örtlichen Oszillatorquellen verbunden sind, und
wobei die Ausgänge von mindestens zwei der Vielzahl der zweiten Frequenzumsetzungsgeräte miteinander verbunden sind und mindestens ein Teil des zweiten Koppelfelds oder mindestens ein Teil eines oder mehrerer der Vielzahl der zweiten Frequenzumsetzungsgeräte einen Differenzsignalpfad aufweist.

24. Die Vorrichtung gemäß Anspruch 23, wobei das zweite Koppelfeld (227, 1920, 1940) und die Vielzahl von zweiten Frequenzumsetzungsgeräten (229, 1920, 1940) in einem zweiten integrierten Schaltkreis (221, 1920, 1940) angeordnet sind.

25. Die Vorrichtung gemäß Anspruch 23, wobei der Ausgang jedes der zweiten Frequenzumsetzungsgeräte konfiguriert ist, um mit einem einzelnen zweiten Ausgabegerät verbunden zu werden.

26. Die Vorrichtung gemäß Anspruch 23, wobei der verbundene Ausgang der zwei oder mehreren zweiten Frequenzumsetzungsgeräte konfiguriert ist, um mit einem einzelnen zweiten Ausgabegerät verbunden zu werden.

27. Die Vorrichtung gemäß Anspruch 20, wobei der Ausgang von mindestens einem der zweiten Frequenzumsetzungsgeräte konfiguriert ist, um mit einer Vielzahl von zweiten Ausgabegeräten verbunden zu werden.

28. Die Vorrichtung gemäß Anspruch 20, wobei der Ausgang von mindestens einem der ersten Frequenzumsetzungsgeräte mit mindestens einem Ausgang der zweiten Frequenzumsetzungsgeräte verbunden ist.

29. Die Vorrichtung gemäß Anspruch 23, weiterhin aufweisend einen zweiten Signalkombinierer (231) mit (i) einer Vielzahl von Eingängen, die mit einer entsprechenden Vielzahl von zweiten Frequenzumsetzungsgeräteausgängen verbunden sind und (ii) einem Ausgang, der mit einem oder mehreren Ausgabegeräten verbunden ist, wobei der Ausgang verbundenen Ausgang der zwei oder mehreren zweiten Frequenzumsetzungsgeräte (229) aufweist.

30. Die Vorrichtung gemäß Anspruch 23, weiterhin aufweisend eine Vielzahl von zweiten Filtern, wobei jeder entsprechende zweite Filter zwischen einem zweiten Frequenzumsetzungsgeräteausgang und einem zweiten Signalkombinierereingang verbunden ist.

31. Die Vorrichtung gemäß Anspruch 23, weiterhin aufweisend eine Vielzahl von zweiten variablen Verstärkern (223, 225, 1920, 1940), die mit dem zweiten Koppelfeld (227, 1920,1940) verbunden sind, wobei jeder der Vielzahl der zweiten variablen Verstärker betreibbar ist, um bei einem hier eingegangenen Signal eine Verstärkung oder Abschwächung vorzunehmen.

32. Die Vorrichtung gemäß Anspruch 31, wobei das zweite Koppelfeld (227, 1920, 1940), die Vielzahl der zweiten Frequenzumsetzungsgeräte (229, 1920, 1940) und die Vielzahl von zweiten variablen Verstärkern (223, 225, 1920, 1940) in einem zweiten integrierten Schaltkreis (221, 1920, 1940) enthalten sind.

33. Ein Verfahren für die Verteilung von einem oder mehreren Kanälen, die innerhalb einer Vielzahl von N empfangenen Signalen enthalten sind, an ein oder mehrere Ausgabegeräten (170) mithilfe eines Signalverteilungssystems, das folgendes aufweist: (i) ein Koppelfeld (140, 226, 320, 1530) mit N Eingängen, die so betreibbar sind, dass eine entsprechende Vielzahl von N Signalen empfangen werden kann, und eine Vielzahl von Koppelfeldausgängen, (ii) eine entsprechende Vielzahl von Frequenzumsetzungsgeräten (150, 228, 330, 1540), die mit den Koppelfeldausgängen verbunden sind, (iii) eine entsprechende Vielzahl von Filtern (1550, 2150, 2240, 2242), wobei jeder mit einem entsprechendem Frequenzumsetzungsgerät (150, 228, 330, 1540) verbunden ist und (iv) ein oder mehrere Ausgabegeräte (170), die mit mindestens einem der Vielzahl der Frequenzumsetzungsgeräte verbunden sind, wobei das Koppelfeld selektiv schaltbar ist, so dass irgendeines der Vielzahl der N empfangenen Signale über einen oder mehrere Signalpfade mit einem oder mehreren Koppelfeldausgängen verbunden ist, wobei ein oder mehrere Koppelfeldausgangs signale jeweiligen Frequenzumsetzungsgeräten zugeführt werden, wobei jedes der einen oder mehreren Koppelfeldausgangs signale einen oder mehrere Kanäle aufweist und wobei weiterhin eines oder mehrere der Vielzahl der Frequenzumsetzungsgeräte einen Signalpfad aufweist, wobei jedes Frequenzumsetzungsgerät betreibbar ist, um die Frequenz eines oder mehrerer Kanäle umzusetzen, wie sie einem oder mehreren entsprechenden Kanälen zugeführt sind, wobei die Ausgänge von mindestens zwei der Vielzahl der Frequenzumsetzungsgeräte miteinander verbunden sind und wobei die Kanäle mit umgesetzter Frequenz an ein oder mehrere Ausgabegeräte ausgegeben werden, die betreibbar sind, um den einen oder mehrere Kanäle, die dem Gerät zugeführt werden, auszugeben, wobei das Verfahren weiterhin folgende Schritte umfasst:

Filterung eines Signals, das mit dem Eingang eines Ausgabegeräts (170) verbunden ist, mithilfe eines Filters (1550, 2150, 2240, 2242), wobei die Filterung die Abweisung von mindestens einem Kanal eines Bands von Kanälen, die in einem Signal enthalten sind, das dem Filter (1550, 2150, 2240, 2242) zugeführt wird, und Durchlassen von mindestens einem Kanal eines Bands von Kanälen, die in einem Signal enthalten sind, das dem Filter (1550, 2150, 2240, 2242) zugeführt wird" aufweist und

Verbreitung des einen Kanals oder mehrerer Kanäle von dem jeweiligen Koppelfeldeingang auf mindestens einen Frequenzumsetzungsgeräteausgang entlang eines oder mehrerer der Signalpfade, wobei mindestens ein Teil des einen oder mehrerer Signalpfade einen Differenzsignalpfad aufweist, der zur Unterstützung der Ausbreitung eines Differenzsignals betreibbar ist,

wobei zwei oder mehrere der Vielzahl der Frequenzübersetzungsgeräte (150, 228, 330, 1540) mit entsprechenden unterschiedlichen, variablen, örtlichen Oszillatorquellen verbunden sind.

**34.** Das Verfahren gemäß Anspruch 33, wobei das Koppelfeld (140, 226, 320, 1530) ein einziges Koppelfeld aufweist, das so betreibbar ist, dass ein oder mehrere Kanäle, die in der Vielzahl der N empfangenen Signale enthalten sind, auf das eine oder mehrere verbundene Ausgabegeräte verteilt werden können.

**35.** Das Verfahren gemäß Anspruch 33, wobei mindestens eines der der N empfangenen Signale eine Vielzahl von Frequenzbändern aufweist.

**36.** Das Verfahren gemäß Anspruch 33, wobei:

ein oder mehrere Kanäle in einem Frequenzband gruppiert sind, und
eine Steuerung die Umsetzung der Frequenz des einen oder mehrerer Kanäle zum gleichen Frequenzband aufweist.

**37.** Das Verfahren gemäß Anspruch 33, wobei:

ein oder mehrere Kanäle in einem Frequenzband gruppiert sind, und
eine Steuerung die Umsetzung der Frequenz des einen oder mehrerer Kanäle zu einem unterschiedlichen Frequenzband aufweist.

**38.** Das Verfahren gemäß Anspruch 33, wobei die Ausgabe der Kanäle mit umgesetzter Frequenz die Ausgabe eines jeden Kanals mit umgesetzter Frequenz auf eine einzelne Leitung aufweist, die mit jedem der einen oder mehreren Ausgabegeräten (170) verbunden ist.

**39.** Das Verfahren gemäß Anspruch 33, wobei die Ausgabe der Kanäle mit umgesetzter Frequenz Folgendes aufweist:

Ausgabe eines oder mehrerer erster Kanäle mit umgesetzter Frequenz auf eine erste Leitung, die mit einem ersten der einen oder mehreren Ausgabegeräte (170) verbunden ist, und
Ausgabe eines oder mehrerer zweiter Kanäle mit umgesetzter Frequenz auf eine zweite Leitung, die mit einem zweiten der einen oder mehreren Ausgabegeräte (170) verbunden ist.

**40.** Das Verfahren gemäß Anspruch 33, wobei die Steuerung Folgendes umfasst.

Aufwärtswandlung von mindestens einem der Kanäle von der ersten Frequenz auf eine Zwischenfrequenz; und
Abwärtswandlung von mindestens einem der Kanäle von der Zwischenfrequenz auf eine zweite Frequenz.

**41.** Das Verfahren gemäß Anspruch 33, wobei die Steuerung Folgendes umfasst.

Abwärtswandlung von mindestens einem der Kanäle von der ersten Frequenz auf eine Zwischenfrequenz; und Aufwärtswandlung von mindestens einem der Kanäle von der Zwischenfrequenz auf eine zweite Frequenz.

42. Das Verfahren gemäß Anspruch 41, wobei die Abwärtswandlung eine Abwärtswandlung des mindestens einen Kanals zum Basisband aufweist.

43. Das Verfahren gemäß Anspruch 33, wobei die Filterung eine Filterung derAusgänge des Bands von Kanälen mit umgesetzter Frequenz des einen oder der mehreren Frequenzumsetzungsgeräte (150, 228, 330, 1540) aufweist.

44. Das Verfahren gemäß Anspruch 33, wobei Frequenzumsetzung entweder (i) die Abwärtswandlung mindestens eines der Kanäle von einer ersten Frequenz auf die zweite Frequenz oder (ii) die Aufwärtswandlung mindestens eines der Kanäle von einer ersten Frequenz auf eine zweite Frequenz aufweist.

45. Das Verfahren gemäß Anspruch 33, weiterhin bestehend aus der variablen Anpassung eines Energieniveaus eines oder mehrerer der N Signale.

46. Das Verfahren gemäß Anspruch 45, wobei die variable Anpassung eines Energieniveaus die Abschwächung eines oder mehrerer der N Signale aufweist.

47. Das Verfahren gemäß Anspruch 45, wobei die variable Anpassung eines Energieniveaus die Verstärkung eines oder mehrere N Signale aufweist.

48. Das Verfahren gemäß Anspruch 33, weiterhin aufweisend:

Empfang der Vielzahl der N Signale in einem zweiten Koppelfeld(227, 1920, 1940), wobei der zweite Koppelfeldeingang eine entsprechende Vielzahl von N Eingängen aufweist;
Selektivschaltung des zweiten Koppelfelds (227, 1920, 1940), wobei jedes der Vielzahl der empfangenen Signale mit jedem der einen oder mehreren zweiten Koppelfeldausgänge verbunden ist;
Zufuhr eines oder mehrerer zweiter Koppelfeldausgangssignale an entsprechende zweite Frequenzumsetzungsgeräte (229, 1920, 1940), wobei jedes der einen oder mehreren zweiten Koppelfeldausgangssignale ein oder zwei Kanäle aufweist, wobei die Ausgänge von mindestens zwei der Vielzahl der zweiten Frequenzumsetzungsgeräte (229, 1920, 1940) miteinander verbunden sind;
Steuerung eines oder mehrerer der Vielzahl der zweiten Frequenzumsetzungsgeräte (229, 1920, 1940) zur Frequenzumsetzung eines oder mehrerer der Kanäle, die an entsprechend ein oder mehrere Kanäle zugeführt wurden, und
Ausgabe der Kanäle mit umgesetzter Frequenz an ein oder mehrere zweite Ausgabegeräte (170), die betreibbar sind, um den einen oder mehrere Kanäle, die dorthin zugeführt werden, auszugeben, und
Filterung eines Signals, das mit dem Eingang eines zweiten Ausgabegeräts (1920, 1940) verbunden ist, unter Verwendung eines zweiten Filters (1920, 1940), wobei die Filterung die Abweisung von mindestens einem Kanal eines Bands von Kanälen, die in einem dem zweiten Filter (1920, 1940) zugeführten Signalenthalten sind, und das Durchlassen von mindestens einem Kanal eines Bands von Kanälen, die in einem den zweiten Filter (1920, 1940) zugeführten Signal enthalten sind, aufweist, und

wobei zwei oder mehr der Vielzahl von Frequenzumsetzungsgeräten (229, 1920, 1940) mit entsprechenden unterschiedlichen, variablen örtlichen Oszillatorquellen verbunden sind, und
wobei mindestens ein Teil des zweiten Koppelfelds (227, 1920, 1940) oder mindestens ein Teil der einen oder mehreren der Vielzahl der zweiten Frequenzumsetzungsgeräte (229, 1920, 1940) einen Differenzsignalpfad aufweist.

49. Eine Vorrichtung zur Verteilung eines oder mehrerer Kanäle, die in jeder der Vielzahl von N Satellitensignalen enthalten sind, an ein oder mehrere Ausgabegeräte, die Vorrichtung aufweisend:

einen ersten rauscharmen Block, der im Folgenden als LNB-Einheit bezeichnet wird, der so betreibbar ist, dass er eine Vielzahl der N Satellitensignale empfängt, wobei die erste LNB-Einheit folgendes aufweist:

einen ersten LNB-Konverter (130a) verbunden zum Empfang einer Vielzahl der N Satellitensignale und betreibbar, um eine Vielzahl von IF-Signale des ersten Satelliten zu erzeugen;
ein erstes Koppelfeld(140) mit einer Vielzahl von ersten Koppelfeldeingängen verbunden zum Empfang von entsprechenden ersten Satelliten IF- Signalen und einer Vielzahl von ersten Koppelfeldausgängen, wobei das erste Koppelfeld so betreibbar ist, dass jeder beliebige der ersten Koppelfeldeingänge mit jedem beliebigen des einen oder der mehreren ersten Koppelfeldausgänge schaltbar verbunden werden können und

eine entsprechende Vielzahl von ersten Frequenzumsetzungsgeräten (150), wobei jedes erste Frequenzumsetzungsgerät einen Eingang hat, der mit einem entsprechenden Ausgang der ersten Koppelfeldausgänge verbunden ist, und einen Ausgang, der zur Verbindung mit einem oder mehreren Ausgabegeräten konfiguriert ist, wobei jedes der ersten Frequenzumsetzungsgeräte betreibbar ist, um die Frequenz eines oder mehrerer Kanäle umzusetzen, wie sie einem entsprechenden der einen oder mehreren Kanäle zugeführt wurden, wobei die Ausgänge der ersten Frequenzumsetzungsgeräte (150) miteinander verbunden sind, um einen ersten Ausgang der LNB-Einheit bereitzustellen, eine Vielzahl von ersten Filtern (1550, 2150, 2240, 2242), die betreibbar sind, um mindestens einen Kanal eines Bands von Kanälen, die dahin eingespeist werden, abzuweisen, und um mindestens einen Kanal eines Bands von Kanälen, die dahin eingespeist werden, durchzulassen, wobei jeder der ersten Filter mit einem der ersten Frequenzumsetzungsgeräte (150) verbunden ist,

wobei zwei oder mehrere der Vielzahl von ersten Frequenzumsetzungsgeräten (150) mit entsprechenden unterschiedlichen, variablen örtlichen Oszillatorquellen verbunden sind, und
wobei mindestens ein Teil des ersten Koppelfelds oder mindestens ein Teil des einen oder mehreren der Vielzahl der ersten Frequenzumsetzungsgeräte einen Differenzsignalpfad aufweisen;
eine zweite LNB-Einheit, die so betreibbar ist, dass eine Vielzahl der N Satellitensignale empfangen werden kann, wobei die zweite LNB-Einheit folgendes aufweist:

einen zweiten LNB-Konverter (130b) verbunden zum Empfang einer Vielzahl der N Satellitensignale und betreibbar, um eine Vielzahl von zweiten Satelliten IF- Signalen zu erzeugen;
ein zweites Koppelfeld(140) mit einer Vielzahl von zweiten Koppelfeldeingängen verbunden zum Empfang von jeweiligen zweiten Satelliten IF-Signalen und einer Vielzahl von zweiten Koppelfeldausgängen, wobei das zweite Koppelfeld betreibbar ist, um jeden beliebigen der zweiten Koppelfeldeingänge mit jedem beliebigen der einen oder mehreren zweiten Koppelfeldausgänge schaltbar zu verbinden und
eine entsprechende Vielzahl von zweiten Frequenzumsetzungsgeräten (150), wobei jedes Frequenzumsetzungsgerät einen Eingang hat, der mit einem entsprechenden Ausgang der zweiten Koppelfeldausgänge verbunden ist, und einen Ausgang, der zur Verbindung mit einem oder mehreren Ausgabegeräten konfiguriert ist, wobei jedes der zweiten Frequenzumsetzungsgeräte so betreibbar ist, dass die Frequenz eines oder mehrerer Kanäle umgesetzt werden kann, wie sie entsprechenden einen oder mehreren Kanäle zugeführt wird, wobei die Ausgänge der zweiten Frequenzumsetzungsgeräte (150) miteinander verbunden sind, um einen zweiten Ausgang der LNB-Einheit bereitzustellen, eine entsprechende Vielzahl von zweiten Filtern (1550, 2150, 2240, 2242), die betreibbar sind, um mindestens einen Kanal eines Bands von Kanälen, die dahin eingespeist werden, abzuweisen und um mindestens einen Kanal eines Bands von Kanälen, die dahin eingespeist werden, durchzulassen, wobei jeder der zweiten Filter mit einem entsprechenden der zweiten Frequenzumsetzungsgeräte (150) verbunden ist,

wobei zwei oder mehrere der Vielzahl der zweiten Frequenzumsetzungsgeräte (150) mit entsprechenden unterschiedlichen, variablen örtlichen Oszillatorquellen verbunden sind, und
wobei mindestens ein Teil des zweiten Koppelfelds oder mindestens ein Teil des einen oder mehrerer der Vielzahl der zweiten Frequenzumsetzungsgeräte einen Differenzsignalpfad aufweisen, und
einen Signalkombinierer mit Eingängen, die verbunden sind, um die ersten und zweiten Ausgänge der LNB-Einheit zu empfangen und einen Ausgang aufweist, der mit einem oder mehreren Ausgabegeräten (170) verbunden ist.

## Revendications

1. Appareil destiné à distribuer un ou plusieurs canaux inclus dans une pluralité de N signaux vers un ou plusieurs dispositifs de sortie (170), l'appareil comprenant un répartiteur à barres croisées (140, 226, 320, 1530), et une pluralité de dispositifs de transposition en fréquence (150, 228, 330, 1540), le répartiteur à barres croisées (140, 226, 320, 1530) comprenant une pluralité de N entrées du répartiteur à barres croisées et une pluralité de sorties du répartiteur à barres croisées, chacune des N entrées du répartiteur à barres croisées étant couplée pour recevoir un des N signaux, le répartiteur à barres croisées (140, 226, 320, 1530) permettant de coupler par commutation chacune de la pluralité des N entrées du répartiteur à barres croisées à une ou plusieurs de la pluralité des sorties du répartiteur à barres croisées, et où chacun de la pluralité des dispositifs de transposition en fréquence comprend une entrée couplée à l'une des sorties correspondantes du répartiteur à barres croisées et une sortie configurée pour s'accoupler à un ou plusieurs dispositifs de sortie (170), chacun de la pluralité des dispositifs de transposition en fréquence (150, 228, 330, 1540) permettant de transposer en fréquence un ou plusieurs des canaux, tels qu'ils sont prévus sur un ou plusieurs canaux correspondants, où les sorties d'au moins deux de la pluralité des dispositifs de transposition en fréquence (150, 228, 330, 1540) sont couplées ensemble, l'appareil comprenant de plus :

au moins une partie du chemin des signaux dans le répartiteur à barres croisées (140, 226, 320, 1530) ou un ou plusieurs de la pluralité es dispositifs de transposition en fréquence (150, 228, 330, 1540) configurés comme chemin de signal différentiel permettant de supporter la propagation d'un signal en mode différentiel ; et une pluralité de filtres (1550, 2150, 2240, 2242), chacun couplé à l'un des dispositifs de transposition en fréquence correspondants (150, 228, 330, 1540) et chacun permettant de rejeter au moins l'un des canaux d'une bande de canaux s'y rapportant, et de laisser passer au moins un canal de ladite bande de canaux s'y rapportant,

où au moins deux dispositifs de transposition en fréquence (150, 228, 330, 1540) sont couplés à différentes sources d'oscillateurs locaux variables correspondantes.

2. Appareil selon la revendication 1, où le ou les canaux inclus dans un ou plusieurs des N signaux comprennent corrélativement un ou plusieurs canaux multiplexés à division de fréquence, chacun desdits canaux multiplexés à division de fréquence fonctionnant à une fréquence porteuse différente.

3. Appareil selon la revendication 1, où le ou les canaux inclus dans un ou plusieurs des N signaux comprennent au moins un canal multiplexé, ledit canal fonctionnant à une fréquence porteuse prédéfinie et incluant le contenu de deux canaux ou plus.

4. Appareil selon la revendication 3, où le contenu des deux canaux ou plus comprend du contenu numérique, et où le canal multiplexé comprend un canal numérique multiplexé.

5. Appareil selon la revendication 1, où au moins un des N signaux comprend une pluralité de bandes de fréquence.

6. Appareil selon la revendication 1, où le répartiteur à barres croisées et la pluralité de dispositifs de transposition en fréquence (150, 228, 330, 1540) sont inclus dans un circuit intégré.

7. Appareil selon la revendication 1, où la sortie de chacun des dispositifs de transposition en fréquence (150, 228, 330, 1540) est configurée pour s'accoupler à un dispositif de sortie unique.

8. Appareil selon la revendication 1, comprenant de plus au moins un convertisseur de bloc de fréquences à faible bruit (130, 210, 1626) qui permet d'émettre les N signaux.

9. Appareil selon la revendication 1, où la sortie couplée des deux dispositifs de transposition en fréquence ou plus (150, 228, 330, 1540) est configurée pour s'accoupler à un dispositif de sortie unique (170).

10. Appareil selon la revendication 1, où la sortie d'au moins un des dispositifs de transposition en fréquence (150, 228, 330, 1540) est configurée pour s'accoupler à une pluralité de dispositifs de sortie (170).

11. Appareil selon la revendication 1, comprenant de plus un mélangeur de signaux (150, 230, 1560a, 2260) doté (i) d'une pluralité d'entrées couplée à une pluralité correspondante de sorties de dispositifs de transposition en fréquence, et (ii) d'une sortie couplée à un ou plusieurs dispositifs de sortie (170), ladite sortie comprenant les sorties couplées des deux dispositifs de transposition en fréquence ou plus (150, 228, 330, 1540).

12. Appareil selon la revendication 11, où la sortie du mélangeur de signaux (150, 230, 1560a, 2260) est couplée à chacun du ou des dispositifs de sorties (170).

13. Appareil selon la revendication 11, où la sortie du mélangeur de signaux (230, 1560a) est couplée à un premier sous-ensemble du ou des dispositifs de sortie (170), l'appareil comprenant également un deuxième mélangeur de signaux (231, 1560b) doté d'une pluralité d'entrées couplé à une pluralité correspondante de sorties de dispositifs de transposition en fréquence, et une sortie couplée à un deuxième sous-ensemble du ou des dispositifs de sortie (170).

**14.** Appareil selon la revendication 11, où chacun des filtres correspondants est couplé entre une sortie de dispositif de transposition en fréquence et une entrée du mélangeur de signaux.

**15.** Appareil selon la revendication 14, où chacun des filtres (1550, 2150, 2240, 2242) est sélectionné au sein du groupe constitué par un filtre passe-haut, un filtre passe-bas, un filtre passe-bande et un diplexeur.

**16.** Appareil selon la revendication 14, où la pluralité de filtres (1550, 2150, 2240, 2242) est intégré séparément du répartiteur à barres croisées (140, 226, 320, 1530).

**17.** Appareil selon la revendication 14, où la pluralité de filtres (1550, 2150, 2240, 2242), le répartiteur à barres croisées (140, 226, 320, 1530) et la pluralité de dispositifs de transposition en fréquence (150, 228, 330, 1540) sont mis en forme sur un circuit intégré monolithique.

**18.** Appareil selon la revendication 1, comprenant de plus une pluralité d'amplificateurs à gain variable (1710, 1734, 1752, 1770, 1912) couplés au répartiteur à barres croisées, chacun de la pluralité des amplificateurs à gain variable (222, 310, 1520) permettant d'appliquer le gain ou l'atténuation aux entrées de signaux s'y rapportant.

**19.** Appareil selon la revendication 18, où chacun de la pluralité des amplificateurs à gain variable (1710, 1734, 1752, 1770, 1912) inclut une entrée couplée pour recevoir l'un des N signaux correspondants, une entrée de commande et une sortie couplée à une des entrées du répartiteur à barres croisées (140, 226, 320, 1530), où chacun des amplificateurs à gain variable (1710, 1734, 1752, 1770, 1912) permet, en réponse à un signal de commande reçu au niveau de l'entrée de commande, d'appliquer le gain ou l'atténuation à une entrée de signal s'y rapportant.

**20.** Appareil selon la revendication 19, comprenant de plus une pluralité correspondante de détecteurs (1720, 1740, 1760, 1770), chaque détecteur doté d'une sortie couplée à l'entrée de l'un des amplificateurs à gain variable et d'une sortie couplée au port de commande dudit amplificateur à gain variable, chacun des détecteurs permettant de commander le niveau de gain ou d'atténuation de l'amplificateur à gain variable en fonction de la puissance détectée.

**21.** Appareil selon la revendication 19, comprenant de plus une pluralité correspondante de détecteurs (1720, 1740, 1760, 1790, 1914), chaque détecteur doté d'une entrée couplée à la sortie de l'un des amplificateurs à gain variable et d'une sortie couplée au port de commande dudit amplificateur à gain variable, chacun des détecteurs permettant de commander le niveau de gain ou d'atténuation de l'amplificateur à gain variable en fonction de la puissance détectée.

**22.** Appareil selon la revendication 19, où le répartiteur à barres croisées (140, 226, 320, 1530), la pluralité de dispositifs de transposition en fréquence (150, 228, 330, 1540) et la pluralité des amplificateurs à gain variable (1710, 1734, 1752, 1770, 1912) sont inclus dans un circuit intégré.

**23.** Appareil selon la revendication 1, où ledit répartiteur à barres croisées comprend un premier répartiteur à barres croisées (226, 1916), ladite pluralité de dispositifs de transposition en fréquence comprenant une pluralité des premiers dispositifs de transposition en fréquence (228, 1918), et lesdits dispositifs de sortie comprenant des premiers dispositifs de sortie, l'appareil comprenant de plus secondes dispositifs de transposition en fréquence (229, 1920, 1940), dotés chacun d'une entrée couplée à une des deuxième sorties correspondantes du répartiteur à barres croisées et d'une sortie configurée pour s'accoupler au ou aux plusieurs des deuxième dispositifs de sortie, chacun des deuxième dispositifs de transposition en fréquence (229, 1920, 1940) permettant de transposer en fréquence un ou plusieurs des canaux, tels qu'ils sont prévus sur un ou plusieurs canaux correspondants, l'appareil étant de plus **caractérisé par** :

un deuxième répartiteur à barres croisées (227, 1920, 1940) doté d'une pluralité de N entrées du répartiteur à barres croisées et d'une pluralité de sorties du répartiteur à barres croisées, chacune des N entrées du deuxième répartiteur à barres croisées couplées : soit à (i) une des entrées correspondantes du premier répartiteur à barres croisées, ou soit à (ii) une des sorties correspondantes du premier répartiteur à barres croisées, chacune des sorties du deuxième répartiteur à barres croisées configurées pour s'accoupler à un ou plusieurs des deuxième dispositifs de sortie, le deuxième répartiteur à barres croisées (227, 1920, 1940) permettant de coupler, par commutation, chacune des N entrées du deuxième répartiteur à barres croisées à une ou plusieurs des sorties du deuxième répartiteur à barres croisées ;
une deuxième pluralité de filtres (1550, 2150, 2240, 2242), chacun couplé à l'un des deuxième dispositifs de transposition en fréquence correspondants (229, 1920, 1940) et chacun permettant de rejeter au moins l'un des canaux d'une bande de canaux s'y rapportant, et de laisser passer au moins un canal de ladite bande de canaux s'y rapportant,

où deux ou plusieurs de la pluralité des dispositifs de transposition en fréquence (150, 228, 330, 1540) sont couplés à différentes sources d'oscillateurs locaux variables correspondantes, et

où les sorties d'au moins deux de la pluralité des deuxième dispositifs de transposition en fréquence sont couplées ensemble et où au moins une partie du deuxième répartiteur à barres croisées ou au moins une partie d'un ou plusieurs de la pluralité des deuxième dispositifs de transposition en fréquence comprend un chemin de signal différentiel.

24. Appareil selon la revendication 23, où le deuxième noeud de commutation (227, 1920, 1940) et la pluralité des deuxième dispositifs de transposition en fréquence (229, 1920, 1940) sont inclus dans un deuxième circuit intégré (221, 1920, 1940).

25. Appareil selon la revendication 23, où la sortie de chacun des deuxième dispositifs de transposition en fréquence est configurée pour s'accoupler à un deuxième dispositif de sortie unique.

26. Appareil selon la revendication 23, où la sortie couplée des deux ou plusieurs des deuxième dispositifs de transposition en fréquence est configurée pour s'accoupler à un deuxième dispositif de sortie unique.

27. Appareil selon la revendication 20, où la sortie d'au moins un des deuxième dispositif de transposition en fréquence est configurée pour s'accoupler à une deuxième pluralité des deuxième dispositifs de sortie.

28. Appareil selon la revendication 23, où la sortie d'au moins un des premiers dispositif de transposition en fréquence est couplée à au moins une sortie des deuxième dispositifs de transposition en fréquence.

29. Appareil selon la revendication 23, comprenant de plus un deuxième mélangeur de signaux (231) doté (i) d'une pluralité d'entrées couplé à une pluralité correspondant de sorties des deuxième dispositifs de transposition en fréquence et (ii) d'une sortie couplée à un ou plusieurs des deuxième dispositifs de sortie, ladite sortie comprenant les sorties couplées des deux des deuxième dispositifs de transposition en fréquence ou plus (229).

30. Appareil selon la revendication 29, comprenant de plus une pluralité correspondante des deuxièmes filtres, chaque deuxième filtre correspondant couplé entre une sortie d'un deuxième dispositif de transposition en fréquence et une entrée du deuxième mélangeur de signaux.

31. Appareil selon la revendication 23, comprenant de plus une deuxième pluralité d'amplificateurs à gain variable (223, 225, 1920, 1940) couplés au deuxième répartiteur à barres croisées (227, 1920, 1940), chacun de la pluralité des deuxièmes amplificateurs à gain variable permettant d'appliquer le gain ou l'atténuation aux entrées de signaux s'y rapportant.

32. Appareil selon la revendication 31, où le deuxième noeud de commutation (227, 1920, 1940), la pluralité des deuxième dispositifs de transposition en fréquence (229, 1920, 1940) et la pluralité des deuxième amplificateurs à gain variable (223, 225, 1920, 1940) sont inclus dans un deuxième circuit intégré (221, 1920, 1940).

33. Procédé de distribution d'un ou de plusieurs signaux inclus dans l'un quelconque de la pluralité de N signaux reçus vers un ou plusieurs dispositifs de sortie (170) à l'aide d'un système de distribution de signaux, le système de distribution de signaux comprenant (i) un répartiteur à barres croisées (140, 226, 320, 1530) doté de N entrées permettant de recevoir une pluralité correspondante de N signaux et une pluralité de sorties du répartiteur à barres croisées, (ii) une pluralité correspondante de dispositifs de transposition en fréquence (150, 228, 330, 1540) couplés aux sorties du répartiteur à barres croisées, (iii) une pluralité correspondante de filtres (1550, 2150, 2240, 2242), chacun couplé à un correspondant des dispositifs de transposition en fréquence (150, 228, 330, 1540), et (iv) un ou plusieurs dispositifs de sortie (170) couplés à au moins un de la pluralité des dispositifs de transposition en fréquence, le répartiteur à barres croisées pouvant être sélectivement commutable, de sorte que chacun de la pluralité des N signaux reçus est couplé, via un ou plusieurs chemins de signaux, à une ou plusieurs des sorties du répartiteur à barres croisées, où un ou plusieurs signaux de sortie du répartiteur à barres croisées sont transmis aux dispositifs correspondants de transposition en fréquence, chacun des signaux de sortie du répartiteur à barres croisées comprenant un ou plusieurs canaux, et où de plus un ou plusieurs de la pluralité des dispositifs de transposition en fréquence comprend un chemin de signal, chaque dispositif de transposition en fréquence permettant de transposer en fréquence un ou plusieurs des canaux transmis à un ou plusieurs canaux correspondants, les sorties d'au moins deux de la pluralité des dispositifs de transposition en fréquence ayant été couplées ensemble ; et où les canaux à fréquence transposée sont sortis à un ou à plusieurs des dispositifs de sortie permettant de transmettre le ou les canaux qui y sont acheminés, le procédé consistant de plus en les étapes suivantes :

filtrage d'un signal couplé à l'entrée d'un dispositif de sortie (170) par un filtre (1550, 2150, 2240, 2242), ledit filtrage impliquant le rejet d'au moins un canal d'une bande de canaux inclus dans un signal entrant dans ledit filtre (150, 1550, 2150, 2240, 2242), et le passage d'au moins un canal de ladite bande de canaux inclus dans ledit signal entrant dans ledit filtre (1550, 2150, 2240, 2242) ; et

propagation du ou des plusieurs canaux à partir de l'entrée correspondante du répartiteur à barres croisées vers au moins une sortie du dispositif de transposition en fréquence avec un ou plusieurs desdits chemins de signaux, où au moins une partie du ou des plusieurs chemins de signaux comprend un chemin de signal différentiel permettant de supporter la propagation d'un signal en mode différentiel,

où deux ou plusieurs dispositifs de transposition en fréquence (150, 228, 330, 1540) sont couplés à différentes sources correspondantes d'oscillateurs locaux variables.

34. Procédé selon la revendication 33, où ledit répartiteur à barres croisées (140, 226, 320, 1530) comprend le seul répartiteur à barres croisées permettant de distribuer un ou plusieurs canaux inclus dans n'importe lequel des N signaux reçus au ou à plusieurs dispositifs de sortie couplés.

35. Procédé selon la revendication 33, où au moins un des N signaux comprend une pluralité de bandes de fréquence.

36. Procédé selon la revendication 33, où :

un ou plusieurs canaux sont regroupés en une bande de fréquence ; et
la commande implique la transposition en fréquence du ou des plusieurs canaux vers la même bande de fréquence.

37. Procédé selon la revendication 33, où :

un ou plusieurs canaux sont regroupés en une bande de fréquence ; et
la commande inclut la transposition en fréquence du ou des plusieurs canaux vers une bande de fréquence différente.

38. Procédé selon la revendication 33, où l'émission des canaux transposés en fréquence inclut l'émission de chacun des canaux transposés en fréquence sur une ligne unique couplée à chacun du ou des plusieurs dispositifs de sortie (170).

39. Procédé selon la revendication 33, où l'émission des canaux transposés en fréquence inclut :

l'émission d'un ou de plusieurs premiers canaux transposés en fréquence sur une première ligne couplée à un premier du ou des plusieurs dispositif de sortie (170) ; et
l'émission d'un ou de plusieurs seconde canaux transposés en fréquence sur une seconde ligne couplée à un second du ou des plusieurs dispositif de sortie (170).

40. Procédé selon la revendication 33, où la commande consiste à :

monter en fréquence au moins un des canaux à partir de la première fréquence vers une fréquence intermédiaire ; et
descendre en fréquence au moins un desdits canaux à partir de la fréquence intermédiaire vers la deuxième fréquence.

41. Procédé selon la revendication 33, où la commande consiste à :

descendre en fréquence au moins un des canaux à partir de la première fréquence vers une fréquence intermédiaire ; et

monter en fréquence au moins un desdits canaux à partir de la fréquence intermédiaire vers la deuxième fréquence.

**42.** Procédé selon la revendication 41, où la descente en fréquence implique de descendre en fréquence au moins ledit canal vers la bande de base.

**43.** Procédé selon la revendication 33, où le filtrage implique le filtrage de la sortie de la bande de canaux transposée en fréquence provenant du ou des plusieurs dispositifs de transposition en fréquence (150, 228, 330, 1540).

**44.** Procédé selon la revendication 33, où la transposition en fréquence consiste soit (i) à descendre en fréquence au moins l'un des canaux à partir d'une première fréquence vers la seconde fréquence, ou soit (ii) à monter en fréquence au moins l'un des canaux à partir d'une première fréquence vers une seconde fréquence.

**45.** Procédé selon la revendication 33, impliquant de plus le réglage variable du niveau de puissance d'un ou plusieurs des N signaux.

**46.** Procédé selon la revendication 45, où le réglage variable du niveau de puissance implique l'atténuation d'un ou plusieurs des N signaux.

**47.** Procédé selon la revendication 45, où le réglage variable du niveau de puissance implique l'amplification d'un ou plusieurs des N signaux.

**48.** Procédé selon la revendication 33, consistant également en :

la réception de la pluralité des N signaux dans un deuxième répartiteur à barres croisées (227, 1920, 1940), l'entrée du deuxième répartiteur à barres croisées étant dotée d'une pluralité correspondante de N entrées ;
la commutation sélective du deuxième répartiteur à barres croisées (227, 1920, 1940), par laquelle chacun de la pluralité des N signaux reçus est couplé à une ou plusieurs sorties quelconques du deuxième répartiteur à barres croisées ;
la transmission d'un ou de plusieurs signaux de sortie du deuxième répartiteur à barres croisées aux deuxièmes dispositifs correspondants de transposition en fréquence (229, 1920, 1940), chacun des signaux de sortie du deuxième répartiteur à barres croisées comprenant un ou plusieurs canaux, où les sorties d'au moins deux de la pluralité des deuxièmes dispositifs de transposition en fréquence (229, 1920, 1940) sont couplées ensemble ;
la commande d'un ou de plusieurs des deuxièmes dispositifs de transposition en fréquence (229, 1920, 1940) pour transposer la fréquence d'un ou plusieurs des canaux transmis à un ou plusieurs canaux correspondants ; et,
l'émission des canaux transposés en fréquence sur un ou plusieurs des deuxièmes dispositifs de sortie (170) permettant la transmission d'un ou de plusieurs canaux s'y rapportant,
le filtrage d'un signal couplé à l'entrée d'un deuxième dispositif de sortie (1920, 1940) par un deuxième filtre (1920, 1940), ledit filtrage impliquant le rejet d'au moins un canal d'une bande de canaux inclus dans un signal entrant dans ledit deuxième filtre (1920, 1940), et le passage d'au moins un canal de ladite bande de canaux inclus dans ledit signal entrant dans ledit deuxième filtre (1920, 1940),
où deux ou plusieurs deuxième dispositifs de transposition en fréquence (229, 1920, 1940) sont couplés à différentes sources correspondantes d'oscillateurs locaux variables, et
où au moins une partie du deuxième répartiteur à barres croisées (227, 1920, 1940) ou au moins une partie d'un ou de plusieurs des deuxième dispositifs de transposition en fréquence (229, 1920, 1940), comprend un chemin de signal différentiel.

**49.** Appareil destiné à distribuer un ou plusieurs canaux inclus dans une pluralité de N signaux par satellite sur un ou plusieurs dispositifs de sortie, l'appareil étant constitué de :

un premier récepteur de bloc de fréquences à faible bruit, désigné par le terme récepteur LNB dans la suite, permettant de recevoir une pluralité de N signaux par satellite, le premier récepteur LNB comprenant :

un premier convertisseur LNB (130a) couplé pour recevoir une pluralité de N signaux par satellite et permettant de produire une pluralité de premier signaux de fréquence intermédiaire (FI) de satellite ;
un premier répartiteur à barres croisées (140) doté d'une pluralité d'entrées du premier répartiteur à barres croisées couplées pour recevoir les premiers signaux correspondant de fréquence intermédiaire (FI) de satellite et une pluralité de sorties du premier répartiteur à barres croisées, le premier répartiteur à barres croisées permettant de coupler, par commutation, chacune des entrées du premier répartiteur à barres croisées à une ou plusieurs sorties quelconques du premier répartiteur à barres croisées ; et,

une pluralité correspondante de premiers dispositifs de transposition en fréquence (150), chaque premier dispositif de transposition en fréquence étant doté d'une entrée couplée à une correspondante des sorties du premier répartiteur à barres croisées et une sortie configurée pour s'accoupler à un ou plusieurs dispositifs de sortie, chaque premier dispositif de transposition en fréquence permettant de transposer la fréquence d'un ou de plusieurs des canaux tels que ceux transmis à un ou plusieurs canaux correspondants, où les sorties des premiers dispositifs de transposition en fréquence (150) sont couplées ensemble pour donner une sortie du premier récepteur LNB,

une pluralité correspondant des premiers filtres (1550, 2150, 2240, 2242) permettant de rejeter au moins l'un des canaux d'une bande de canaux s'y rapportant et de passer au moins un canal de ladite bande de canaux s'y rapportant, chacun des premiers filtres couplé à un correspondant des premiers dispositifs de transposition en fréquence (150),

où deux ou plusieurs de la pluralité des premiers dispositifs de transposition en fréquence (150) sont couplés à différentes sources correspondantes d'oscillateurs locaux variables, et

où au moins une partie du premier répartiteur à barres croisées ou au moins une partie d'un ou de plusieurs de la priorité des premiers dispositifs de transposition en fréquence comprend un chemin de signal différentiel ;

un deuxième récepteur LNB permettant de recevoir une pluralité de N signaux de satellite, le deuxième récepteur LNB comprenant :

un deuxième convertisseur LNB (130b) couplé pour recevoir une pluralité de N signaux de satellite et permettant de produire une pluralité de deuxième signaux de fréquence intermédiaire (FI) par satellite ;

un deuxième répartiteur à barres croisées (140) doté d'une pluralité d'entrées du deuxième répartiteur à barres croisées couplées pour recevoir les deuxième signaux correspondant de fréquence intermédiaire (FI) de satellite et une pluralité de sorties du deuxième répartiteur à barres croisées, le deuxième répartiteur à barres croisées permettant de coupler, par commutation, chacune des entrées du deuxième répartiteur à barres croisées à une ou plusieurs sorties quelconques du deuxième répartiteur à barres croisées ; et,

une pluralité correspondante des deuxièmes dispositifs de transposition en fréquence (150), chaque des deuxièmes dispositifs de transposition en fréquence étant doté d'une entrée couplée à une correspondante des sorties du deuxième répartiteur à barres croisées et une sortie configurée pour s'accoupler à un ou plusieurs dispositifs de sortie, chaque des deuxièmes dispositifs de transposition en fréquence permettant de transposer la fréquence d'un ou de plusieurs des canaux tels que ceux transmis à un ou plusieurs canaux correspondants, où les sorties des deuxièmes dispositifs de transposition en fréquence (150) sont couplées ensemble pour donner une sortie du deuxième récepteur LNB ;

une pluralité correspondante de deuxièmes filtres (1550, 2150, 2240, 2242) permettant de rejeter au moins l'un des canaux d'une bande de canaux s'y rapportant et de passer au moins un canal de ladite bande de canaux s'y rapportant, chacun des deuxièmes filtres couplé à l'un correspondant des deuxième dispositifs de transposition en fréquence (150),

où deux ou plusieurs de la pluralité des deuxièmes dispositifs de transposition en fréquence (150) sont couplés à différentes sources correspondantes d'oscillateurs locaux variables, et

où au moins une partie du deuxième répartiteur à barres croisées ou au moins une partie d'un ou de plusieurs de la pluralité des deuxièmes dispositifs de transposition en fréquence comprend un chemin de signal différentiel, et

un mélangeur de signaux doté d'entrées couplées pour recevoir les sorties des premier et deuxième récepteurs LNB et une sortie couplée à un ou plusieurs dispositifs de sortie (170).

FIG. 1

*FIG. 2*

*FIG. 3*

*300*

*320*

*310a* *310b* *310c* *310d*

N X M

*330a* *332a* *338a*

LO

*336a* *334a*

BTD

*330b* *332b* *338b*

LO

*336b* *334b*

BTD

FIG. 4A

FIG. 4B

**FIG. 5**

**FIG. 6A**

672

Supply a first frequency signal to input switch(es), each input switch having first and second outputs

674

Switch the input terminal of the first and second switches between their outputs at a second frequency.

676

Connect the first and second outputs of each input switch to either:
(i) a node common to the first and second outputs, or
(ii) opposite polarity nodes.

FIG. 6B

FIG. 6C

**FIG. 7**

**FIG. 8A**

FIG. 8B

EP 1 573 931 B1

*FIG. 9A*

LNB INPUT

910

912

N X M

CASCADE OUTPUT

*FIG. 9B*

LNB INPUT

A 920

928

N X M

B 924

CASCADE OUTPUT

*FIG. 9C*

LNB INPUT

930

934

A

938

N X M

CASCADE OUTPUT

FIG. 10

*FIG. 11A*

*FIG. 11B*

*FIG. 11C*

*FIG. 11D*

**FIG. 12**

EP 1 573 931 B1

FIG. 13

FIG. 14

EP 1 573 931 B1

*FIG. 15*

*FIG. 16*

## FIG. 17A

## FIG. 17B

## FIG. 17C

## FIG. 17D

EP 1 573 931 B1

FIG. 18A

FIG. 18B

EP 1 573 931 B1

FIG. 19

_2000_

```
┌─────────────────────┐
│      RECEIVE        │  ╭─2002
│   DISTRIBUTION      │
│      SIGNALS        │
└─────────────────────┘
           │
           ▼
┌─────────────────────┐
│  LOW NOISE AMPLIFY  │  ╭─2010
└─────────────────────┘
           │
           ▼
┌─────────────────────┐
│ MEASURE OUTPUT POWER│  ╭─2012
└─────────────────────┘
           │
           ▼
┌─────────────────────┐
│   VARY LNA GAIN     │  ╭─2014
└─────────────────────┘
           │
           ▼
┌─────────────────────┐
│ PROVIDE CASCADE OUTLET │ ╭─2020
└─────────────────────┘
           │
           ▼
┌─────────────────────┐
│ROUTE SIGNAL TO DESTINATION│ ╭─2030
└─────────────────────┘
           │
           ▼
┌─────────────────────┐
│ BAND TRANSLATE SIGNAL │ ╭─2040
└─────────────────────┘
           │
           ▼
┌─────────────────────┐
│    FILTER SIGNAL    │  ╭─2050
└─────────────────────┘
           │
           ▼
┌─────────────────────┐
│  COMBINE SIGNALS    │  ╭─2060
└─────────────────────┘
```

## FIG. 20

EP 1 573 931 B1

_2100_

_FIG. 21_

*FIG. 22*

_2300_

RECEIVE SATELLITE
TRANSPONDER SIGNALS  ⟋2310

BLOCK CONVERT
SIGNALS TO PREDETERMINED
BANDS  ⟋2320

ROUTE SIGNAL SOURCES
TO DESTINATIONS  ⟋2330

BAND TRANSLATE SIGNALS
FROM FIRST PREDETERMINED
BAND TO SECOND PREDETERMINED
BAND  ⟋2340

FILTER BAND TRANSLATED
SIGNALS  ⟋2350

COMBINE SIGNALS  ⟋2360

## FIG. 23

**EP 1 573 931 B1**

**Patent documents cited in the description**

- US 5184084 A, Yun